# EUROPEAN PATENT APPLICATION

(11) **EP 1 840 653 A1**
(43) Date of publication of application: **03.10.2007**
(21) Application number: 07006254.2
(22) Date of filing: 27.03.2007
(51) Int. Cl.: G03F 7/027, G03F 7/031, G03F 7/11, G03F 7/30, G03F 7/32

(54) **Method for preparation of lithographic printing plate and lithographic printing plate precursor**

(30) Priority: 31.03.2006 JP 2006099780; 27.04.2006 JP 2006123825
(71) Applicant: FUJIFILM Corporation, Minato-ku Tokyo (JP)
(72) Inventor: Oohashi, Hidekazu, Haibara-gun Shizuoka (JP); Aizawa, Takeo, Haibara-gun Shizuoka (JP)
(74) Representative: HOFFMANN EITLE

(57) **Abstract**

A method for producing a lithographic printing plate comprising: imagewise exposing a lithographic printing plate precursor comprising: a hydrophilic support; a photosensitive layer containing a radical polymerizable compound having an isocyanuric acid group, a binder polymer having an acid value of 0.3 meq/g or less, a sensitizing dye having an absorption maximum in a wavelength range of from 360 to 450 nm and a polymerization initiator; and a protective layer in this order with a laser beam of from 360 to 450 nm; and rubbing a surface of the exposed lithographic printing plate precursor with a rubbing member in a presence of a developer having pH of from 2 to 10 in. an automatic processor equipped with the rubbing member to remove the protective layer and an unexposed area of the photosensitive layer.

## Description

### FIELD OF THE INVENTION

The present invention relates to a method for plate-making of a lithographic printing plate, more particularly to a method for plate-making of a lithographic printing plate precursor wherein development is conducted with a mild aqueous solution (having pH of 2 to 10), and the lithographic printing plate precursor for use in the method.

### BACKGROUND OF THE INVENTION

In general, a lithographic printing plate has a surface composed of an oleophilic image area and a hydrophilic non-image area. Lithographic printing is a printing method comprising supplying alternately dampening water and oily ink on the surface of lithographic printing plate, making the hydrophilic non-image area a dampening water-receptive area (ink unreceptive area) and depositing the oily ink only to the oleophilic image area by utilizing the nature of the dampening water and oily ink to repel with each other, and then transferring the ink to a printing material, for example, paper.

In order to produce the lithographic printing plate, a lithographic printing plate precursor (PS plate) comprising a hydrophilic support having provided thereon an oleophilic photosensitive layer (image-recording layer) has heretofore been broadly used. Ordinarily, a lithographic printing plate is obtained by conducting plate making by a method of exposing the lithographic printing plate precursor through an original, for example, a lith film, and then treating the exposed lithographic printing plate precursor to remove the image-recording layer in the unnecessary non-image area by dissolving with a an alkaline developer or an organic solvent thereby revealing a surface of the hydrophilic support to form the non-image area while leaving the image-recording layer in the image area.

In the hitherto known plate-making process of lithographic printing plate precursor, after the exposure, the step of removing the unnecessary image-recording layer by dissolving, for example, with a developer is required. However, it is one of the subjects to simplify such an additional wet treatment described above. As one means for the simplification, it has been desired to conduct the development with a nearly neutral aqueous solution or simply with water.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate technique of carrying the digitalized image information on highly converging radiation, for example, laser light and conducting scanning exposure of a lithographic printing plate precursor with the light thereby directly preparing a lithographic printing plate without using a lith film. Thus, it is one of the important technical subjects to obtain a lithographic printing plate precursor adaptable to the technique described above.

Based on the background described above, adaptation of plate making operation to both simplification and digitalization has been demanded strongly more and more than ever before.

In response to such a demand, for instance, it is described in JP-A 2002-365789 (the term "JP-A" as used herein means an "unexamined published Japanese patent application") that by incorporating a compound having an ethylene oxide chain into an image-forming layer of a lithographic printing plate precursor comprising a hydrophilic support and the image-forming layer containing a hydrophobic precursor, a hydrophilic resin and a light to heat converting agent, the lithographic printing plate precursor enables printing after conducting exposure and wet development processing using as a developer, water or an appropriate aqueous solution, besides on-machine development.

Also, a processing method of lithographic printing plate precursor is described in U. S. Patent Publication No. 2004/0013968 which comprises preparing a lithographic printing plate precursor comprising (i) a hydrophilic support and (ii) an oleophilic heat-sensitive image-forming layer which contains a radical-polymerizable ethylenically unsaturated monomer, a radical polymerization initiator and an infrared absorbing dye, is hardened with infrared laser exposure and is developable with an aqueous developer containing 60% by weight or more of water and having pH of 2.0 to 10.0, exposing imagewise the lithographic printing plate precursor with an infrared laser, and removing the unhardened region of the heat-sensitive layer with the aqueous developer.

However, as for the lithographic printing plate precursors described in JP-A 2002-365789 and U. S. Patent Publication No. 2004/0013968, hydrophilicity of the image-forming layer is highly arranged in order to perform development with an aqueous developer. Therefore, there are problems in that a sufficient number of printed materials can not be obtained because of weak water-resistance of the image area and in that the productivity of printing plate is low because the exposure is performed with an infrared laser of high energy.

On the other hand, as the means for increasing the productivity of printing plate, printing plate precursors referred to as photon mode using a laser beam of a visible to ultraviolet region having low energy are known.

For instance, a photopolymerizable composition containing a polymerizable compound having an addition-polymerizable unsaturated bond, a photopolymerization initiator and an alkali-soluble polymer compound, wherein the polymerizable compound having an addition-polymerizable unsaturated bond is a compound of a specific structure containing a cyanuric acid group, and a photosensitive lithographic printing plate comprising a support having a hydrophilic surface having provided thereon a layer of the photopolymerizable composition are described (see, for example, JP-A-8-160615). It is described that the photosensitive lithographic printing plate is able to be developed with an alkali aqueous solution having pH of 12 or more.

Also, a photosensitive composition containing a polymerizable monomer of a specific structure having a cyanuric acid group, a (meth)acrylate group and a hydroxycarboxylic acid-connected (meth)acrylate group, and a photosensitive lithographic printing plate comprising a support having provided thereon a layer of the photosensitive composition are described (see, for example, JP-A-10-104835). It is described that the photosensitive lithographic printing plate is able to be developed with a mixed solution of a specific organic solvent, an alkali agent and water.

Further, a photopolymerizable composition containing a polymer compound containing a polymerizable double bond in its side chain and having weight average molecular weight of 10,000 or more and a polymerizable monomer of a specific structure having a cyanuric acid group, a (meth)acrylate group and a (meth)acrylate group is described (see, for example, JP-A-62-290705). With respect to a photosensitive lithographic printing plate employing the photosensitive composition, there is described an example of development with 1,1,1-trichloroethane.

According to the photosensitive lithographic printing plates described in the above-described patent documents, although the productivity of printing plate is improved, it is impossible for the photosensitive lithographic printing plates to develop with an aqueous developer of a neutral to acid region having pH of 2 to 10.

### SUMMARY OF THE INVENTION

An object of the present invention is to provide a lithographic printing plate precursor which has high sensitivity and high productivity of printing plate, exhibits good developing property even in development with a mild aqueous solution (having pH of 2.0 to 10.0) and is capable of providing a lithographic printing plate excellent in printing durability, and a plate-making method.

As a result of the extensive investigations to achieve the above-described object, the inventor has found that the above-described object can be achieved by imagewise exposing a lithographic printing plate precursor comprising a photosensitive layer and a protective layer in this order with a laser beam of 360 to 450 nm, and rubbing a surface of the exposed lithographic printing plate precursor with a rubbing member in the presence of a developer having pH of 2 to 10 in an automatic processor equipped with the rubbing member to remove the protective layer and an unexposed area of the photosensitive layer to complete the invention.

Specifically, the present invention includes the following items.
(1) A method for preparation of a lithographic printing plate comprising imagewise exposing a lithographic printing plate precursor comprising a hydrophilic support, a photosensitive layer containing (A) a radical polymerizable compound having an isocyanuric acid group, (B) a binder polymer having an acid value of 0.3 meq/g or less, (C) a sensitizing dye having an absorption maximum in a wavelength range of 360 to 450 nm and (D) a polymerization initiator and a protective layer in this order with a laser beam of 360 to 450 nm, and rubbing a surface of the exposed lithographic printing plate precursor with a rubbing member in the presence of a developer having pH of 2 to 10 in an automatic processor equipped with the rubbing member to remove the protective layer and an unexposed area of the photosensitive layer.
(2) The method for preparation of a lithographic printing plate as described in (1) above, wherein (A) the radical polymerizable compound having an isocyanuric acid group has a molecular weight of 450 or more.
(3) The method for preparation of a lithographic printing plate as described in (1) or (2) above, wherein (A) the radical polymerizable compound having an isocyanuric acid group has a radical polymerizable group value of 4 mmol/g or more.
(4) The method for preparation of a lithographic printing plate as described in any one of (1) to (3) above, wherein (B) the binder polymer having an acid value of 0.3 meq/g or less is a polymer having a weight average molecular weight of 10,000 or more and a glass transition point (Tg) of 80°C or less.
(5) The method for preparation of a lithographic printing plate as described in (4) above, wherein (B) the binder polymer having an acid value of 0.3 meq/g or less further has a radical polymerizable group.
(6) The method for preparation of a lithographic printing plate as described in any one of (1) to (5) above, wherein the exposed lithographic printing plate precursor is subjected to a heat treatment between the exposure and the development.
(7) The method for preparation of a lithographic printing plate as described in any one of (1) to (6) above, wherein the developer contains a surfactant represented by the following formula (1-III) or (1-IV): 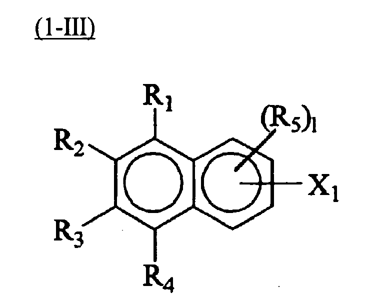 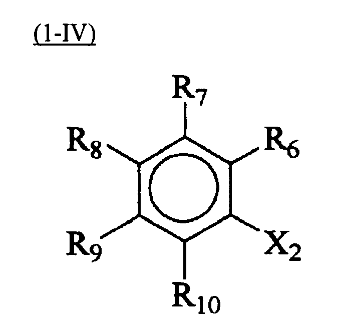 In the formulae, R₁ to R₁₀ each represents a hydrogen atom or an alkyl group; 1 represents an integer of 1 to 3; X₁, and X₂ each represents a sulfonate, a sulfuric monoester salt, a carboxylate or a phosphate; and provided that a total number of carbon atoms included in R₁ to R₅ or R₆ to R₁₀ is 3 or more.
(8) The method for preparation of a lithographic printing plate as described in any one of (1) to (6) above, wherein the developer contains a surfactant represented by the following formula (1-V) or (I-VI): 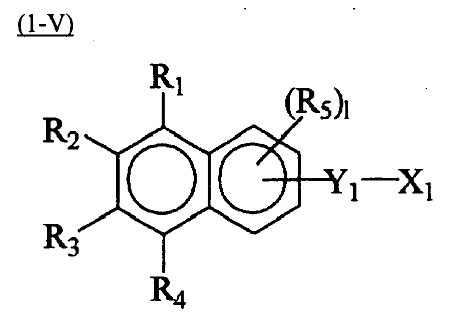 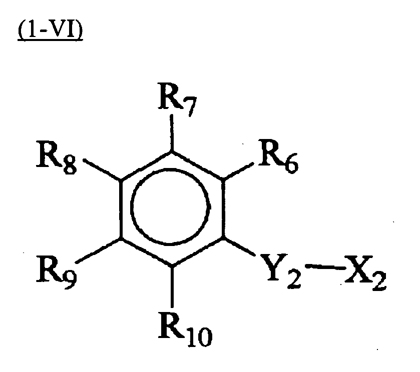 In the formulae, R₁ to R₁₀ each represents a hydrogen atom or an alkyl group; 1 represents an integer of 1 to 3; X₁ and X₂ each represents a sulfonate, a sulfuric monoester salt, a carboxylate or a phosphate; Y₁ and Y₂ each represents -CₙH₂ₙ-, -Cₙ₋ₘH₂₍ₙ₋ₘ₎OCₘH₂ₘ-,-O-(CH₂CH₂O)ₙ-, -O-(CH₂CH₂CH₂O)ₙ- or -CO-NH- wherein n ≥ 1 and n ≥ m ≥ 0; and provided that a total number of carbon atoms included in R₁ to R₅ and Y₁ or R₆ to R₁₀ and Y₂ is 3 or more.
(9) The method for preparation of a lithographic printing plate as described in any one of (1) to (6) above, wherein the developer contains a surfactant represented by any on of the following formulae (1-VII) to (1-IX): 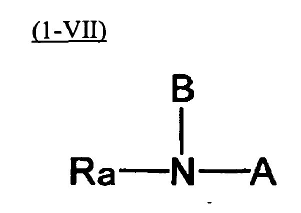 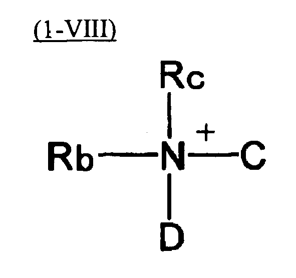 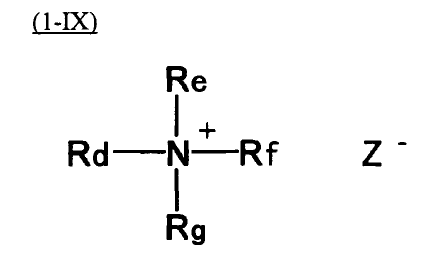 In formula (1-VII), Rₐ represents a hydrogen atom or an alkyl group; and A and B each represents a group containing an ethylene oxide group, a carboxylic acid group or a carboxylate.
   In formula (1-VIII), R_{b} and R_{c} each represents a hydrogen atom or an alkyl group; C represents an alkyl group or a group containing an ethylene oxide group; and D represents a group containing a carboxylic acid anion.
   In formula (1-IX), R_{d}, Rₑ, R_{f} and R_{g} each represents a hydrogen atom or an alkyl group; and Z⁻ represents a counter anion.
(10) A lithographic printing plate precursor comprising a hydrophilic support, a photosensitive layer containing (A) a radical polymerizable compound having an isocyanuric acid group, (B) a binder polymer having an acid value of 0.3 meq/g or less, (C) a sensitizing dye having an absorption maximum in a wavelength range of 360 to 450 nm and (D) a polymerization initiator and a protective layer in this order, wherein the protective layer and an unexposed area of the photosensitive layer is capable of being removed by imagewise exposing the lithographic printing plate precursor with a laser beam of 360 to 450 nm and rubbing a surface of the exposed lithographic printing plate precursor with a rubbing member in the presence of a developer having pH of 2 to 10 in an automatic processor equipped with the rubbing member.

The functional mechanism according to the invention is estimated as follows. Specifically, it is believed that the CON group included in the isocyanuric acid group has hydrophilicity so that the developing property is increased. On the other hand, since the CON group has high cohesion force, the layer becomes strong after polymerization and hardening due to the cohesion to improve the printing durability.

According to the present invention, a lithographic printing plate precursor which is capable of being written with a laser light source having an oscillation wavelength in a range of 360 to 450 nm, is capable of being developed by rubbing a surface of the exposed lithographic printing plate precursor with a rubbing member in the presence of a developer having pH of 2 to 10 and provides a lithographic printing plate having high printing durability, and a plate-making method of the lithographic printing plate precursor can be provided.

### BRIEF DESCRIPTION OF THE DRAWINGS

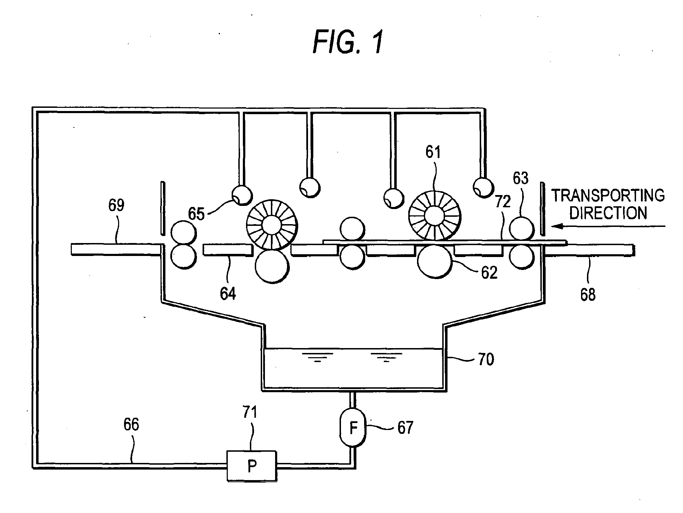

Fig. 1 shows a structure of an automatic development processor.
Description of reference numerals and signs:
- 61:: Rotating brush roller
- 62:: Backing roller
- 63:: Transport roller
- 64:: Transport guide plate
- 65:: Spray pipe
- 66:: Pipe line
- 67:: Filter
- 68:: Plate supply table
- 69:: Plate discharge table
- 70:: Developer tank
- 71:: Circulating pump
- 72:: Plate

### DETAILED DESCRIPTION OF THE INVENTION

The plate-making method of the lithographic printing plate precursor according to the invention will be described in detail below.

The plate-making method of the lithographic printing plate precursor according to the invention is a plate-making method comprising imagewise exposing a lithographic printing plate precursor comprising a support and at least a photosensitive layer with laser of 360 to 450 nm, wherein the method is characterized by comprising imagewise exposing a lithographic printing plate precursor comprising a hydrophilic support, a photosensitive layer containing (A) a radical polymerizable compound having an isocyanuric acid group, (B) a binder polymer having an acid value of 0.3 meq/g or less, (C) a sensitizing dye having an absorption maximum in a wavelength range of 360 to 450 nm and (D) a polymerization initiator and a protective layer in this order with a laser beam of 360 to 450 nm, and rubbing a surface of the exposed lithographic printing plate precursor with a rubbing member in the presence of a developer having pH of 2 to 10 in an automatic processor equipped with the rubbing member to remove the protective layer and an unexposed area of the photosensitive layer.

First, the lithographic printing plate precursor for use in the plate-making method according to the invention is described in detail below.

### <Lithographic printing plate precursor>

The lithographic printing plate precursor for use in the invention is characterized by comprising a support and a photosensitive layer formed from a photosensitive composition containing (A) a radical polymerizable compound, (B) a binder polymer, (C) a sensitizing dye absorbing light of 360 to 450 nm and (D) a polymerization initiator.

The lithographic printing plate precursor according to the invention is described in more detail below.

### [Photosensitive layer]

The photosensitive layer of the lithographic printing plate precursor according to the invention is a photosensitive layer
capable of being removed by rubbing a surface of the lithographic printing plate precursor with a rubbing member in the presence of a developer having pH of 2 to 10 in an automatic processor and is a photosensitive layer of polymerizable negative type formed from a photosensitive composition containing as the essential components, (A) a radical polymerizable compound, (B) a binder polymer, (C) a sensitizing dye absorbing light of 360 to 450 nm and (D) a polymerization initiator, and further, if desired, a coloring agent and other optional components.

The controls of developing speed of the unexposed area of the photosensitive layer and penetration speed of developer into the photosensitive layer after hardening can be performed according to conventional methods in addition to the method of using the above-described binder polymer. For instance, for the purpose of increase in the developing speed of the unexposed area, addition of a hydrophilic compound is useful, and for the purpose of suppression of the penetration of developer into the exposed area, means of addition of a hydrophobic compound is effective.

The photosensitive layer of polymerizable negative type according to the invention can be sensitive to a blue laser useful for CRT because it responds to light of 360 to 450 nm. Such a sensitizing dye absorbing light of 360 to 450 nm forms the electron excited state in high sensitivity upon irradiation (exposure) of the blue laser, and electron transfer, energy transfer or the like relating to the electron excited state acts on a polymerization initiator coexisting in the photosensitive layer to cause chemical change in the polymerization initiator, thereby generating a radical. Then, by the radical thus-generated, a polymerizable compound causes a polymerization reaction so that the exposed area is hardened to from an image area.

In the lithographic printing plate precursor according to the invention, an intermediate layer (also referred to as "undercoat layer") may be provided between the photosensitive layer and the support for the purpose of increasing the adhesion property therebetween and improving the stain resistance. Further, a protective layer (also referred to as "overcoat layer") is provided on the photosensitive layer. The protective layer prevents a low molecular weight compound, for example, oxygen or a basic substance present in the atmosphere, which inhibits the image-forming reaction initiated in the photosensitive layer upon the exposure, from permeating into the photosensitive layer, whereby the protective layer makes it possible to perform the exposure in the atmosphere.

The lithographic printing plate precursor according to the invention is particularly preferable for plate-making including direct drawing with a blue laser having a wavelength of 360 to 450 nm, since the photosensitive layer thereof contains the sensitizing dye absorbing light of 360 to 450 nm, and it exhibits the high image-forming property in comparison with conventional lithographic printing plate precursors.

Each of the components constituting the photosensitive layer of the lithographic printing plate precursor according to the invention will be described in detail below.

### (A) Radical polymerizable compound having an isocyanuric acid group

As the radical polymerizable compound having an isocyanuric acid group for use in the invention, any radical polymerizable compound having an isocyanuric acid group in its molecule can be preferably employed. The radical polymerizable compound having an isocyanuric acid group is preferably that having a molecular weight of 450 or more. By using the compound having such a molecular weight, printing durability is preferably increased. Also, a radical polymerizable group value (i.e., number of radical polymerizable group/molecular weight) of the radical polymerizable compound having an isocyanuric acid group is preferably 4.0 mmol/g or more. By using the compound having such a radical polymerizable group value, the printing durability is more preferably increased.

As the radical polymerizable compound having an isocyanuric acid group for use in the invention, any compound can be preferably employed as long as the compound has an isocyanuric acid group and a radical polymerizable functional group in its molecule. Examples of the radical polymerizable functional group include an acrylic acid ester group, a methacrylic acid ester group, an itaconic acid ester group, a maleic acid ester group, a fumaric acid ester group, an acrylic acid amide group, a methacrylic acid amide group, an itaconic acid amide group, a maleic acid amide group, a fumaric acid amide group, a vinyl ether group, a vinyl ester group, a vinylphenyl group, a vinylcarbonyl group, an allyl group and functional groups derived from these groups. Among them, an acrylic acid ester group, a methacrylic acid ester group, an itaconic acid ester group, a maleic acid ester group, a fumaric acid ester group, an acrylic acid amide group, a vinyl ether group, a vinyl ester group and a vinylphenyl group are preferable, and an acrylic acid ester group and a methacrylic acid ester group are particularly preferable.

Specific examples of the radical polymerizable compound having an isocyanuric acid group for use in the invention are set forth below, but the invention should not be construed as being limited thereto.

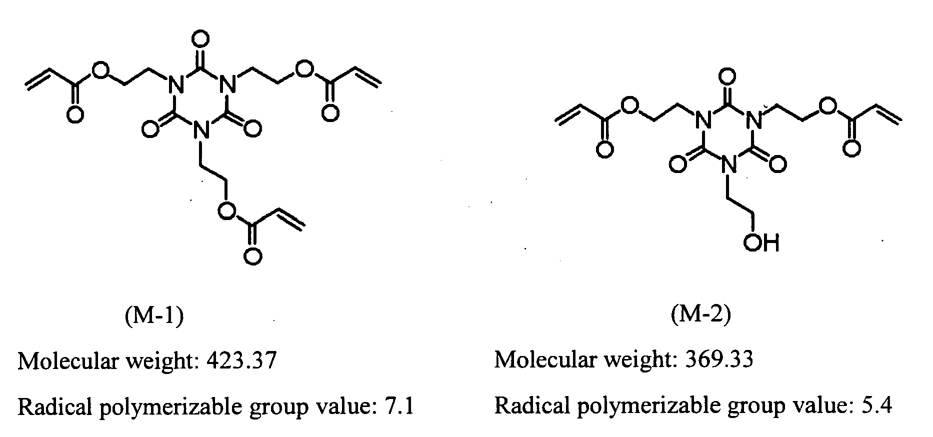

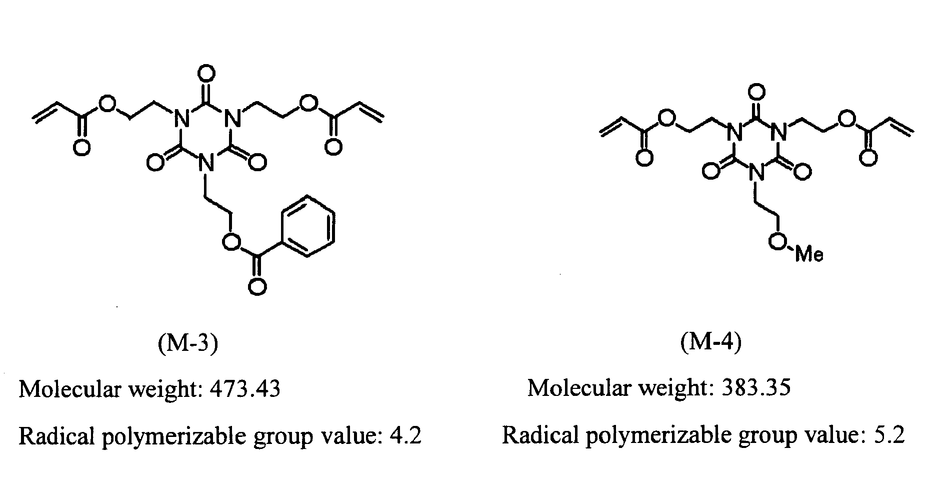

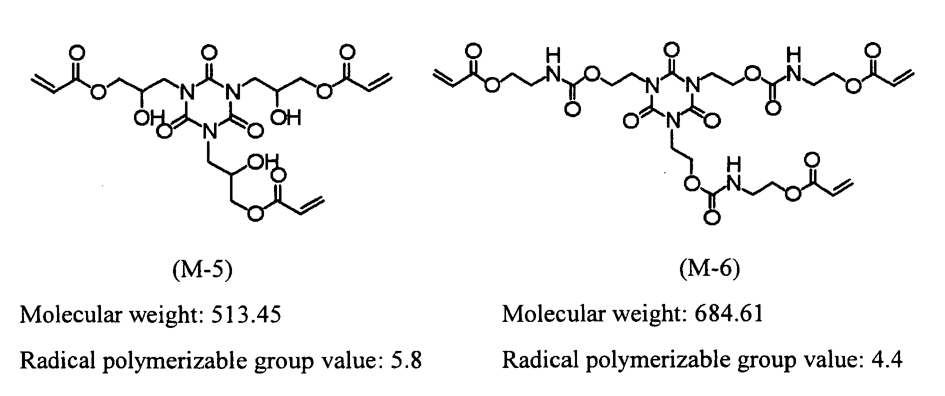

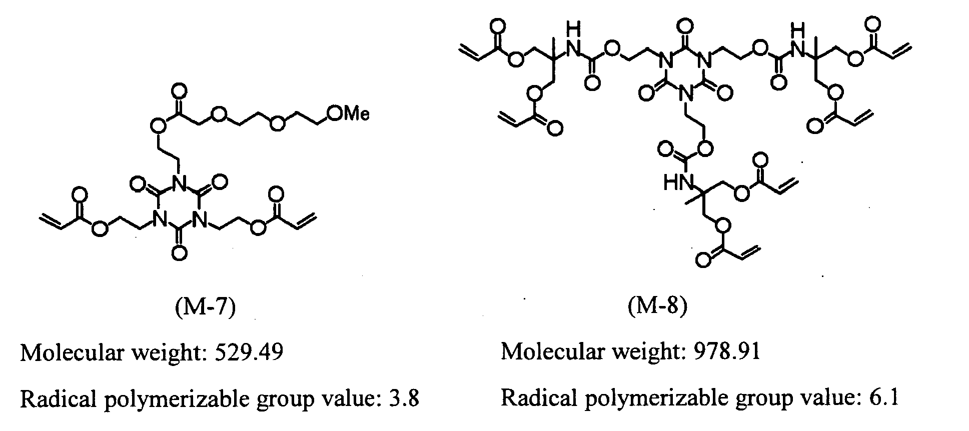

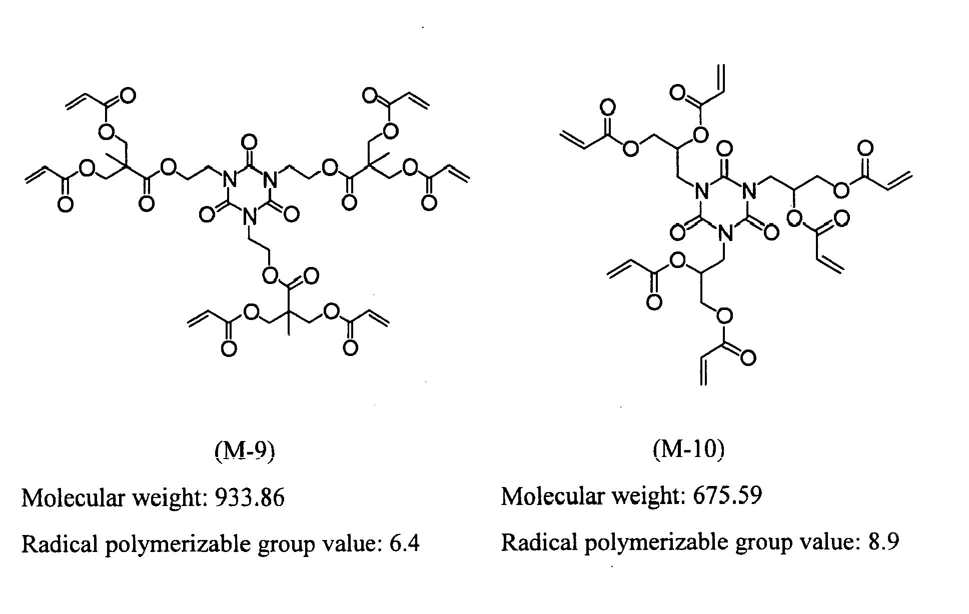

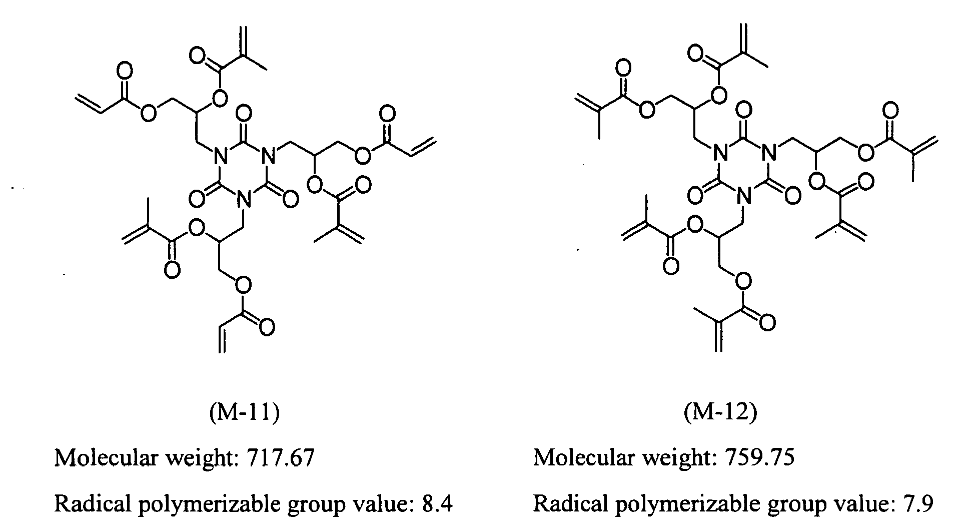

The radical polymerizable compounds having an isocyanuric acid group may be used individually or in combination of two or more thereof. Also, the radical polymerizable compound having an isocyanuric acid group may be used together with a conventional radical polymerizable compound having no isocyanuric acid group. The content of the radical polymerizable compound having an isocyanuric acid group and the conventional radical polymerizable compound having no isocyanuric acid group used together is preferably from 10 to 90% by weight, more preferably from 20 to 80% by weight, in the photosensitive layer. A molar ratio of the content of the radical polymerizable compound having an isocyanuric acid group to the content of the conventional radical polymerizable compound having no isocyanuric acid group contained in the photosensitive layer is preferably from 100/0 to 50/50, more preferably from 100/0 to 60/40, and particularly preferably from 100/0 to 70/30.

### (B) Binder polymer having an acid value of 0.3 meq/g or less (also referred to as "hydrophobic binder polymer")

The hydrophobic binder polymer which can be used in the photosensitive layer according to the invention is preferably a water-insoluble polymer. Further, the hydrophobic binder polymer which can be used in the invention preferably does not substantially contain an acid group, for example, a carboxyl group, a sulfonic acid group or a phosphoric acid group. An acid value (acid content per g of polymer, indicated by the chemical equivalent number) of the binder polymer is 0.3 meq/g or less and preferably 0.1 meq/g or less.

Specifically, the hydrophobic binder polymer which can be used in the invention is preferably insoluble in water and an aqueous solution having pH of 10 or more. The solubility of the hydrophobic binder polymer in water or an aqueous solution having pH of 10 or more is preferably 0.5% by weight or less, more preferably 0.1 % by weight or less. By using such a hydrophobic binder polymer, film strength, water resistance and ink-receptive property of the photosensitive layer are increased and improvement in printing durability can be achieved.

As for the hydrophobic binder polymer, conventionally known hydrophobic binder polymers preferably having the solubility in the above-described range can be used without limitation as long as the performance of the lithographic printing plate of the invention is not impaired, and a linear organic polymer having film-forming property is preferred.

Preferable examples of such a hydrophobic binder polymer include a polymer selected from an acrylic resin, a polyvinyl acetal resin, a polyurethane resin, a polyamide resin, an epoxy resin, a methacrylic resin, a styrene-based resin and a polyester resin. Among these, an acrylic resin is preferred, and a (meth)acrylic acid ester copolymer is more preferred. More specifically, a copolymer of a (meth)acrylic acid alkyl or aralkyl ester with a (meth)acrylic acid ester containing a -CH₂CH₂O- or -CH₂CH₂NH- unit in R of the ester residue (-COOR) of the (meth)acrylic acid ester is particularly preferred. The alkyl group in the (meth)acrylic acid alkyl ester is preferably an alkyl group having from 1 to 5 carbon atoms, more preferably a methyl group. Preferred examples of the (meth)acrylic acid aralkyl ester include benzyl (meth)acrylate.

The hydrophobic binder polymer can be imparted with a crosslinking property in order to increase the film strength of the image area.

In order to impart the crosslinking property to the binder polymer, a crosslinkable functional group, for example, an ethylenically unsaturated bond is introduced into a main chain or side chain of the polymer. The crosslinkable functional group may be introduced by copolymerization or a polymer reaction.

The term "crosslinkable group" as used herein means a group capable of crosslinking the polymer binder in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bonding group, an amino group or an epoxy group as a functional group capable of conducting an addition polymerization reaction. Also, a functional group capable of forming a radical upon irradiation with light may be used and such a crosslinkable group includes, for example, a thiol group, a halogen atom and an onium salt structure.

Among them, the ethylenically unsaturated bonding group is preferable, and functional groups represented by formulae (1) to (3) shown below are particularly preferable.

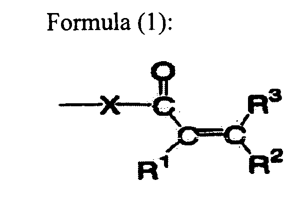

In formula (1), R¹ to R³ each independently represents a hydrogen atom or a monovalent organic group. R¹ preferably includes, for example, a hydrogen atom or an alkyl group which may have a substituent. Among them, a hydrogen atom or a methyl group is preferable because of high radical reactivity. R² and R³ each independently preferably includes, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

X represents an oxygen atom, a sulfur atom or -N(R¹²)-, and R¹² represents a hydrogen atom or a monovalent organic group. The monovalent organic group represented by R¹² includes, for example, an alkyl group which may have a substituent. Among them, a hydrogen atom, a methyl group, an ethyl group or an isopropyl group is preferable because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

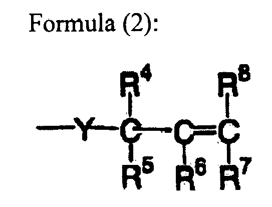

In formula (2), R⁴ to R⁸ each independently represents a hydrogen atom or a monovalent organic group. R⁴ to R⁸ each independently preferably includes, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable.

Examples of the substituent introduced include those described in Formula (1). Y represents an oxygen atom, a sulfur atom or -N(R¹²)-, and R¹² has the same meaning as R¹² defined in Formula (1). Preferred examples for R¹² are also same as those described in Formula (1).

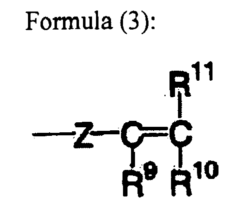

In formula (3), R⁹ preferably represents a hydrogen atom or an alkyl group which may have a substituent. Among them, a hydrogen atom or a methyl group is preferable because of high radical reactivity. R¹⁰ and R¹¹ each independently represents, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

Examples of the substituent introduced include those described in Formula (1). Z represents an oxygen atom, a sulfur atom, -N(R¹³)- or a phenylene group which may have a substituent. R¹³ includes an alkyl group which may have a substituent or the like. Among them, a methyl group, an ethyl group or an isopropyl group is preferable because of high radical reactivity.

Among the polymers, a (meth)acrylic acid copolymer and a polyurethane each having a crosslinkable group in the side chain thereof are more preferable.

In the hydrophobic binder polymer having a crosslinking property, for example, a free radical (a polymerization initiating radical or a propagating radical in the process of polymerization of the polymerizable compound) is added to the crosslinkable functional group to cause an addition-polymerization between polymers directly or through a polymerization chain of the polymerizable compound, as a result, crosslinking is formed between polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between polymer molecules to effect curing.

The content of the crosslinkable group (content of radical-polymerizable unsaturated double bond determined by iodine titration) in the hydrophobic binder polymer is preferably from 0.1 to 10.0 mmol, more preferably from 1.0 to 7.0 mmol, and most preferably from 2.0 to 5.5 mmol, per g of the hydrophobic binder polymer.

In view of improvement in the developing property with an aqueous solution, the binder polymer is preferably hydrophilic. On the other hand, in view of increasing the printing durability, it is important that the binder polymer has good compatibility with the polymerizable compound contained in the photosensitive layer, that is, the binder polymer is preferably oleophilic. From these standpoints, it is also effective in the invention to copolymerize a hydrophilic group-containing component and an oleophilic group-containing component in the hydrophobic binder polymer in order to improve the developing property and the printing durability. Examples of the hydrophilic group-containing component which can be preferably used include those having a hydrophilic group, for example, a hydroxy group, a carboxylate group, a hydroxyethyl group, an ethyleneoxy group, a hydroxypropyl group, a polyoxyethyl group, a polyoxypropyl group, an amino group, an aminoethyl group, an aminopropyl group, an ammonium group, an amido group and a carboxymethyl group.

The hydrophobic binder polymer preferably has a weight average molecular weight of 5,000 or more, more preferably 10,000 or more, still more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The hydrophobic binder polymer preferably has a glass transition point (Tg) of 80°C or less, more preferably 70°C or less. The Tg can be measured, for example, by a differential scanning calorimeter.

The hydrophobic binder polymer may be any of a random polymer, a block polymer, a graft polymer and the like, and it is preferably a random polymer.

The hydrophobic binder polymers may be used individually or in combination of two or more thereof.

The content of the hydrophobic binder polymer is from 5 to 90% by weight, preferably from 10 to 70% by weight, more preferably from 10 to 60% by weight, based on the total solid content of the photosensitive layer. In the above-described range, preferable strength of the image area and good image-forming property are achieved.

Preferable specific examples of the binder polymer are set forth below, but the invention should not be construed as being limited thereto.

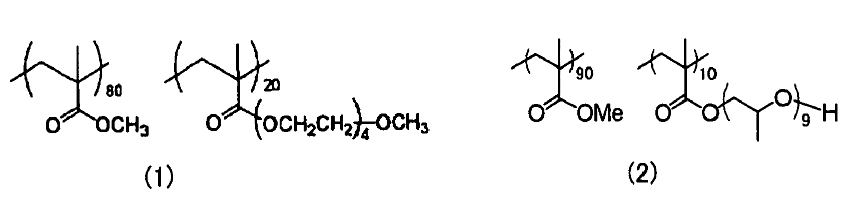

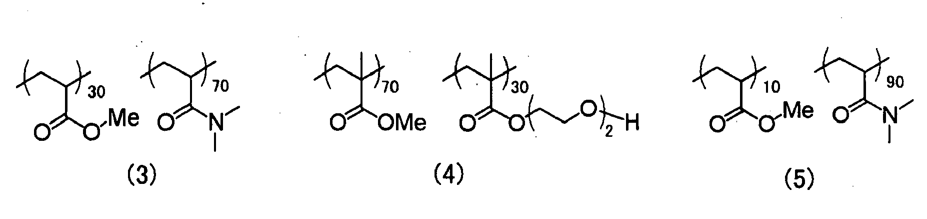

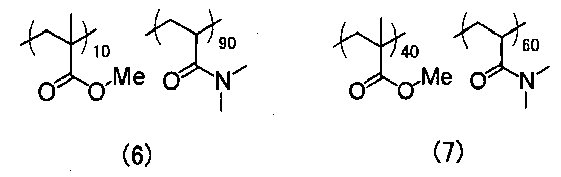

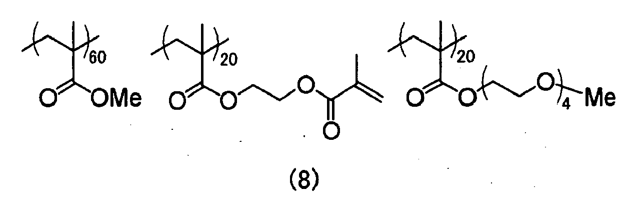

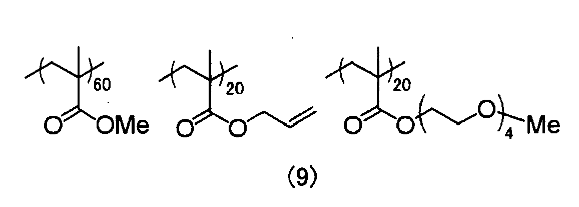

### (C) Sensitizing dye having an absorption maximum in a wavelength range of from 360 to 450 nm

The sensitizing dye for use in the invention has an absorption maximum in a wavelength range of 360 to 450 nm. Examples of the sensitizing dye include merocyanine dyes represented by formula (I) shown below, benzopyranes or coumarins represented by formula (II) shown below, aromatic ketones represented by formula (III) shown below, and anthracenes represented by formula (IV) shown below.

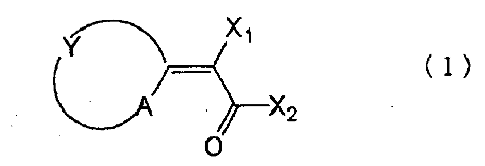

In formula (I), A represents a sulfur atom or NR₁, R₁ represents a hydrogen atom or a monovalent non-metallic atomic group, Y represents a non-metallic atomic group necessary for forming a basic nucleus of the dye together with adjacent A and the adjacent carbon atom, and X₁ and X₂ each independently represents a hydrogen atom or a monovalent non-metallic atomic group or X₁ and X₂ may be combined with each other to form an acidic nucleus of the dye.

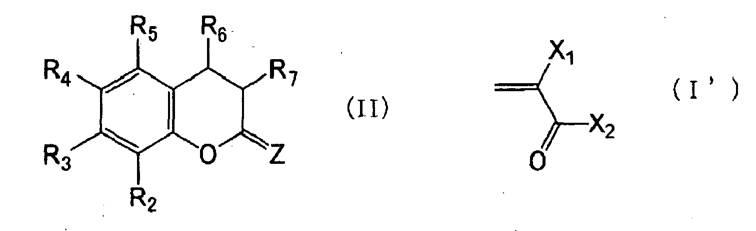

In formula (II), =Z represents a carbonyl group, a thiocarbonyl group, an imino group or an alkylydene group represented by the partial structural formula (I') described above, X₁ and X₂ have the same meanings as defined in formula (II) respectively, and R₂ to R₇ each independently represents a hydrogen atom or a monovalent non-metallic atomic group.

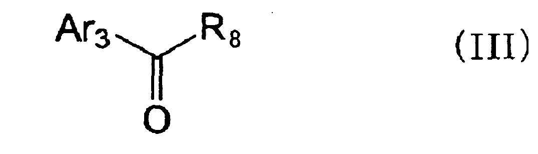

In formula (III), Ar₃ represents an aromatic group which may have a substituent or a heteroaromatic group which may have a substituent, and R₈ represents a hydrogen atom or a monovalent non-metallic atomic group. R₈ preferably represents an aromatic group or a heteroaromatic group. Ar₃ and R₈ may be combined with each other to form a ring.

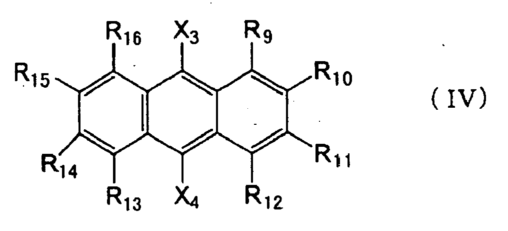

In formula (IV), X₃, X₄ and R₉ to R₁₆ each independently represents a hydrogen atom or a monovalent non-metallic atomic group. Preferably, X₃ and X₄ each independently represents an electron-donating group having a negative Hammett substituent constant.

In formulae (I) to (IV), preferable examples of the hydrogen atom and monovalent non-metallic atomic group represented by any one of X₁ to X₄ and R₁ to R₁₆ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-l-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group or a phosphonatophenyl group), a heteroaryl group (for example, a heteroaryl group derived from thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine), an alkenyl group (for example, a vinyl group, a 1-propenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl group), a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, and a nitro group. Among the above-described groups, a hydrogen atom, an alkyl group, an aryl group, a halogen atom, an alkoxy group and an acyl group are particularly preferred.

The basic nucleus of the dye formed by Y together with the adjacent A and the adjacent carbon atom in formula (I) includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenyl)thiazole or 4-(2-thienyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole; 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole or 5-ethoxycarbonylbenzothiazole); naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7',6',4,5-thiazole); oxazoles (for example, 4-methyloxazole, 5-methyloxazole, 4-phenyloxazole, 4,5-diphenyloxazole, 4-ethyloxazole, 4,5-dimethyloxazole or 5-phenyloxazole); benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole or 6-hydroxybenzoxazole); naphthoxazoles (for example, naphth[1,2]oxazole or naphth[2,1]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1]selenazole); thiazolines (for example, thiazoline or 4-methylthiazoline); 2-quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline); 4-quinolines (for example, quinoline, 6-methoxyquinoline, 7-methylquinoline or 8-methylquinoline); 1-isoquinolines (for example, isoquinoline or 3,4-dihydroisoquinoline); 3-isoquinolines (for example, isoquinoline); benzimidazoles (for example, 1,3-diethylbenzimidazole or 1-ethyl-3-phenylbenzimidazole); 3,3-dialkylindolenines (for example, 3,3-dimethylindolenine, 3,3,5-trimethylindolenine or 3,3,7-trimethylindolenine); 2-pyridines (for example, pyridine or 5-methylpyridine); and 4-pyridines (for example, pyridine).

Examples of the sulfur-containing heterocyclic ring include dithiol partial structures in dyes described in JP-A-3-296759.

Specific examples thereof include benzodithiols (for example, benzodithiol, 5-tert-butylbenzodithiol or 5-methylbenzodithiol); naphthodithiols (for example, naphtho[1,2]dithiol or naphtho[2,1]dithiol); and dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol).

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolilydene group.

Of the compounds having an absorption maximum in a wavelength range of 360 to 450 nm as the sensitizing dyes, dyes represented by formula (V) shown below are more preferable in view of high sensitivity.

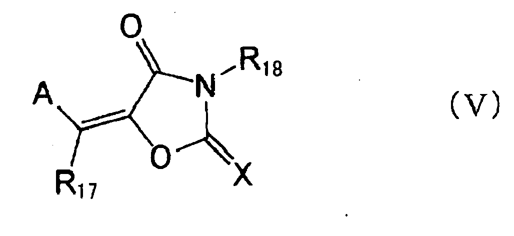

In formula (V), A represents an aromatic cyclic group which may have a substituent or a heterocyclic group which may have a substituent, X represents an oxygen atom, a sulfur atom or =N(R₁₉), and R₁₇, R₁₈ and R₁₉ each independently represents a hydrogen atom or a monovalent non-metallic atomic group, or A and R₁₇ or R₁₈ and R₁₉ may be combined with each other to form an aliphatic or aromatic ring.

The formula (V) will be described in more detail below. R₁₇, R₁₈ and R₁₉ each independently represents a hydrogen atom or a monovalent non-metallic atomic group, preferably a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxy group or a halogen atom.

Preferable examples of R₁₇, R₁₈ and R₁₉ will be specifically described below. Preferable examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, a monovalent non-metallic atomic group is used. Preferable examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an -N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, a nitro group, an aryl group, a heteroaryl group, an alkenyl group and an alkynyl group.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group and a phosphonatophenyl group.

Preferable examples of the heteroaryl group represented by any one of R₁₇, R₁₈ and R₁₉ include a monocyclic or polycyclic aromatic cyclic group containing at least one of a nitrogen atom, an oxygen atom and a sulfur atom. Examples of especially preferable heteroaryl group include a heteroaryl group derived from thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine. These groups may be benzo-fused or may have a substituent.

Also, preferable examples of the alkenyl group represented by any one of R₁₇, R₁₈ and R₁₉ include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of G₁ in the acyl group (G₁CO-) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferable alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any one of R₁₇, R₁₈ and R₁₉, which is obtained by combining the above-described substituent with the alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group; an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferable examples of the aryl group represented by any one of R₁₇, R₁₈ and R₁₉ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Specific examples of the preferable substituted aryl group represented by any one of R₁₇, R₁₈ and R₁₉ include aryl groups having a monovalent non-metallic atomic group as a substituent on the ring-forming carbon atom of the above-described aryl group. Preferable examples of the substituent include the above-described alkyl groups and substituted alkyl groups, and the substituents described for the above-described substituted alkyl group. Specific examples of the preferable substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group and a 3-butynylphenyl group.

Next, A in formula (V) will be described below. A represents an aromatic cyclic group which may have a substituent or heterocyclic group which may have a substituent. Specific examples of the aromatic cyclic group which may have a substituent or heterocyclic group which may have a substituent include those described for any one of R₁₇, R₁₈ and R₁₉ in formula (V).

The sensitizing dye represented by formula (V) is obtained by a condensation reaction of the above-described acidic nucleus or an active methyl group-containing acidic nucleus with a substituted or unsubstituted, aromatic ring or hetero ring and can be synthesized with reference to JP-B-59-28329.

Preferable specific examples (D1) to (D41) of the compound represented by formula (V) are set forth below. Further; when isomers with respect to a double bond connecting an acidic nucleus and a basic nucleus are present in each of the compounds, the invention should not be construed as being limited to any one of the isomers.

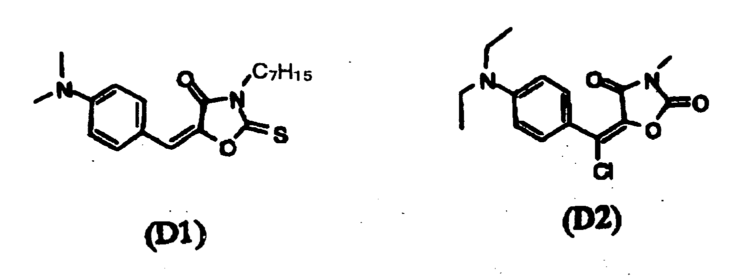

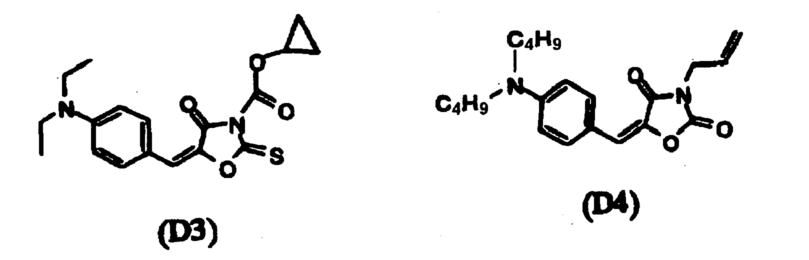

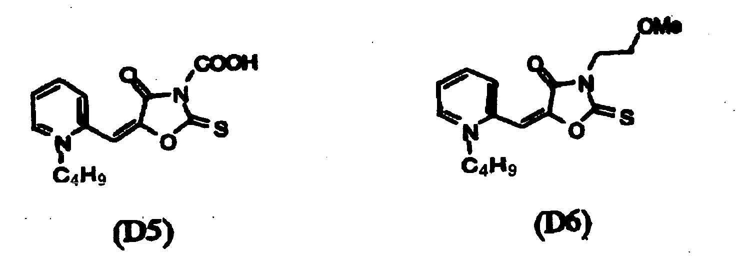

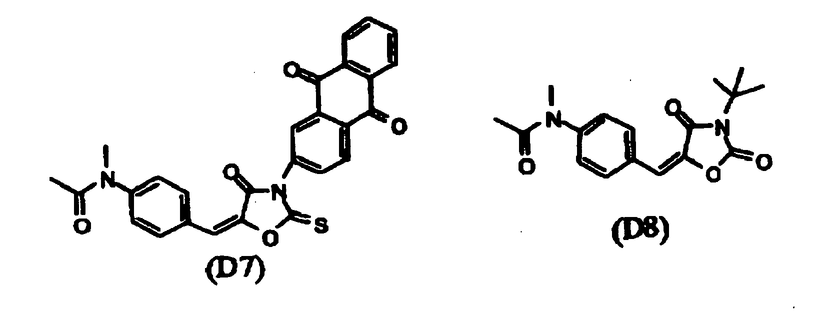

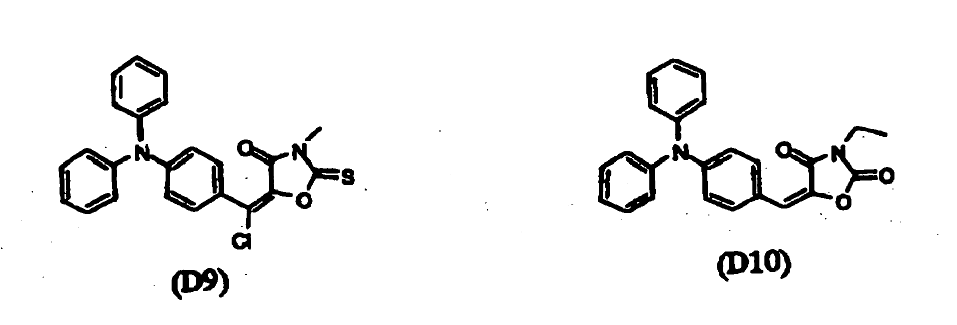

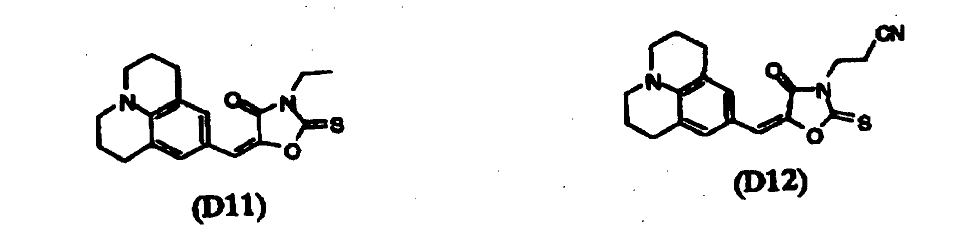

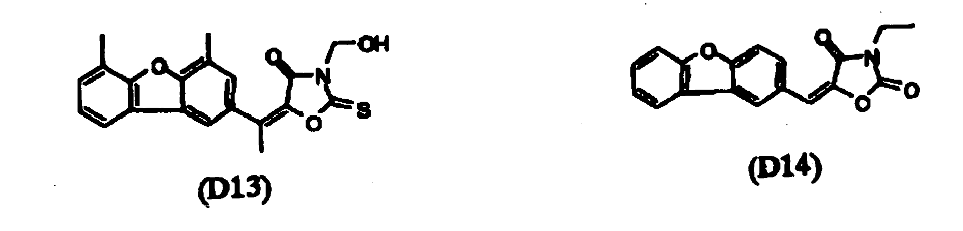

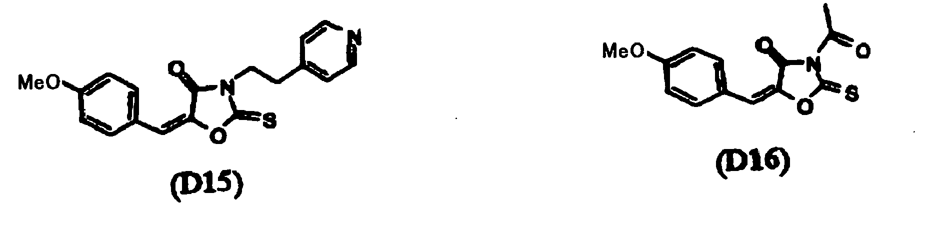

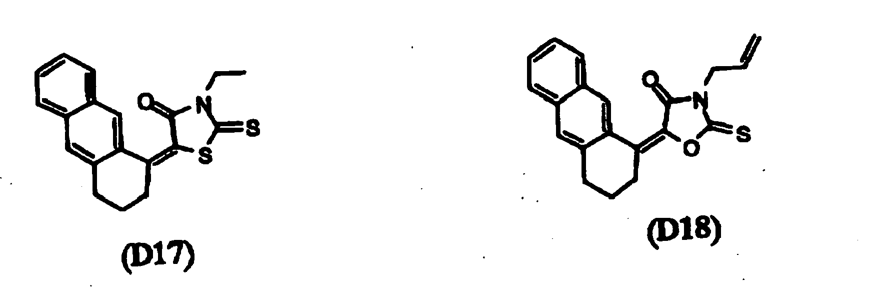

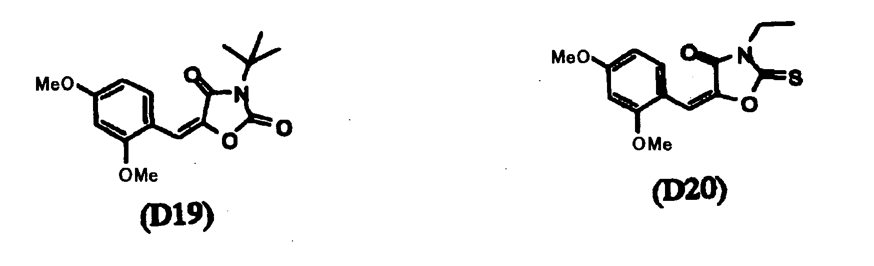

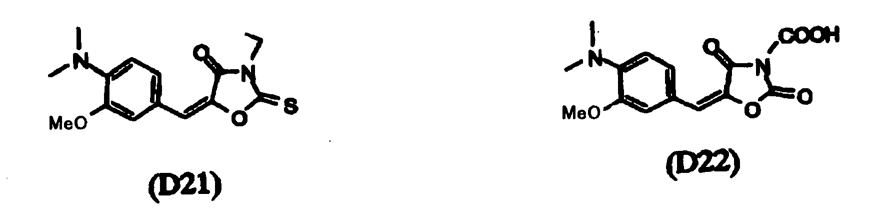

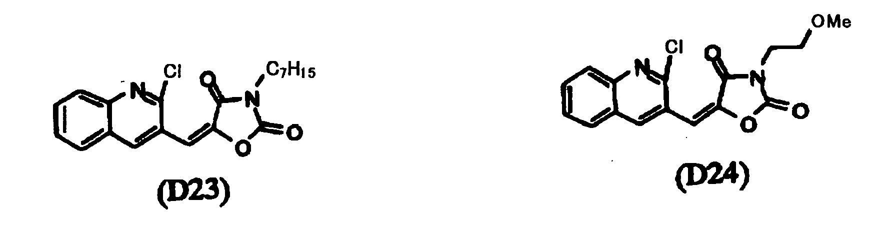

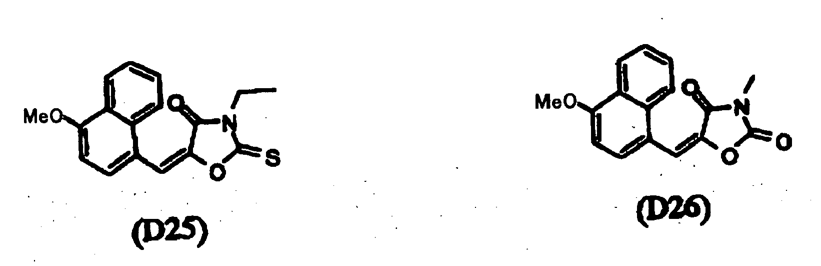

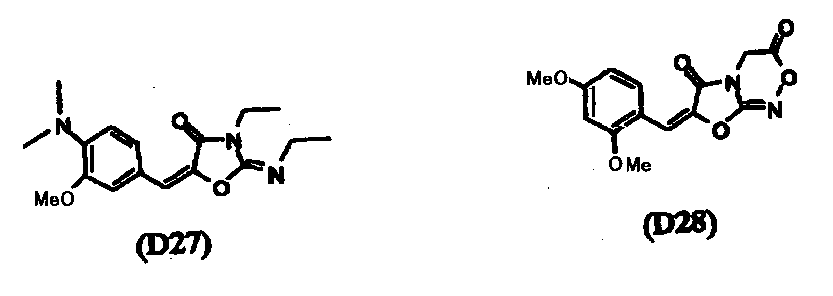

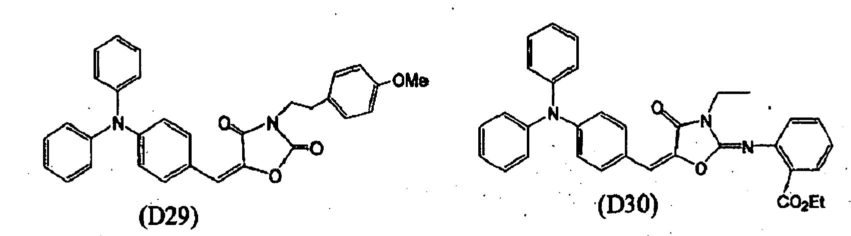

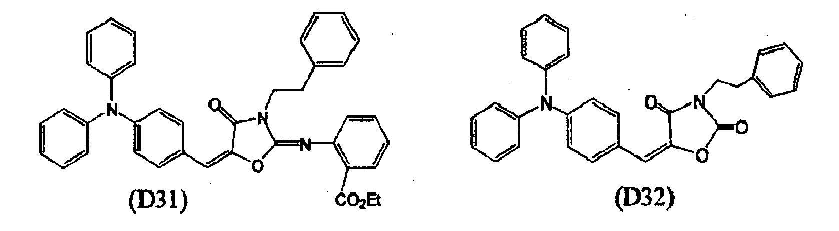

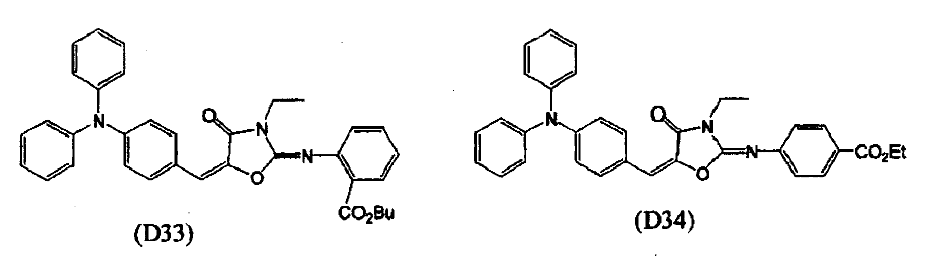

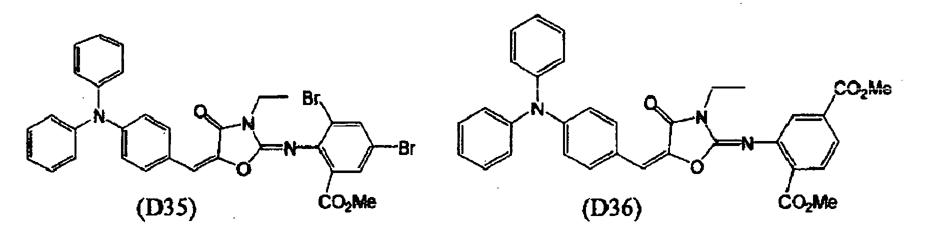

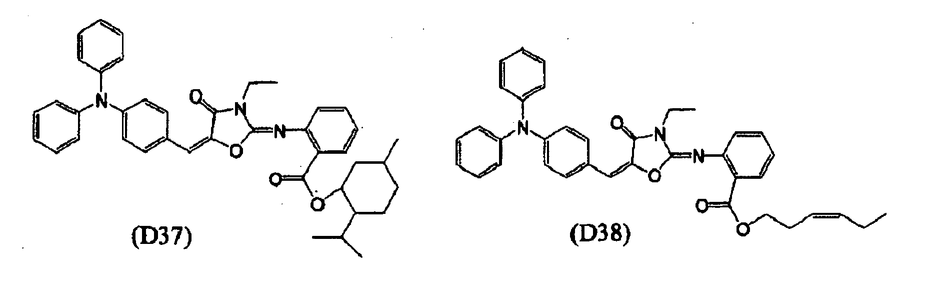

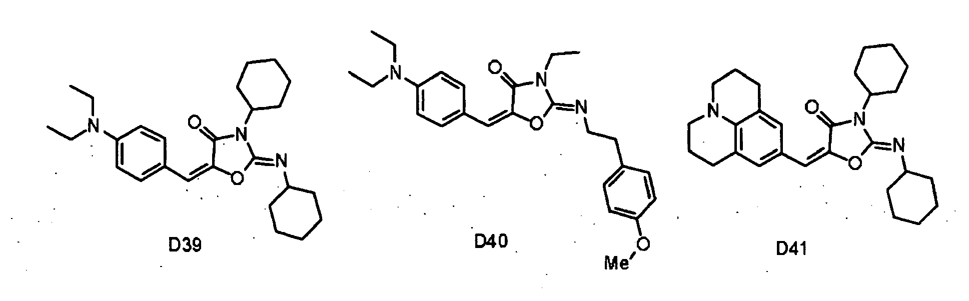

The sensitizing dye absorbing light of 360 to 450 nm is preferably used in a range from 1.0 to 10.0% by weight, more preferably from 1.5 to 5.0% by weight, based on the total solid content of the photosensitive layer.

### (D) Polymerization initiator

The polymerization initiator for use in the invention is a compound which generates a radical with light energy or heat energy to initiate or accelerate polymerization of a compound having a polymerizable unsaturated group. The polymerization initiator according to the invention is appropriately selected to use, for example, from known polymerization initiators and compounds containing a bond having small bond dissociation energy.

The polymerization initiators include, for example, organic halogen compounds, carbonyl compounds, organic peroxides, azo compounds, azido compounds, metallocene compounds, hexaarylbiimidazole compounds, organic boron compounds, disulfone compounds, oxime ester compounds and onium salt compounds.

The organic halogen compounds described above specifically include, for example, compounds described in Wakabayashi et al., Bull. Chem. Soc. Japan, 42, 2924 (1969), U.S. Patent 3,905,815, JP-B-46-4605, JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339 and M. P. Hutt, Journal of Heterocyclic Chemistry, 1, No. 3 (1970). Among them, oxazole compounds and s-triazine compounds each substituted with a trihalomethyl group are preferable.

More preferably, s-triazine derivatives in which at least one of mono-, di- or tri-halogen substituted methyl group is connected to the s-triazine ring and oxazole derivatives in which at least one of mono-, di- or tri-halogen substituted methyl group is connected to the oxazole ring are exemplified. Specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis-(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl-4,6-bis(trichloromethyl)-s-triazine, 2-(p-isopropyloxystyryl-4,6-bis(trichloromethyl)-s-triazine; 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine and compounds shown below.

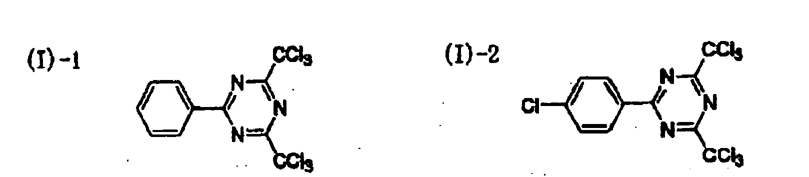

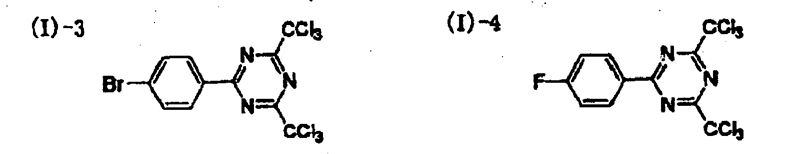

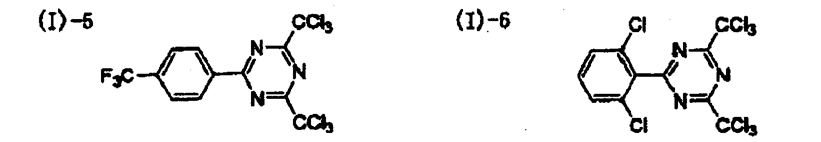

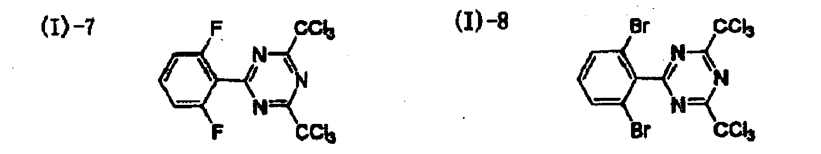

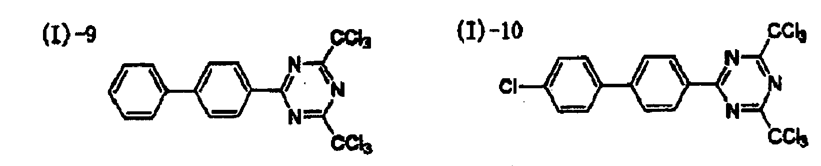

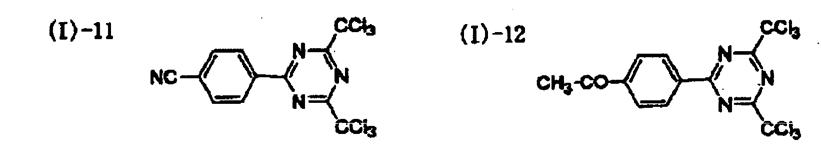

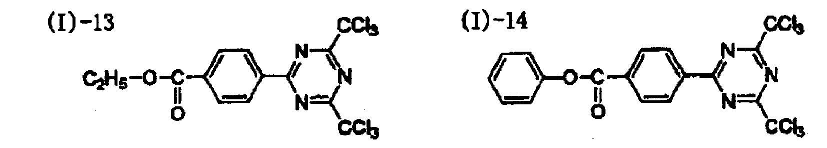

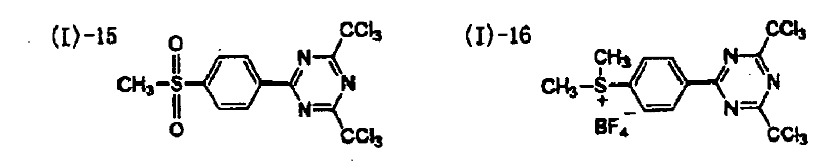

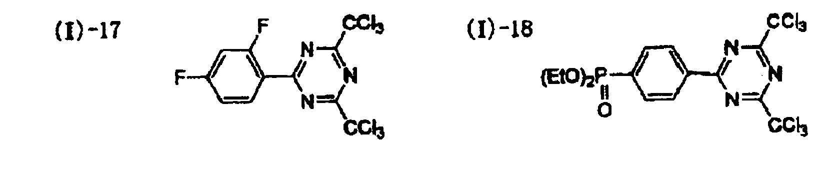

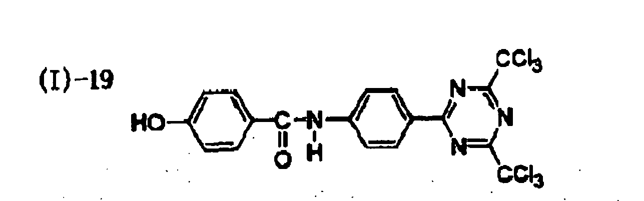

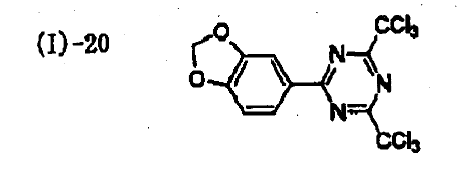

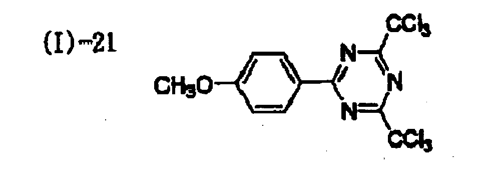

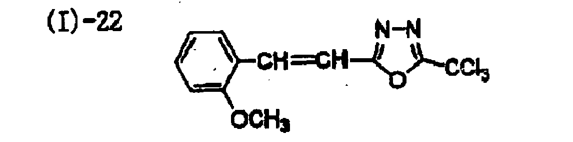

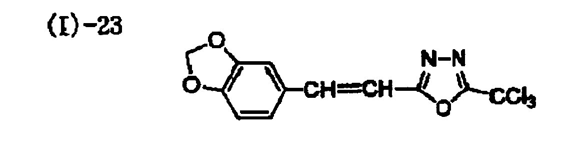

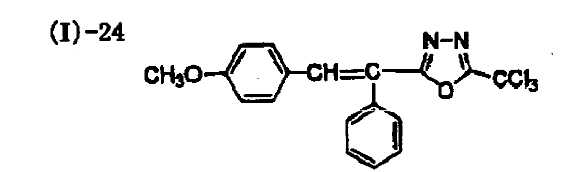

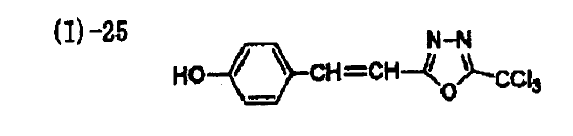

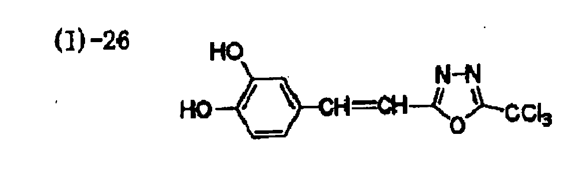

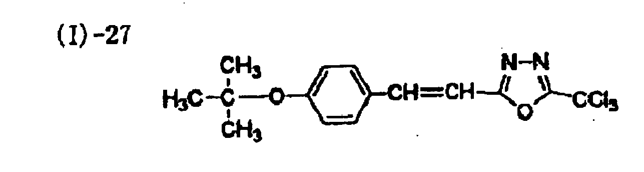

The carbonyl compounds described above include, for example, benzophenone derivatives, e.g., benzophenone, Michler's ketone, 2-methylbenzophenone, 3-methylbenzophenone, 4-methylbenzophenone, 2-chlorobenzophenone, 4-bromobenzophenone or 2-carboxybenzophenone, acetophenone derivatives, e.g., 2,2-dimethoxy-2-phenylacetophenone, 2,2-diethoxyacetophenone, 1-hydroxycyclohexylphenylketone, α-hydroxy-2-methylphenylpropane, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propane or 1,1,1,-trichloromethyl-(p-butylphenyl)ketone, thioxantone derivatives, e.g., thioxantone, 2-ethylthioxantone, 2-isopropylthioxantone, 2-chlorothioxantone, 2,4-dimetylthioxantone, 2,4-dietylthioxantone or 2,4-diisopropylthioxantone, and benzoic acid ester derivatives, e.g., ethyl p-dimethylaminobenzoate or ethyl p-diethylaminobenzoate.

The azo compounds described above include, for example, azo compounds described in JP-A-8-108621.

The organic peroxides described above include, for example, trimethylcyclohexanone peroxide, acetylacetone peroxide, 1,1-bis(tert-butylperoxy)-3,3,5-trimethylcyclohexane, 1,1 -bis(tert-butylperoxy)cyclohexane, 2,2-bis(tert-butylperoxy)butane, tert-butylhydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, peroxy succinic acid, benzoyl peroxide, 2,4-dichlorobenzoyl peroxide, diisopropylperoxy dicarbonate, di-2-ethylhexylperoxy dicarbonate, di-2-ethoxyethylperoxy dicarbonate, dimethoxyisopropylperoxy dicarbonate, di(3-methyl-3-methoxybutyl)peroxy dicarbonate, tert-butylperoxy acetate, tert-butylperoxy pivalate, tert-butylperoxy neodecanoate, tert-butylperoxy octanoate, tert-butylperoxy laurate, tersyl carbonate, 3,3',4,4'-tetra(tert-butylperoxycarbonyl)benzophenone, 3,3',4,4'-tetra(tert-hexylperoxycarbonyl)benzophenone, 3,3',4,4'-tetra(p-isopropylcumylperoxycarbonyl)benzophenone, carbonyl di(tert-butylperoxydihydrogen diphthalate) and carbonyl di(tert-hexylperoxydihydrogen diphthalate).

The metallocene compounds described above include, for example, various titanocene compounds described in JP-A-59-152396, JP-A-61-151197, JP-A-63-41484, JP-A-2-249, JP-A-2-4705 and JP-A-5-83588, for example, dicyclopentadienyl-Ti-bisphenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-triafluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-triafluorophen-1-yl, dimethylcyclopentadienyl-Ti-bis-2,3,5,6-tetrafluorophen-1-yl, dimethylcyclopentadienyl-Ti-bis-2,3,4,5,6-pentafluorophen-1-yl, or bis(cyclopentadienyl)-bis(2,6-difluoro-3-(pyr-l-yl)phenyl) titanium and iron-arene complexes described in JP-A-1-304453 and JP-A-1-152109.

The hexaarylbiimidazole compounds described above include, for example, various compounds described in JP-B-6-29285 and U.S. Patents 3,479,185, 4,311,783 and 4,622,286, specifically, for example, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimidazole.

The organic boron compounds described above include, for example, organic boric acid salts described in JP-A-62-143044, JP-A-62-150242, JP-A-9-188685, JP-A-9-188686, JP-A-9-188710, JP-A-2000-131837, JP-A-2002-107916, Japanese Patent 2764769, JP-A-2002-116539 and Martin Kunz, Rad Tech '98, Proceeding, April 19-22 (1998), Chicago, organic boron sulfonium complexes or organic boron oxosulfonium complexes described in JP-A-6-157623, JP-A-6-175564 and JP-A-6-175561, organic boron iodonium complexes described in JP-A-6-175554 and JP-A-6-175553, organic boron phosphonium complexes described in JP-A-9-188710, and organic boron transition metal coordination complexes described in JP-A-6-348011, JP-A-7-128785, JP-A-7-140589, JP-A-7-306527 and JP-A-7-292014.

The disulfone compounds described above include, for example, compounds described in JP-A-61-166544 and JP-A-2002-328465.

The oxime ester compounds described above include, for example, compounds described in J. C. S. Perkin II, 1653-1660 (1979), J. C. S. Perkin II, 156-162 (1979), Journal of Photopolymer Science and Technology, 202-232 (1995) and JP-A-2000-66385, and compounds described in JP-A-2000-80068. Specific examples thereof include compounds represented by the following structural formulae:

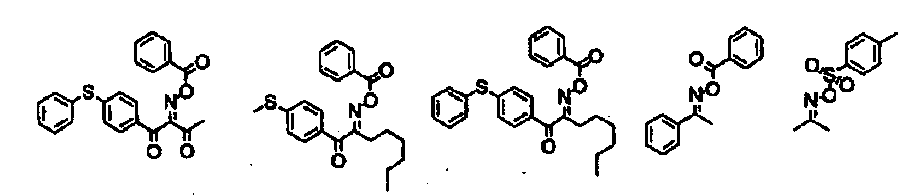

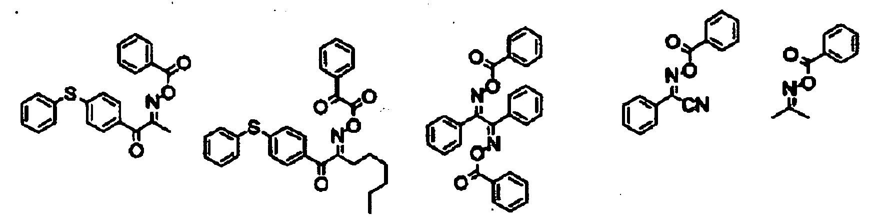

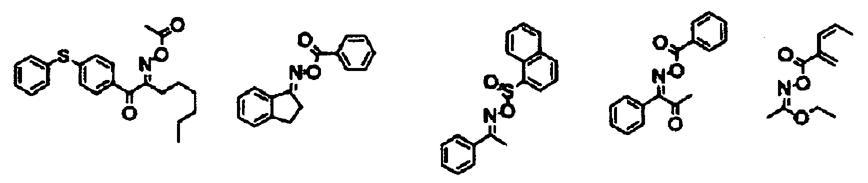

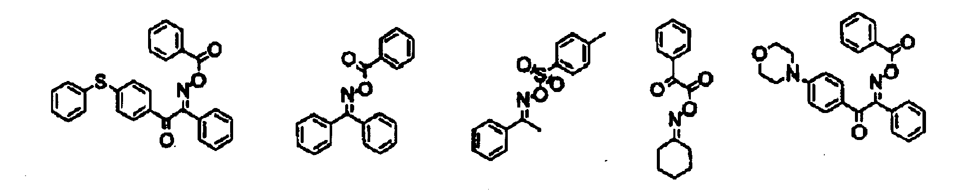

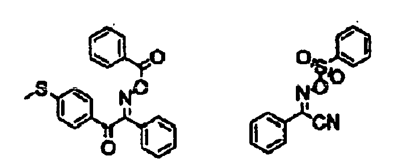

The onium salt compounds described above include onium salts, for example, diazonium salts described in S. I. Schlesinger, Photogr. Sci. Eng., 18, 387 (1974) and T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U.S. Patents 339,049 and 410,201, JP-A-2-150848 and JP-A-2-296514, sulfonium salts described in European Patents 370,693, 390,214, 233,567, 297,443 and 297,442, U.S. Patents 4,933,377, 161,811, 410,201, 339,049, 4,760,013, 4,734,444 and 2,833,827 and German Patents 2,904,626, 3,604,580 and 3,604,581, selenonium salts described in J.V. Crivello et al., Macromolecules, 10 (6), 1307 (1977) and J.V. Crivello et al., J. Polymer Sci., Polymer Chem. Ed., 17, 1047 (1979), and arsonium salts described in C.S. Wen et al., Teh, Proc. Conf. Rad. Curing ASIA, p. 478, Tokyo, Oct. (1988).

In the invention, the onium salt functions not as an acid generator, but as an ionic radical polymerization initiator.

The onium salts preferably used in the invention include onium salts represented by the following formulae (RI-I) to (RI-III):

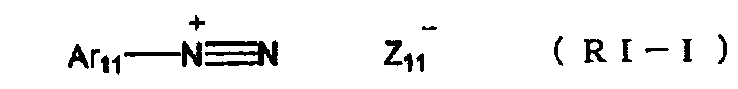

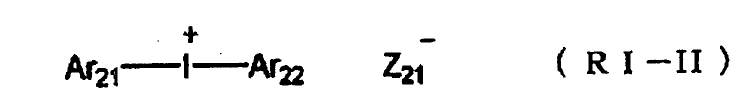

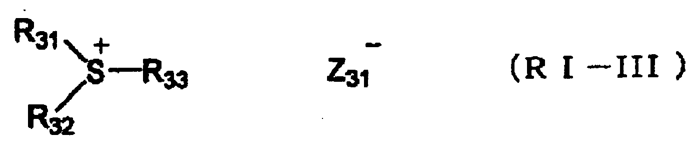

In formula (RI-I), Ar₁₁ represents an aryl group having 20 or less carbon atoms, which may have 1 to 6 substituents. Preferable examples of the substituent include an alkyl group having from 1 to 12 carbon atoms, an alkenyl group having from 2 to 12 carbon atoms, an alkynyl group having from 2 to 12 carbon atoms, an aryl group having from 6 to 18 carbon atoms, an alkoxy group having from 1 to 12 carbon atoms, an aryloxy group having from 6 to 18 carbon atoms, a halogen atom, an alkylamino group having from 1 to 12 carbon atoms, a dialkylimino group having from 2 to 12 carbon atoms, an alkylamido group having from 2 to 12 carbon atoms, an arylamido group having from 7 to 19 carbon atoms, a carbonyl group, a carboxyl group, a cyano group, a sulfonyl group, an thioalkyl group having from 1 to 12 carbon atoms and an thioaryl group having from 6 to 18 carbon atoms. Z₁₁⁻ represents a monovalent anion. Specific examples of the monovalent anion include a halogen ion, a perchlorate ion, a hexafluorophosphate ion, a tetrafluoroborate ion, a sulfonate ion, a sulfinate ion, a thosulfonate ion and a sulfate ion. Among them, a perchlorate ion, a hexafluorophosphate ion, a tetrafluoroborate ion, a sulfonate ion and a sulfinate ion are preferred in view of stability.

In the formula (RI-II), Ar₂₁ and Ar₂₂ each independently represents an aryl group having 20 or less carbon atoms, which may have 1 to 6 substituents. Preferable examples of the substituent include an alkyl group having from 1 to 12 carbon atoms, an alkenyl group having from 2 to 12 carbon atoms, an alkynyl group having from 2 to 12 carbon atoms, an aryl group having from 6 to 18 carbon atoms, an alkoxy group having from 1 to 12 carbon atoms, an aryloxy group having from 6 to 18 carbon atoms, a halogen atom, an alkylamino group having from 1 to 12 carbon atoms, a dialkylimino group having from 2 to 12 carbon atoms, an alkylamido group having from 2 to 12 carbon atoms, an arylamido group having from 7 to 19 carbon atoms, a carbonyl group, a carboxyl group, a cyano group, a sulfonyl group, an thioalkyl group having from 1 to 12 carbon atoms and an thioaryl group having from 6 to 18 carbon atoms. Z₂₁⁻ represents a monovalent anion. Specific examples of the monovalent anion include a halogen ion, a perchlorate ion, a hexafluorophosphate ion, a tetrafluoroborate ion, a sulfonate ion, a sulfinate ion, a thosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity.

In the formula (RI-III), R₃₁, R₃₂ and R₃₃ each independently represents an aryl group having 20 or less carbon atoms, which may have 1 to 6 substituents, an alkyl group, an alkenyl group or an alkynyl group. Among them, an aryl group is preferred in view of reactivity and stability. Preferable examples of the substituent include an alkyl group having from 1 to 12 carbon atoms, an alkenyl group having from 2 to 12 carbon atoms, an alkynyl group having from 2 to 12 carbon atoms, an aryl group having from 6 to 18 carbon atoms, an alkoxy group having from 1 to 12 carbon atoms, an aryloxy group having from 6 to 18 carbon atoms, a halogen atom, an alkylamino group having from 1 to 12 carbon atoms, a dialkylimino group having from 2 to 12 carbon atoms, an alkylamido group having from 2 to 12 carbon atoms, an arylamido group having from 7 to 19 carbon atoms, a carbonyl group, a carboxyl group, a cyano group, a sulfonyl group, an thioalkyl group having from 1 to 12 carbon atoms and an thioaryl group having from 6 to 18 carbon atoms. Z₃₁⁻ represents a monovalent anion. Specific examples of the monovalent anion include a halogen ion, a perchlorate ion, a hexafluorophosphate ion, a tetrafluoroborate ion, a sulfonate ion, a sulfinate ion, a thosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity. Carboxylate ions described in JP-A-2001-343742 are more preferable, and carboxylate ions described in JP-A-2002-148790 are particularly preferable.

Specific examples of the onium salt are set forth below, but the invention should not be construed as being limited thereto.

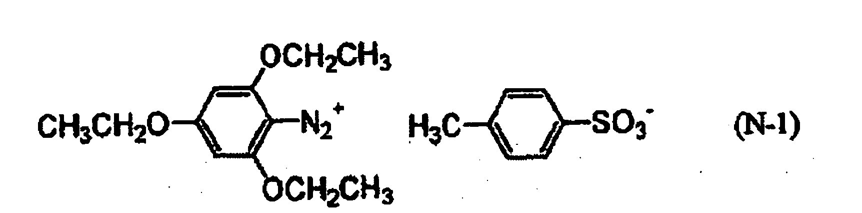

Pf₆⁻ (N-2)

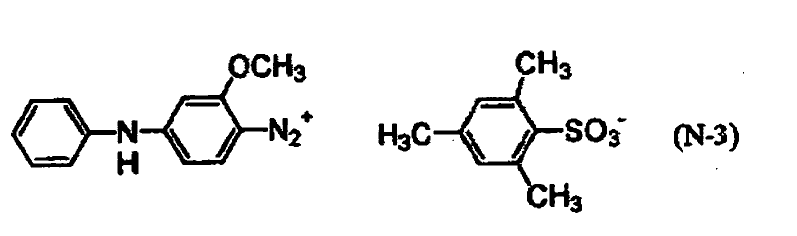

ClO₄⁻ (N-4)

PF₆⁻ (N-5)

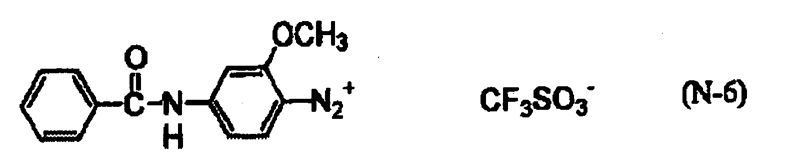

BF₄⁻ (N-7)

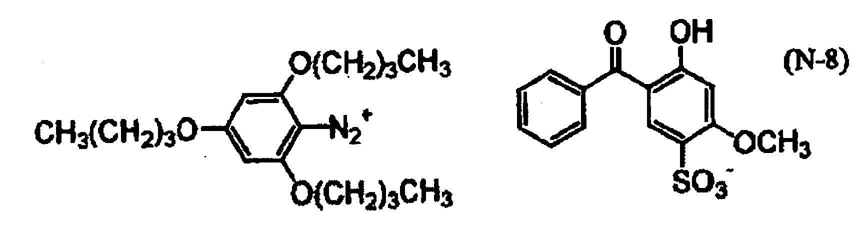

ClO₄⁻ (N-9)

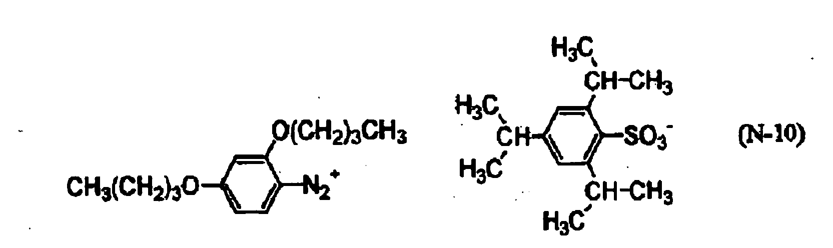

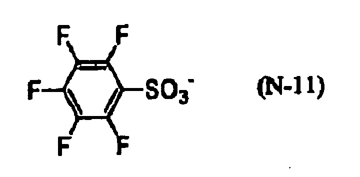

PF₈⁻ (N-12)

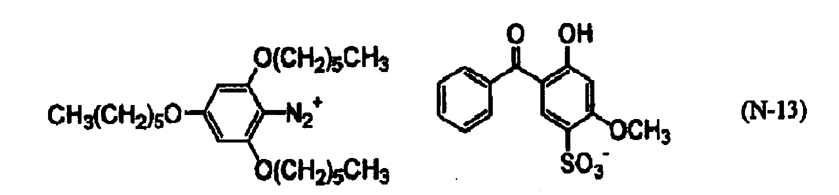

ClO₄⁻ (N-14)

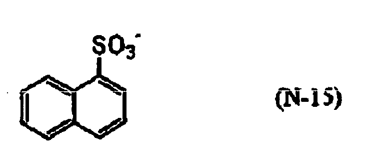

PF₆⁻ (N-16)

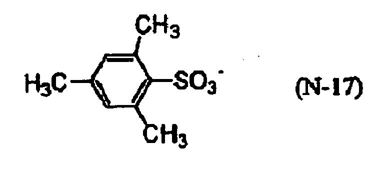

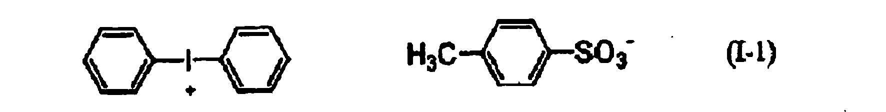

PF₆⁻ (I-2)

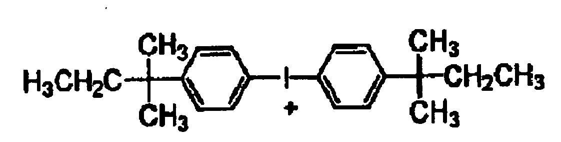

PF₆⁻ (I-3)

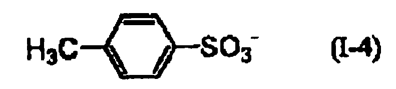

ClO⁻₄ (I-5)

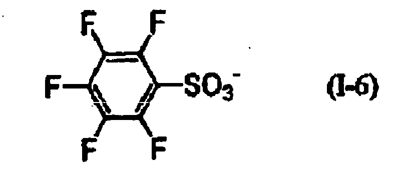

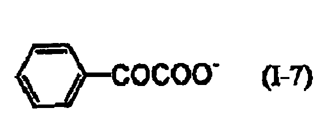

CF₃SO₃⁻ (I-8)

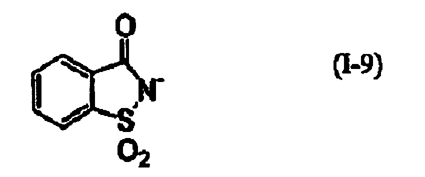

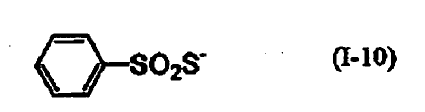

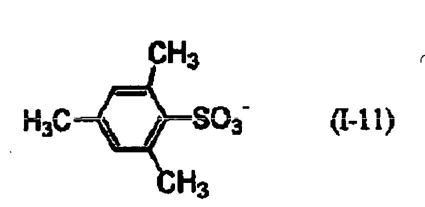

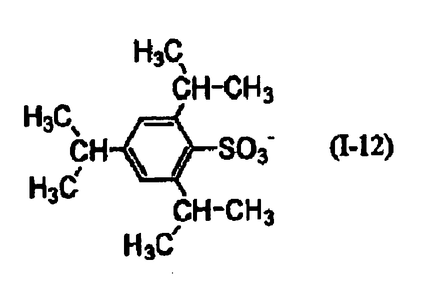

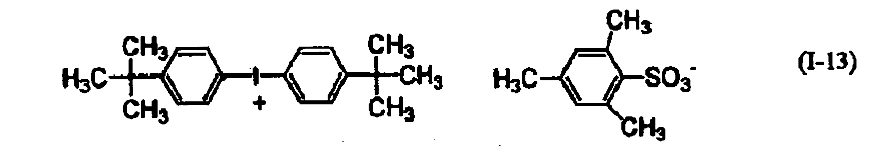

ClO₄⁻ (I-14)

PF₆⁻ (I-15)

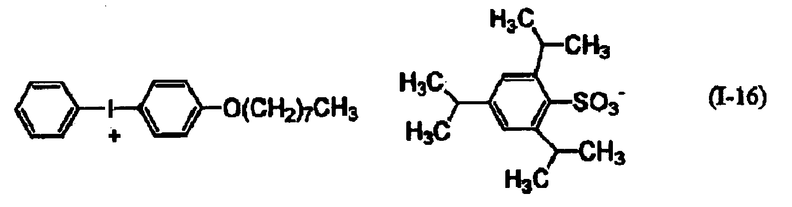

CF₃CCO⁻ (I-17)

CF₃SO₃⁻ (I-18)

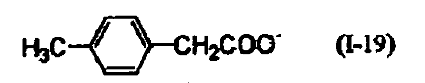

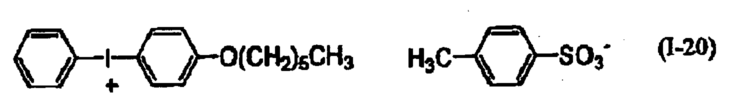

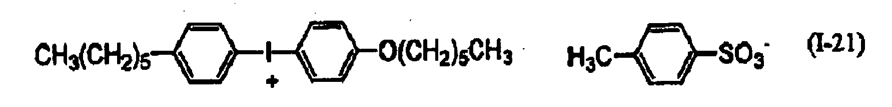

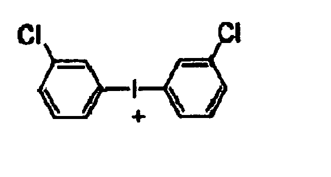

BF₄⁻ (I-22)

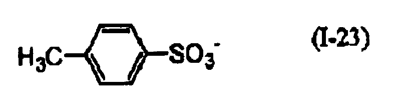

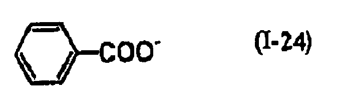

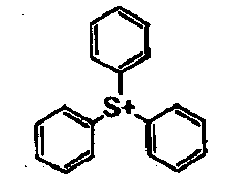

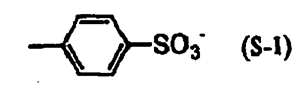

PF₆⁻ (S-2)

ClO₄⁻ (S-3)

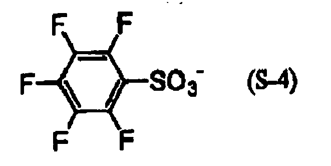

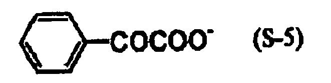

CF₃SO₃⁻ (S-6)

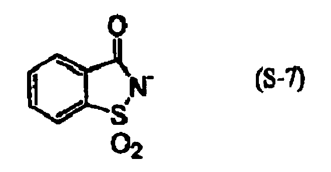

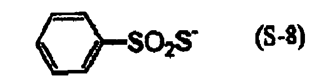

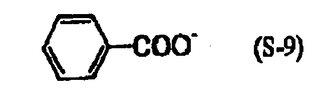

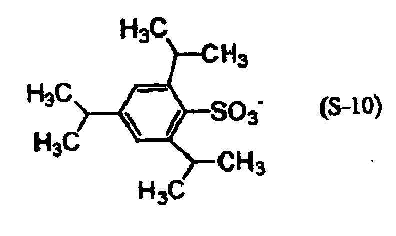

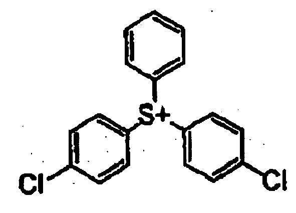

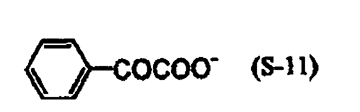

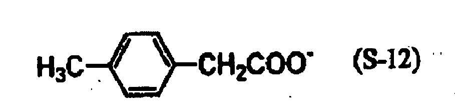

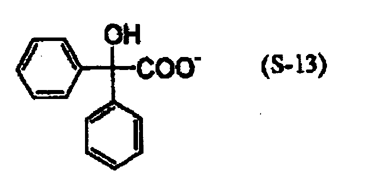

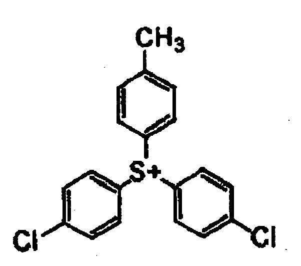

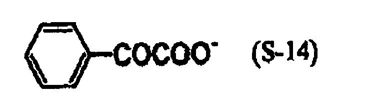

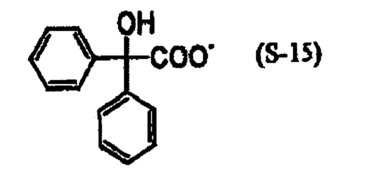

BF₄⁻ (S-16)

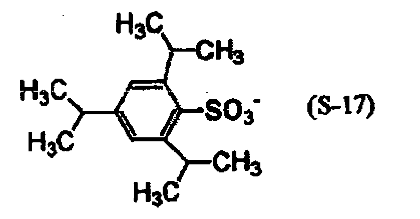

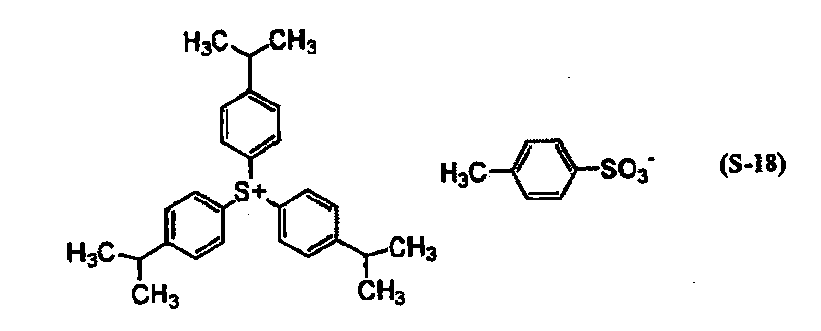

The polymerization initiator is not limited to those described above. In particular, the triazine type initiators, organic halogen compounds, oxime ester compounds, diazonium salts, iodonium salts and sulfonium salts are more preferable from the standpoint of reactivity and stability

The polymerization initiators may be used individually or in combination of two or more thereof. Further, the polymerization initiator may be added together with other components to one layer or may be added to a different layer separately provided. The polymerization initiator can be added preferably in an amount from 0.1 to 50% by weight, more preferably from 0.5 to 30% by weight, particularly preferably from 0.8 to 20% by weight, based on the total solid content of the photosensitive layer.

### <Chain transfer agent>

It is preferred to incorporate a chain transfer agent into the photosensitive layer according to the invention. The chain transfer agent contributes to improvements in the sensitivity and preservation stability. Compounds which function as the chain transfer agents include, for example, compounds containing SH, PH, SiH or GeH in their molecules. Such a compound donates hydrogen to a radical species of low activity to generate a radical, or is oxidized and then deprotonated to generate a radical.

In the photosensitive layer according to the invention, a thiol compound (for example, a 2-mercaptobenzimidazole) is particularly preferably used as the chain transfer agent.

Among them, a thiol compound represented by formula (III) shown below is particularly preferably used. By using the thiol compound represented by formula (III) as the chain transfer agent, a problem of the odor and decrease in sensitivity due to evaporation of the compound from the photosensitive layer or diffusion thereof into other layers are avoided and a lithographic printing plate precursor which is excellent in preservation stability and exhibits high sensitivity and good printing durability is obtained.

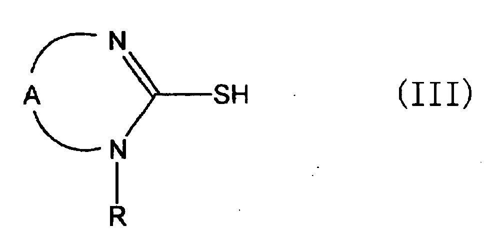

In formula (III), R represents an alkyl group which may have a substituent or an aryl group which may have a substituent; and A represents an atomic group necessary for forming a 5-membered or 6-membered hetero ring containing a carbon atom together with the N=C-N linkage, and A may have a substituent.

Compounds represented by formulae (III-1) and (III-2) shown below are more preferably used.

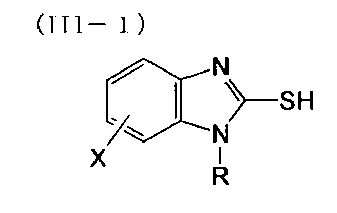

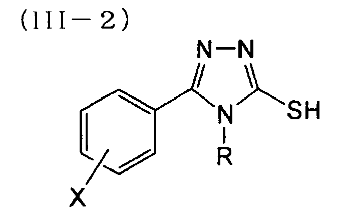

In formulae (III-1) and (III-2), R represents an alkyl group which may have a substituent or an aryl group which may have a substituent; and X represents a halogen atom, an alkoxy group which may have a substituent, an alkyl group which may have a substituent or an aryl group which may have a substituent.

Specific examples of the compound represented by formula (III) are set forth below, but the invention should not be construed as being limited thereto.

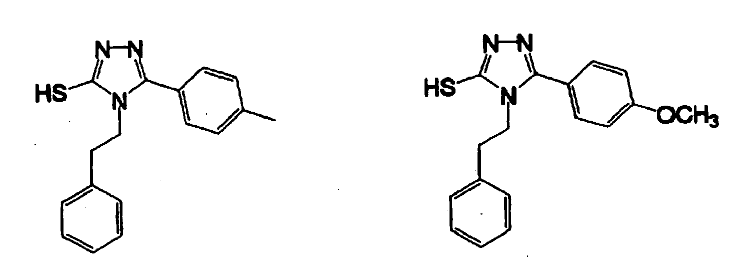

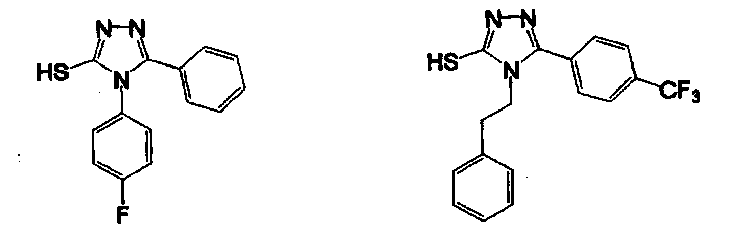

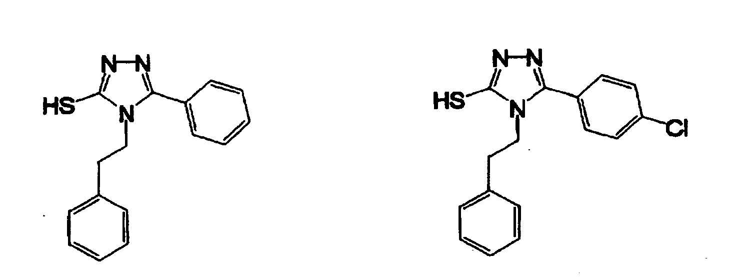

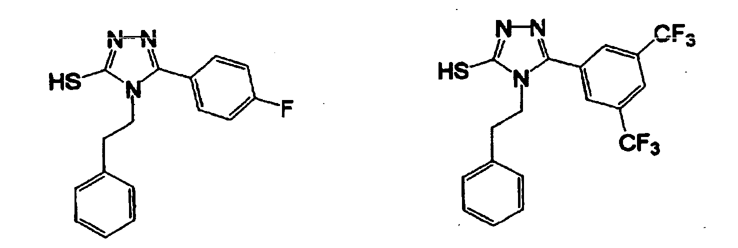

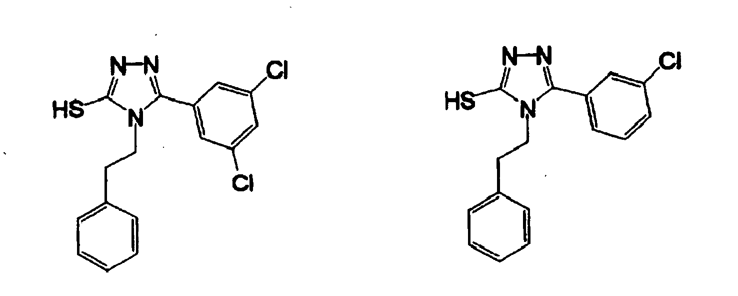

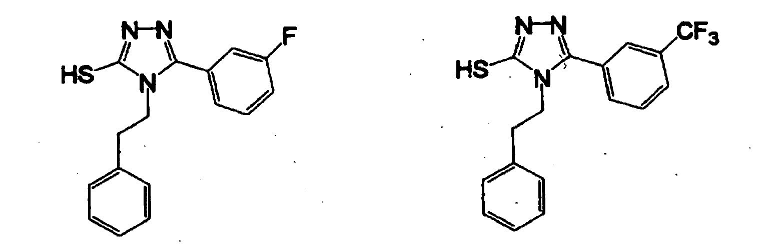

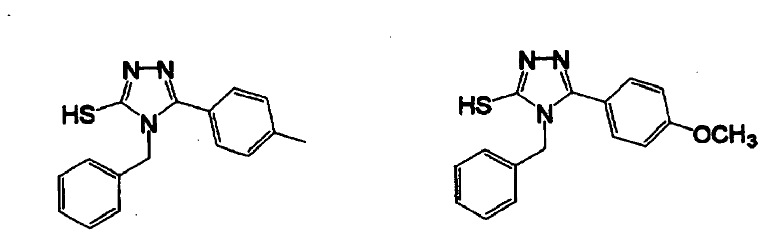

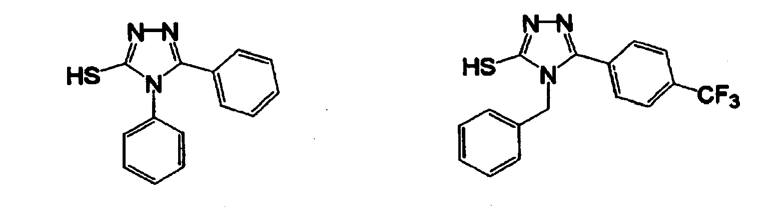

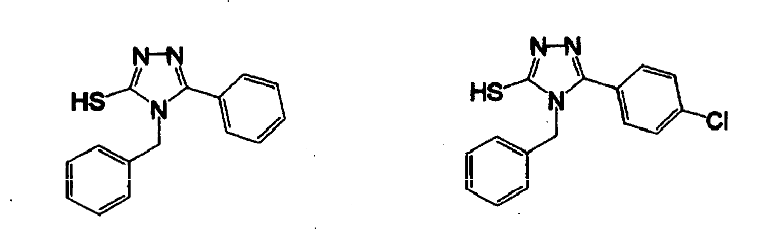

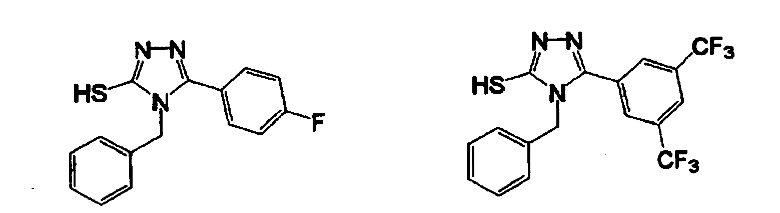

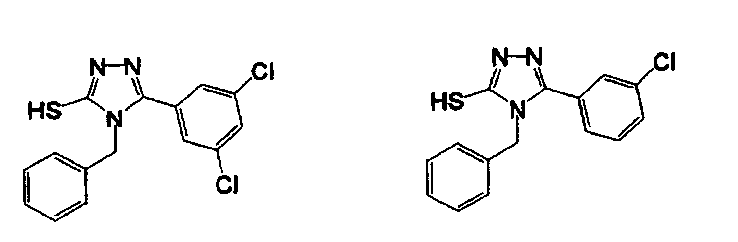

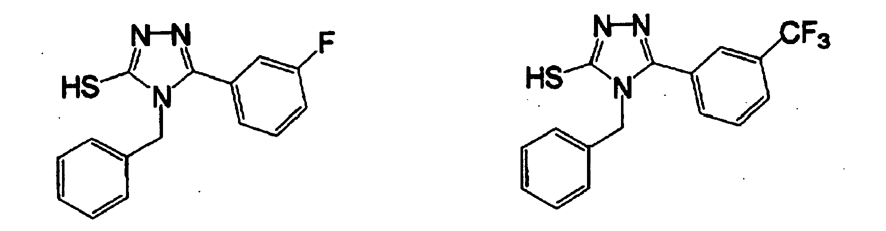

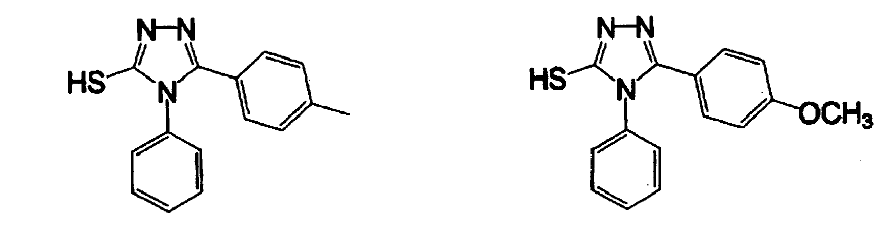

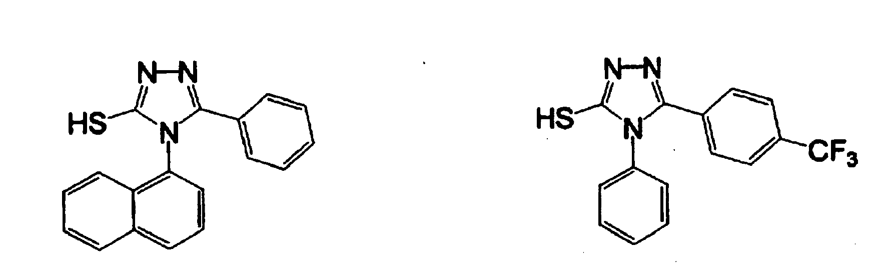

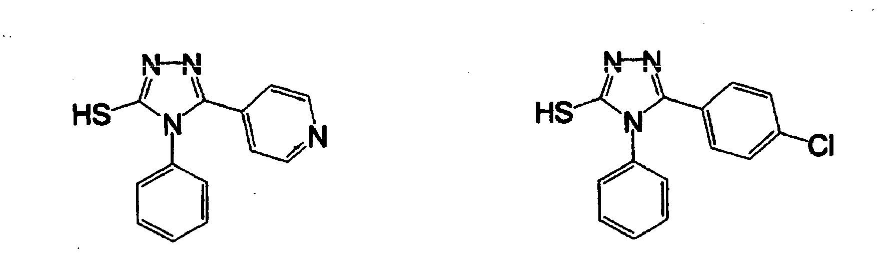

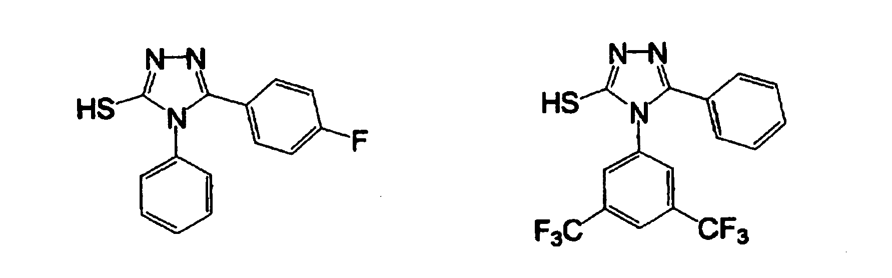

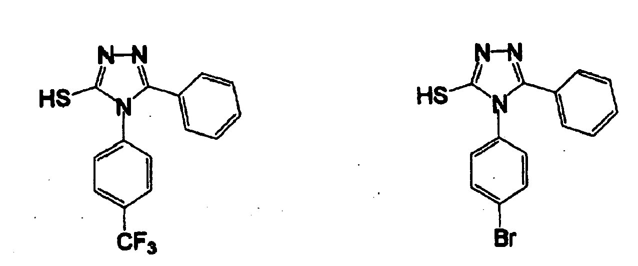

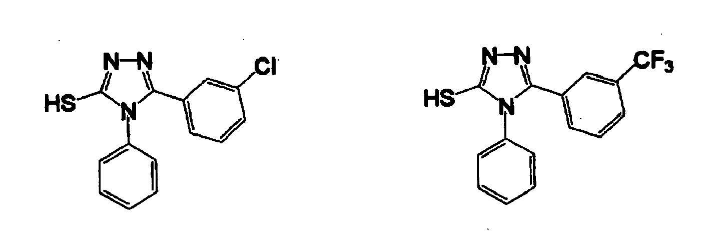

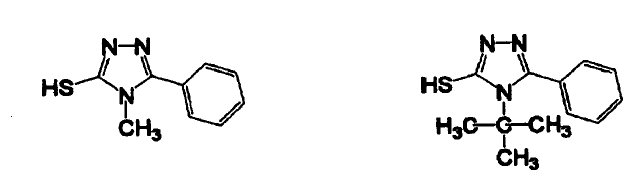

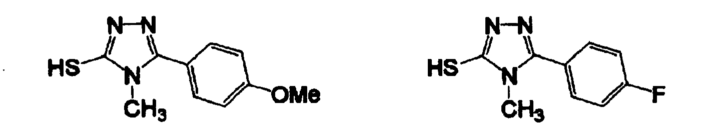

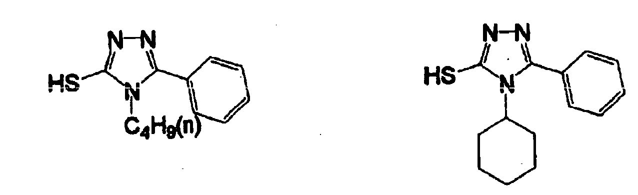

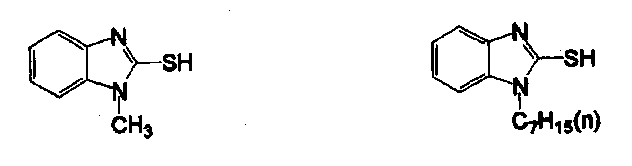

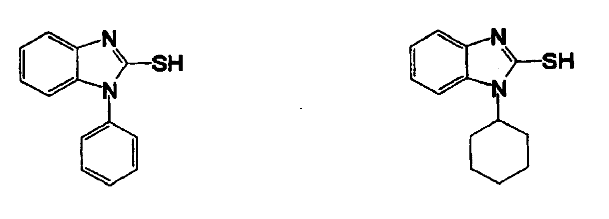

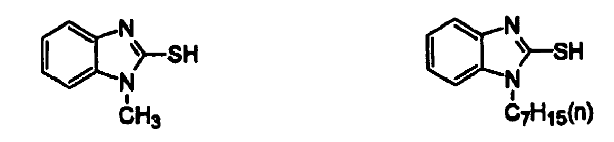

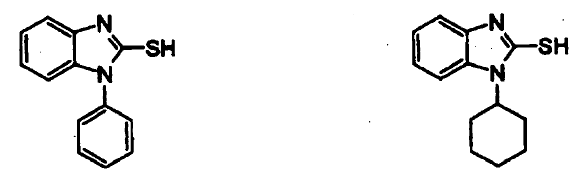

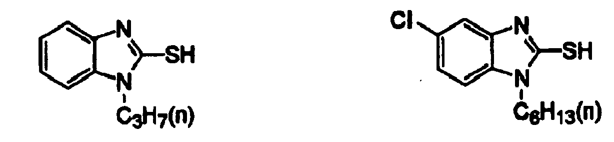

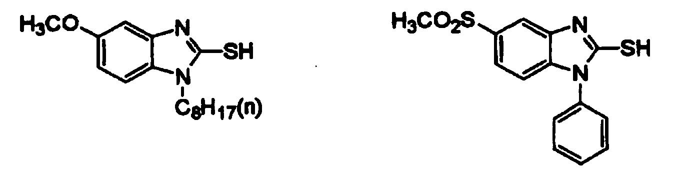

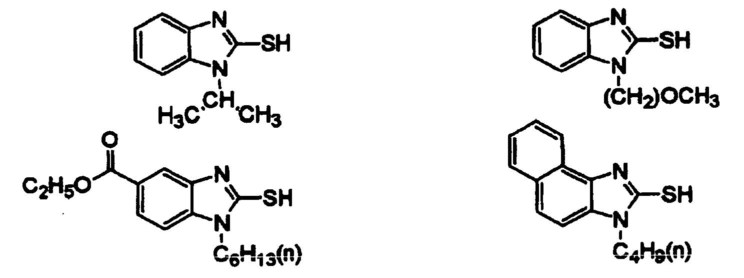

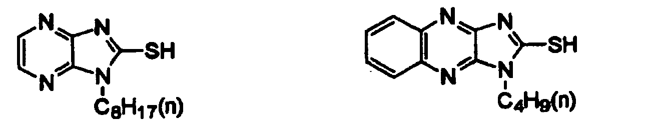

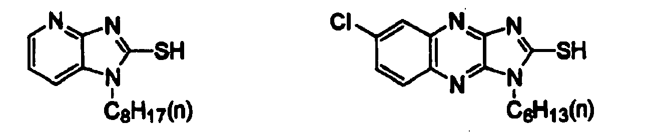

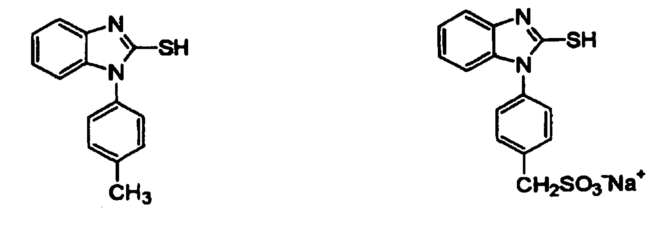

An amount of the chain transfer agent (for example, the thiol compound) used is preferably from 0.01 to 20% by weight, more preferably from 0.1 to 15% by weight, and still more preferably from 1.0 to 10% by weight, based on the total solid content of the photosensitive layer.

### (Microcapsule)

In the invention, in order to incorporate the above-described constituting components of the photosensitive layer and other constituting components described hereinafter into the photosensitive layer, a part of the constituting components is encapsulated into microcapsules and added to the photosensitive layer as described, for example, in JP-A-2001-277740 and JP-A-2001-277742. In such a case, each constituting component may be present inside or outside the microcapsule in an appropriate ratio.

As a method of microencapsulating the constituting components of the photosensitive layer, known methods can be used. Methods for the production of microcapsules include, for example, a method of utilizing coacervation described in U.S. Patents 2,800,457 and 2,800,458, a method of using interfacial polymerization described in U.S. Patent 3,287,154, JP-B-38-19574 and JP-B-42-446, a method of using deposition of polymer described in U.S. Patents 3,418,250 and 3,660,304, a method of using an isocyanate polyol wall material described in U.S. Patent 3,796,669, a method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U.S. Patent 4,025,445, an in-situ method by polymerization of monomer described in JP-B-36-9163 and JP-B-51-9079, a spray drying method described in British Patent 930,422 and U.S. Patent 3,111,407, and an electrolytic dispersion cooling method described in British Patents 952,807 and 967,074, but the invention should not be construed as being limited thereto.

A preferable microcapsule wall used in the invention has three-dimensional crosslinking and has a solvent-swellable property. From this point of view, a preferable wall material of the microcapsule includes polyurea, polyurethane, polyester, polycarbonate, polyamide and a mixture thereof, and particularly polyurea and polyurethane are preferred. Further, a compound having a crosslinkable functional group, for example, an ethylenically unsaturated bond, capable of being introduced into the hydrophobic binder polymer described above may be introduced into the microcapsule wall.

An average particle size of the microcapsule is preferably from 0.01 to 3.0 µm, more preferably from 0.05 to 2.0 µm, and particularly preferably from 0.10 to 1.0 µm. In the above-described range, preferable resolution and good preservation stability can be achieved.

### <Other constituting components of photosensitive layer>

Into the photosensitive layer according to the invention, various additives can further be incorporated, if desired. Such additives are described in detail below.

### <Surfactant>

In the invention, it is preferred to use a surfactant in the photosensitive layer in order to progress the developing property and to improve the state of surface coated. The surfactant includes, for example, a nonionic surfactant, an anionic surfactant, a cationic surfactant, an amphoteric surfactant and a fluorine-based surfactant. The surfactants may be used individually or in combination of two or more thereof.

The nonionic surfactant used in the invention is not particular restricted, and nonionic surfactants hitherto known can be used. Examples of the nonionic surfactant include polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxyethylene alkylamines, triethanolamine fatty acid esters, trialylamine oxides, polyethylene glycols, and copolymers of polyethylene glycol and polypropylene glycol.

The anionic surfactant used in the invention is not particularly restricted and anionic surfactants hitherto known can be used. Examples of the anionic surfactant include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styrylphenyl ether sulfate ester salts, alkyl phosphate ester salts, polyoxyethylene alkyl ether phosphate ester salts, polyoxyethylene alkyl phenyl ether phosphate ester salts, partial saponification products of styrene/maleic anhydride copolymer, partial saponification products of olefin/maleic anhydride copolymer and naphthalene sulfonate formalin condensates.

The cationic surfactant used in the invention is not particularly restricted and cationic surfactants hitherto known can be used. Examples of the cationic surfactant include alkylamine salts, quaternary ammonium salts, polyoxyethylene alkyl amine salts and polyethylene polyamine derivatives.

The amphoteric surfactant used in the invention is not particularly restricted and amphoteric surfactants hitherto known can be used. Examples of the amphoteric surfactant include carboxybetaines, aminocarboxylic acids, sulfobetaines, aminosulfuric esters and imidazolines.

In the surfactants described above, the term "polyoxyethylene" can be replaced with "polyoxyalkylene", for example, polyoxymethylene, polyoxypropylene or polyoxybutylene, and such surfactants can also be used in the invention.

Further, a preferred surfactant includes a fluorine-based surfactant containing a perfluoroalkyl group in its molecule. Examples of the fluorine-based surfactant include an anionic type, for example, perfluoroalkyl carboxylates, perfluoroalkyl sulfonates or perfluoroalkylphosphates; an amphoteric type, for example, perfluoroalkyl betaines; a cationic type, for example, perfluoroalkyl trimethyl ammonium salts; and a nonionic type, for example, perfluoroalkyl amine oxides, perfluoroalkyl ethylene oxide adducts, oligomers having a perfluoroalkyl group and a hydrophilic group, oligomers having a perfluoroalkyl group and an oleophilic group, oligomers having a perfluoroalkyl group, a hydrophilic group and an oleophilic group or urethanes having a perfluoroalkyl group and an oleophilic group. Further, fluorine-based surfactants described in JP-A-62-170950, JP-A-62-226143 and JP-A-60-168144 are also preferably exemplified.

The surfactants may be used individually or in combination of two or more thereof.

A content of the surfactant is preferably from 0.001 to 10% by weight, more preferably from 0.01 to 7% by weight, based on the total solid content of the photosensitive layer.

### <Coloring agent>

In the invention, a dye having large absorption in the visible light region can be used as a coloring agent for the image. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industry Co., Ltd.), Victoria Pure Blue, Crystal Violet (CI42555), Methyl Violet (CI42535), Ethyl Violet, Rhodamine B (CI45170B), Malachite Green (CI42000), Methylene Blue (CI52015), and dyes described in JP-A-62-293247. Also, a pigment, for example, phthalocyanine-based pigment, azo-based pigment, carbon black and titanium oxide can be preferably used.

It is preferable to add the coloring agent, because the image area and the non-image area after the image formation can be easily distinguished. The amount of the coloring agent added is preferably from 0.01 to 10% by weight based on the total solid content of the photosensitive layer.

### <Polymerization inhibitor>

In the photosensitive layer according to the invention, a small amount of a thermal polymerization inhibitor is preferably added in order to prevent the radical polymerizable compound from undergoing undesirable thermal polymerization during the preparation or preservation of the photosensitive layer.

Preferable examples of the thermal polymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol) and N-nitroso-N-phenylhydroxylamine aluminum salt.

The amount of the thermal polymerization inhibitor added is preferably from about 0.01 to about 5% by weight based on the total solid content of the photosensitive layer.

### <Higher fatty acid derivative>

In the photosensitive layer according to the invention, for example, a higher fatty acid derivative, e.g., behenic acid or behenic acid amide may be added and localized on the surface of the photosensitive layer during the process of drying after coating in order to avoid polymerization inhibition due to oxygen. The amount of the higher fatty acid derivative added is preferably from about 0.1 to about 10% by weight based on the total solid content of the photosensitive layer.

### <Plasticizer>

The photosensitive layer according to the invention may contain a plasticizer. Preferable examples of the plasticizer include a phthalic acid ester, for example, dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate or diallyl phthalate; a glycol ester, for example, dimethyl glycol phthalate, ethyl phthalylethyl glycolate, methyl phthalylethyl glycolate, butyl phthalylbutyl glycolate or triethylene glycol dicaprylic acid ester; a phosphoric acid ester, for example, tricresyl phosphate or triphenyl phosphate; an aliphatic dibasic acid ester, for example, diisobutyl adipate, dioctyl adipate, dimethyl sebacate, dibutyl sebacate, dioctyl azelate or dibutyl maleate; polyglycidyl methacrylate, triethyl citrate, glycerin triacetyl ester and butyl laurate. The content of the plasticizer is preferably about 30% by weight or less based on the total solid content of the photosensitive layer.

### <Fine inorganic particle>

The photosensitive layer according to the invention may contain fine inorganic particle in order to increase strength of the hardened layer in the image area. The fine inorganic particle preferably includes, for example, silica, alumina, magnesium oxide, titanium oxide, magnesium carbonate, calcium alginate and a mixture thereof. Even if the fine inorganic particle has no light to heat converting property, it can be used, for example, for strengthening the layer or enhancing interface adhesion property due to surface roughening. The fine inorganic particle preferably has an average particle size from 5 nm to 10 µm and more preferably from 0.5 to 3µm. In the above-described range, it is stably dispersed in the photosensitive layer, sufficiently maintains the film strength of the photosensitive layer and can form the non-image area excellent in hydrophilicity and preventing from stain at the printing.

The fine inorganic particle described above is easily available as a commercial product, for example, colloidal silica dispersion.

The content of the fine inorganic particle is preferably 20% by weight or less, and more preferably 10% by weight or less based on the total solid content of the photosensitive layer.

### <Hydrophilic low molecular weight compound>

The photosensitive layer according to the invention may contain a hydrophilic low molecular weight compound in order to improve the developing property. The hydrophilic low molecular weight compound includes a water-soluble organic compound, for example, a glycol compound, e.g., ethylene glycol, diethylene glycol, triethylene glycol, propylene glycol, dipropylene glycol or tripropylene glycol, or an ether or ester derivative thereof, a polyhydroxy compound, e.g., glycerine or pentaerythritol, an organic amine, e.g., triethanol amine, diethanol amine or monoethanol amine, or a salt thereof, an organic sulfonic acid, e.g., toluene sulfonic acid or benzene sulfonic acid, or a salt thereof, an organic phosphonic acid, e.g., phenyl phosphonic acid, or a salt thereof, an organic carboxylic acid, e.g., tartaric acid, oxalic acid, citric acid, maleic acid, lactic acid, gluconic acid or an amino acid, or a salt thereof, and an organic quaternary ammonium salt, e.g., tetraethyl ammonium hydrochloride.

Into the photosensitive layer according to the invention, in addition to the components described above, for example, a co-sensitizer may be incorporated.

### <Formation of photosensitive layer>

The photosensitive layer according to the invention is formed by dispersing or dissolving each of the necessary constituting components described above to prepare a coating solution and coating the solution. The solvent used include, for example, ethylene dichloride, cyclohexanone, methyl ethyl ketone, methanol, ethanol, propanol, ethylene glycol monomethyl ether, 1-methoxy-2-propanol, 2-methxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water, but the invention should not be construed as being limited thereto. The solvents may be used individually or as a mixture. The solid concentration of the coating solution is preferably from 1 to 50% by weight.

The photosensitive layer according to the invention may also be formed by preparing plural coating solutions by dispersing or dissolving the same or different components described above into the same or different solvents and conducting repeatedly plural coating and drying.

The coating amount (solid content) of the photosensitive layer on the support after the coating and drying may be varied depending on the use, but ordinarily, it is preferably from 0.3 to 3.0 g/m². In the above-described range, the preferable sensitivity and good film property of the photosensitive layer can be obtained.

Various methods can be used for the coating. Examples of the method include bar coater coating, spin coating, spray coating, curtain coating, dip coating, air knife coating, blade coating and roll coating.

In the lithographic printing plate precursor according to the invention, an intermediate layer (also referred to as "undercoat layer") may be provided between the photosensitive layer and the support for the purpose of increasing the adhesion property therebetween and improving the stain resistance. Further, a protective layer (also referred to as "overcoat layer") is provided on the photosensitive layer. The protective layer prevents a low molecular weight compound, for example, oxygen or a basic substance present in the atmosphere, which inhibits the image-forming reaction initiated in the photosensitive layer upon the exposure, from permeating into the photosensitive layer, whereby the protective layer makes it possible to perform the exposure in the atmosphere.

### (Protective layer)

In the lithographic printing plate precursor according to the invention, a protective layer (oxygen-blocking layer) is preferably provided on the photosensitive layer in order to prevent diffusion and penetration of oxygen which inhibits the polymerization reaction at the time of exposure. The protective layer for use in the invention preferably has oxygen permeability (A) at 25°C under one atmosphere of 1.0 ≤ (A) ≤ 20 (ml/m²·day). When the oxygen permeability (A) is extremely lower than 1.0 (ml/m²·day), problems may occur in that an undesirable polymerization reaction arises during the production or preservation before image exposure and in that undesirable fog or spread of image line occurs at the image exposure. On the contrary, when the oxygen permeability (A) greatly exceeds 20 (ml/m²·day), decrease in sensitivity may be incurred. The oxygen permeability (A) is more preferably in a range of 1.5 ≤ (A) ≤ 12 (ml/m²·day), and still more preferably in a range of 2.0 **≤** (A) ≤ 10.0 (ml/m²·day). Besides the above described oxygen permeability, as for the characteristics required of the protective layer, it is desired that the protective layer does not substantially hinder the transmission of light for the exposure, is excellent in adhesion to the photosensitive layer, and can be easily removed during a development step after the exposure. Contrivances on the protective layer have been heretofore made and described in detail in U.S. Patent 3,458,311 and JP-B-55-49729.

As the material of the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in the fundamental characteristics, for example, oxygen-blocking property and removability of the protective layer by development.

Polyvinyl alcohol for use in the protective layer may be partially substituted with ester, ether or acetal as long as it contains unsubstituted vinyl alcohol units for achieving the necessary oxygen-blocking property and water solubility. Also, a part of polyvinyl alcohol may have other copolymer component. As specific examples of polyvinyl alcohol, those having a hydrolyzing rate of 71 to 100% and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferred embodiment, the content of polyvinyl alcohol in the protective layer is from 20 to 95% by weight, more preferably from 30 to 90% by weight.

Also, known modified polyvinyl alcohol can be preferably used. For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified.

As a component used as a mixture with polyvinyl alcohol, polyvinyl pyrrolidone or a modified product thereof is preferable from the viewpoint of the oxygen-blocking property and removability by development. The content thereof is ordinarily from 3.5 to 80% by weight, preferably from 10 to 60% by weight, and more preferably from 15 to 30% by weight, in the protective layer.

The components of the protective layer (selection of PVA and use of additives) and the coating amount are determined taking into consideration fogging property, adhesion property and scratch resistance besides the oxygen-blocking property and removability by development. In general, the higher the hydrolyzing rate of the PVA used (the higher the unsubstituted vinyl alcohol unit content in the protective layer) and the larger the layer thickness, the higher is the oxygen-blocking property, thus it is advantageous in the point of sensitivity. The molecular weight of the (co)polymer, for example, polyvinyl alcohol (PVA) is ordinarily from 2,000 to 10,000,000, and preferably from 20,000 to 3,000,000.

As other additive of the protective layer, glycerin, dipropylene glycol or the like can be added in an amount corresponding to several % by weight of the (co)polymer to provide flexibility. Further, an anionic surfactant, for example, sodium alkylsulfate or sodium alkylsulfonate; an amphoteric surfactant, for example, alkylaminocarboxylate and alkylaminodicarboxylate; or a nonionic surfactant, for example, polyoxyethylene alkyl phenyl ether can be added in an amount corresponding to several % by weight of the (co)polymer.

The adhesion property of the protective layer to the photosensitive layer and scratch resistance are also extremely important in view of handling of the printing plate precursor. Specifically, when a hydrophilic layer comprising a water-soluble polymer is laminated on a oleophilic photosensitive layer, layer peeling due to insufficient adhesion is liable to occur, and the peeled portion causes such a defect as failure in hardening of the photosensitive layer due to polymerization inhibition by oxygen. Various proposals have been made for improving the adhesion between the photosensitive layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on the photosensitive layer. Any of these known techniques can be applied to the protective layer according to the invention. Coating methods of the protective layer are described in detail, for example, in U.S. Patent 3,458,311 and JP-B-55-4929.

Further, it is also preferred to incorporate an inorganic stratiform compound into the protective layer of the lithographic printing plate precursor according to the invention for the purpose of improving the oxygen-blocking property and property for protecting the surface of photosensitive layer.

The inorganic stratiform compound used here is a particle having a thin tabular shape and includes, for instance, mica, for example, natural mica represented by the following formula: A (B, C)₂₋₅ D₄ O₁₀ (OH, F, O)₂, (wherein A represents any one of K, Na and Ca, B and C each represents any one of Fe (II), Fe(III), Mn, Al, Mg and V, and D represents Si or Al) or synthetic mica; talc represented by the following formula: 3MgO·4SiO·H₂O; teniolite; montmorillonite; saponite; hectolite; and zirconium phosphate.

Of the micas, examples of the natural mica include muscovite, paragonite, phlogopite, biotite and lepidolite. Examples of the synthetic mica include non-swellable mica, for example, fluorphlogopite KMg₃(AlSi₃O₁₀)F₂ or potassium tetrasilic mica KMg_{2.5}(S₁₄O₁₀)F₂, and swellable mica, for example, Na tetrasilic mica NaMg_{2.5}(Si₄O₁₀)F₂, Na or Li teniolite (Na, Li)Mg₂Li(Si₄O₁₀)F₂, or montmorillonite based Na or Li hectolite (Na, Li)_{1/8}Mg_{2/5}Li_{1/8}(Si₄O₁₀)F₂. Synthetic smectite is also useful.

Of the inorganic stratiform compounds, fluorine based swellable mica, which is a synthetic inorganic stratiform compound, is particularly useful in the invention. Specifically, the swellable synthetic mica and an swellable clay mineral, for example, montmorillonite, saponite, hectolite or bentonite have a stratiform structure comprising a unit crystal lattice layer having thickness of approximately 10 to 15 angstroms, and metallic atom substitution in the lattices thereof is remarkably large in comparison with other clay minerals. As a result, the lattice layer results in lack of positive charge and to compensate it, a cation, for example, Na⁺, Ca²⁺ or Mg²⁺, is adsorbed between the lattice layers. The cation existing between the lattice layers is referred to as an exchangeable cation and is exchangeable with various cations. In particular, in the case where the cation between the lattice layers is Li+ or Na⁺, because of a small ionic radius, a bond between the stratiform crystal lattices is week, and the inorganic stratiform compound greatly swells upon contact with water. When share is applied under such condition, the stratiform crystal lattices are easily cleaved to form a stable sol in water. The bentnite and swellable synthetic mica have strongly such tendency and are useful in the invention. Particularly, the swellable synthetic mica is preferably used.

With respect to the shape of the inorganic stratiform compound used in the invention, the thinner the thickness or the larger the plain size as long as smoothness of coated surface and transmission of actinic radiation are not damaged, the better from the standpoint of control of diffusion. Therefore, an aspect ratio of the inorganic stratiform compound is ordinarily 20 or more, preferably 100 or more, and particularly preferably 200 or more. The aspect ratio is a ratio of thickness to major axis of particle and can be determined, for example, from a projection drawing of particle by a microphotography. The larger the aspect ratio, the greater the effect obtained.

As for the particle size of the inorganic stratiform compound used in the invention, an average major axis is ordinarily from 0.3 to 20 µm, preferably from 0.5 to 10 µm, and particularly preferably from 1 to 5 µm. An average thickness of the particle is ordinarily 0.1 µm or less, preferably 0.05 µm or less, and particularly preferably 0.01 µm or less. For example, in the swellable synthetic mica that is the representative compound of the inorganic stratiform compounds, thickness is approximately from 1 to 50 nm and plain size is approximately from 1 to 20 µm.

When such an inorganic stratiform compound particle having a large aspect ratio is incorporated into the protective layer, strength of coated layer increases and penetration of oxygen or moisture can be effectively inhibited so that the protective layer can be prevented from deterioration due to deformation, and even when the lithographic printing plate precursor is preserved for a long period of time under a high humidity condition, it is prevented from decrease in the image-forming property thereof due to the change of humidity and exhibits excellent preservation stability.

The content of the inorganic stratiform compound in the protective layer is preferably from 5/1 to 1/00 in terms of weight ratio to the amount of binder used in the protective layer. When a plurality of inorganic stratiform compounds is used in combination, it is also preferred that the total amount of the inorganic stratiform compounds fulfills the above-described weight ratio.

An example of common dispersing method for the inorganic stratiform compound used in the protective layer is described below. Specifically, from 5 to 10 parts by weight of a swellable stratiform compound that is exemplified as a preferred inorganic stratiform compound is added to 100 parts by weight of water to adapt the compound to water and to be swollen, followed by dispersing using a dispersing machine. The dispersing machine used include, for example, a variety of mills conducting dispersion by directly applying mechanical power, a high-speed agitation type dispersing machine providing a large shear force and a dispersion machine providing ultrasonic energy of high intensity. Specific examples thereof include a ball mill, a sand a grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having a Polman whistle. A dispersion containing from 5 to 10% by weight of the inorganic stratiform compound thus prepared is highly viscous or gelled and exhibits extremely good preservation stability. In the formation of a coating solution for protective layer using the dispersion, it is preferred that the dispersion is diluted with water, sufficiently stirred and then mixed with a binder solution.

To the coating solution for protective layer can be added known additives, for example, a surfactant for improving coating property or a water-soluble plasticizer for improving physical property of coated layer in addition to the inorganic stratiform compound. Examples of the water-soluble plasticizer include propionamide, cyclohexanediol, glycerin or sorbitol. Also, a water-soluble (meth)acrylic polymer can be added. Further, to the coating solution may be added known additives for increasing adhesion to the photosensitive layer or for improving preservation stability of the coating solution.

The coating solution for protective layer thus-prepared is coated on the photosensitive layer provided on the support and then dried to form a protective layer. The coating solvent may be appropriately selected in view of the binder used, and when a water-soluble polymer is used, distilled water or purified water is preferably used as the solvent. A coating method of the protective layer is not particularly limited, and known methods, for example, methods described in U.S. Patent 3,458,311 and JP-B-55-49729 can be utilized. Specific examples of the coating method for the protective layer include a blade coating method, an air knife coating method, a gravure coating method, a roll coating method, a spray coating method, a dip coating method and a bar coating method.

A coating amount of the protective layer is preferably in a range from 0.05 to 10 g/m² in terms of the coating amount after drying. When the protective layer contains the inorganic stratiform compound, it is more preferably in a range from 0.1 to 0.5 g/m², and when the protective layer does not contain the inorganic stratiform compound, it is more preferably in a range from 0.5 to 5 g/m².

### [Support]

The support for use in the lithographic printing plate precursor according to the invention is not particularly restricted as long as it is a support having a hydrophilic surface (hydrophilic support) a dimensionally stable plate-like hydrophilic support. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetatebutyrate, cellulose nitrate, polyethylene terephthalate, polyethylene, polystyrene, polypropylene, polycarbonate or polyvinyl acetal film) and paper or a plastic film laminated or deposited with the metal described above. Preferable examples of the support include a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero elements and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Although a pure aluminum plate is preferred in the invention, since completely pure aluminum is difficult to be produced in view of the refining technique, the aluminum plate may slightly contain the hetero element. The composition is not specified for the aluminum plate and those materials known and used conventionally can be appropriately utilized.

The thickness of the support is preferably from 0.1 to 0.6 mm, more preferably from 0.15 to 0.4 mm, and still more preferably from 0.2 to 0.3 mm.

Prior to the use of aluminum plate, a surface treatment, for example, roughening treatment or anodizing treatment is preferably performed. The surface treatment facilitates improvement in the hydrophilic property and ensures adhesion between the photosensitive layer and the support. In advance of the roughening treatment of the aluminum plate, a degreasing treatment, for example, with a surfactant, an organic solvent or an aqueous alkaline solution is conducted for removing rolling oil on the surface thereof, if desired.

The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively).

As the method of the mechanical roughening treatment, a known method, for example, a ball grinding method, a brush grinding method, a blast grinding method or a buff grinding method can be used.

The electrochemical roughening treatment method includes, for example, a method of conducting it by passing alternating current or direct current in an electrolyte containing an acid, for example, hydrochloric acid or nitric acid. Also, a method of using a mixed acid described in JP-A-54-63902 can be used.

The aluminum plate after the roughening treatment is then subjected, if desired, to an alkali etching treatment using an aqueous solution, for example, of potassium hydroxide or sodium hydroxide and further subjected to a neutralizing treatment, and then subjected to an anodizing treatment in order to enhance the abrasion resistance, if desired.

As the electrolyte used for the anodizing treatment of the aluminum plate, various electrolytes capable of forming porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte.

Since the conditions of the anodizing treatment are varied depending on the electrolyte used, they cannot be defined generally. However, it is ordinarily preferred that electrolyte concentration in the solution is from 1 to 80% by weight, liquid temperature is from 5 to 70°C, current density is from 5 to 60 A/dm², voltage is from 1 to 100 V, and electrolysis time is from 10 seconds to 5 minutes. The amount of the anodized film formed is preferably from 1.0 to 5.0 g/m² and more preferably from 1.5 to 4.0 g/m². In the above-described range, good printing durability and favorable scratch resistance in the non-image area of lithographic printing plate can be achieved.

The aluminum plate subjected to the surface treatment and having the anodized film is used as it is as the support in the invention. However, in order to more improve adhesion to a layer provided thereon, hydrophilicity, resistance to stain, heat insulating property or the like, other treatment, for example, a treatment for enlarging micropores or a sealing treatment of micropores of the anodized film described in JP-A-2001-253181 and JP-A-2001-322365, or a surface hydrophilizing treatment by immersing in an aqueous solution containing a hydrophilic compound, may be appropriately conducted. Needless to say, the enlarging treatment and sealing treatment are not limited to those described in the above-described patents and any conventionally known method may be employed.

As the sealing treatment, as well as a sealing treatment with steam, a sealing treatment with an aqueous solution containing an inorganic fluorine compound, for example, fluorozirconic acid alone or sodium fluoride, a sealing treatment with steam having added thereto lithium chloride or a sealing treatment with hot water may be employed.

Among them, the sealing treatment with an aqueous solution containing an inorganic fluorine compound, the sealing treatment with water vapor and a sealing treatment with hot water are preferred.

The hydrophilizing treatment includes an alkali metal silicate method described in U.S. Patents 2,714,066, 3,181,461, 3,280,734 and 3,902,734. In the method, the support is subjected to an immersion treatment or an electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U.S. Patents 3,276,868, 4,153,461, and 4,689,272.

In the case of using a support having a surface of insufficient hydrophilicity, for example, a polyester film, in the invention, it is desirable to coat a hydrophilic layer thereon to make the surface sufficiently hydrophilic. Examples of the hydrophilic layer preferably includes a hydrophilic layer formed by coating a coating solution containing a colloid of oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer containing an organic hydrophilic matrix obtained by crosslinking or pseudo-crosslinking of an organic hydrophilic polymer described in JP-A-2002-79772, a hydrophilic layer containing an inorganic hydrophilic matrix obtained by sol-gel conversion comprising hydrolysis and condensation reaction of polyalkoxysilane and titanate, zirconate or aluminate, and a hydrophilic layer comprising an inorganic thin layer having a surface containing metal oxide. Among them, the hydrophilic layer formed by coating a coating solution containing a colloid of oxide or hydroxide of silicon is preferred.

Further, in the case of using, for example, a polyester film as the support in the invention, it is preferred to provide an antistatic layer on the hydrophilic layer side, opposite side to the hydrophilic layer or both sides. When the antistatic layer is provided between the support and the hydrophilic layer; it also contributes to improve the adhesion of the hydrophilic layer to the support. As the antistatic layer, a polymer layer having fine particles of metal oxide or a matting agent dispersed therein described in JP-A-2002-79772 can be used.

The support preferably has a center line average roughness of 0.10 to 1.2 µm. In the above-described range, good adhesion to the photosensitive layer, good printing durability, and good stain resistance can be achieved.

The color density of the support is preferably from 0.15 to 0.65 in terms of the reflection density value. In the above-described range, good image-forming property by preventing halation at the image exposure and good aptitude for plate inspection after development can be achieved.

### (Undercoat layer)

In the lithographic printing plate precursor for use in the lithographic printing method according to the invention, an undercoat layer can be provided between the photosensitive layer and the support, if desired. It is advantageous that in the case of infrared laser exposure, since the undercoat layer acts as a heat insulating layer, heat generated upon the exposure does not diffuse into the support and is efficiently utilized so that increase in sensitivity can be achieved. Further, the undercoat layer makes removal of the photosensitive layer from the support in the unexposed area easy so that the on-machine development property can be improved

As a compound for the undercoat layer, specifically, for example, a silane coupling agent having an addition-polymerizable ethylenic double bond reactive group described in JP-A-10-282679 and a phosphorus compound having an ethylenic double bond reactive group described in JP-A-2-304441 are preferably exemplified.

As the most preferable compound for undercoat layer, a polymer resin obtained by copolymerization of a monomer having an adsorbing group, a monomer having a hydrophilic group and a monomer having a crosslinkable group is exemplified.

The essential component in the polymer undercoat layer is an adsorbing group to the hydrophilic surface of the support. Whether the adsorptivity to the hydrophilic surface of the support is present or not can be judged, for example, by the following method.

Specifically, a test compound is dissolved in a solvent in which the test compound is easily soluble to prepare a coating solution, and the coating solution is coated and dried on a support so as to have the coating amount after drying of 30 mg/m². After thoroughly washing the support coated with the test compound using the solvent in which the test compound is easily soluble, the residual amount of the test compound that has not been removed by the washing is measured to calculate the adsorption amount to the support. For measurement of the residual amount, the amount of the residual test compound may be directly determined, or it may be calculated from the amount of the test compound dissolved in the washing solution. The determination for the compound can be performed, for example, by fluorescent X-ray measurement, reflection spectral absorbance measurement or liquid chromatography measurement. The compound having the adsorptivity to support means a compound that remains by 1 mg/m² or more even after conducting the washing treatment described above.

The adsorbing group to the hydrophilic surface of the support is a functional group capable of forming a chemical bond (for example, an ionic bond, a hydrogen bond, a coordinate bond or a bond with intermolecular force) with a substance (for example, metal or metal oxide) or a functional group (for example, a hydroxy group) present on the surface of the support. The adsorbing group is preferably an acid group or a cationic group.

The acid group preferably has an acid dissociation constant (pKa) of 7 or less. Examples of the acid group include a phenolic hydroxy group, a carboxyl group, -SO₃H, -OSO₃H, -PO₃H₂, -OPO₃H₂, -CONHSO₂-, -SO₂NHSO₂- and -COCH₂COCH₃. Among them, -OPO₃H₂ and -PO₃H₂ are particularly preferred. The acid group may be the form of a metal salt.

The cationic group is preferably an onium group. Examples of the onium group include an ammonium group, a phosphonium group, an arsonium group, a stibonium group, an oxonium group, a sulfonium group, a selenonium group, a stannonium group and iodonium group. Among them, the ammonium group, phosphonium group and sulfonium group are preferred, the ammonium group and phosphonium group are more preferred, and the ammonium group is most preferred.

Particularly preferable examples of the monomer having the adsorbing group include compounds represented by the following formula (VII) or (VIII):

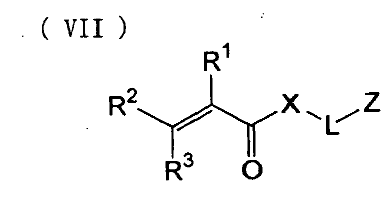

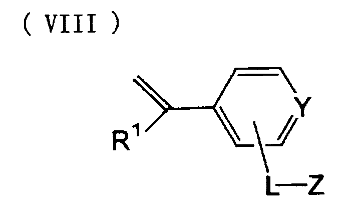

In formula (VII) or (VIII), R¹, R² and R³ each independently represents a hydrogen atom, halogen atom or an alkyl group having from 1 to 6 carbon atoms. R¹ and R² and R³ each independently represents preferably a hydrogen atom or an alkyl group having from 1 to 6 carbon atoms, more preferably a hydrogen atom or an alkyl group having from 1 to 3 carbon atoms, and most preferably a hydrogen atom or a methyl group. It is particularly preferred that R² and R³ each represents a hydrogen atom.

In the formula (VII), X represents an oxygen atom (-O-) or imino group (-NH-). Preferably, X represents an oxygen atom. In the formula (VII) or (VIII), L represents a divalent connecting group. It is preferred that L represents a divalent aliphatic group (for example, an alkylene group, a substituted alkylene group, an alkenylene group, a substituted alkenylene group, an alkinylene group or a substituted alkinylene group), a divalent aromatic group (for example, an arylene group or a substituted arylene group), a divalent heterocyclic group or a combination of each of the groups described above with an oxygen atom (-O-), a sulfur atom (-S-), an imino group (-NH-), a substituted imino group (-NR-, wherein R represents an aliphatic group, an aromatic group or a heterocyclic group) or a carbonyl group (-CO-).

The aliphatic group may form a cyclic structure or a branched structure. The number of carbon atoms of the aliphatic group is preferably from 1 to 20, more preferably from 1 to 15, and most preferably from 1 to 10. It is preferred that the aliphatic group is a saturated aliphatic group rather than an unsaturated aliphatic group. The aliphatic group may have a substituent. Examples of the substituent include a halogen atom, a hydroxy group, an aromatic group and a heterocyclic group.

The number of carbon atoms of the aromatic group is preferably from 6 to 20, more preferably from 6 to 15, and most preferably from 6 to 10. The aromatic group may have a substituent. Examples of the substituent include a halogen atom, a hydroxy group, an aliphatic group, an aromatic group and a heterocyclic group.

It is preferred that the heterocyclic group has a 5-membered or 6-membered ring as the hetero ring. Other heterocyclic ring, an aliphatic ring or an aromatic ring may be condensed to the heterocyclic ring. The heterocyclic group may have a substituent. Examples of the substituent include a halogen atom, a hydroxy group, an oxo group (=O), a thioxo group (=S), an imino group (=NH), a substituted imino group (=N-R, where R represents an aliphatic group, an aromatic group or a heterocyclic group), an aliphatic group, an aromatic group and a heterocyclic group.

It is preferred that L represents a divalent connecting group containing a plurality of polyoxyalkylene structures. It is more preferred that the polyoxyalkylene structure is a polyoxyethylene structure. Specifically, it is preferred that L contains -(OCH₂CH₂)ₙ- (n is an integer of 2 or more).

In the formula (VII) or (VIII), Z represents a functional group adsorbing to the hydrophilic surface of the support. In the formula (VIII), Y represents a carbon atom or a nitrogen atom. In the case where Y is a nitrogen atom and L is connected to Y to form a quaternary pyridinium group, Z is not mandatory, because the quaternary pyridinium group itself exhibits the adsorptivity. The adsorptive functional group is the same as that described above.

Representative examples of the monomer represented by formula (VII) or (VIII) are set forth below.

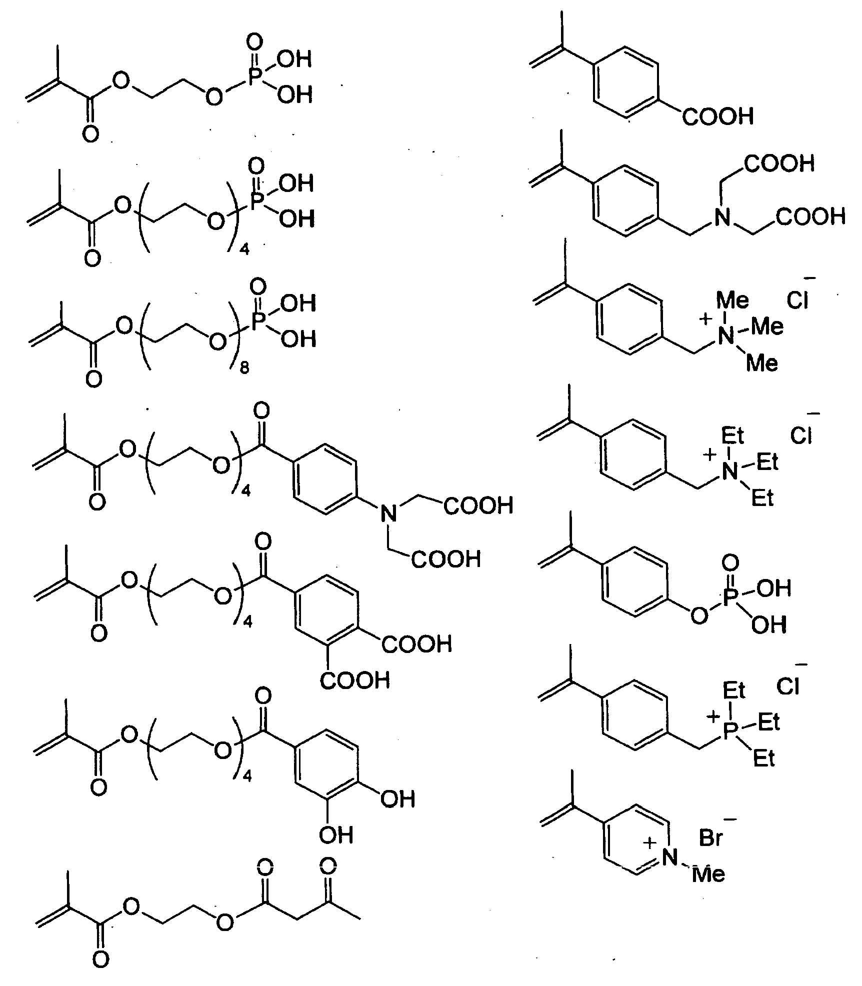

The hydrophilic group of the polymer resin for undercoat layer which can be used in the invention includes, for example, a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group; a carboxymethyl group, a sulfonic acid group and a phosphoric acid group. A monomer containing such a hydrophilic group and a polymerizable group is employed as a copolymerization component of the polymer resin for undercoat layer.

The polymer resin for undercoat layer which can be used in the invention preferably includes a crosslinkable group. By the crosslinkable group, increase in adhesion to the image area can be achieved. In order to impart the crosslinkable property to the polymer resin for the undercoat layer, introduction of a crosslinkable functional group, for example, an ethylenically unsaturated bond into the side chain of the polymer resin, or introduction by formation of a salt structure between a polar substituent of the polymer resin and a compound containing a substituent having a counter charge to the polar substituent of the polymer resin and an ethylenically unsaturated bond is carried out.

Examples of the polymer having an ethylenically unsaturated bond in the side chain thereof include a polymer of an ester or amide of acrylic acid or methacrylic acid, which is a polymer wherein the ester or amide residue (R in -COOR or -CONHR) has an ethylenically unsaturated bond.

Examples of the residue (R described above) having an ethylenically unsaturated bond include -(CH₂)ₙCR₁=CR₂R₃, -(CH₂O)ₙCH₂CR₁=CR₂R₃, -(CH₂CH₂O)ₙCH₂CR₁=CR₂R₃, -(CH₂)ₙNH-CO-O-CH₂CR₁=CCR₂R₃, -(CH₂)ₙ-O-CO-CR₁=CCR₂R₃ and -(CH₂CH₂O)₂-X (wherein R₁ to R₃ each independently represents a hydrogen atom, a halogen atom or an alkyl group having from 1 to 20 carbon atoms, an aryl group, alkoxy group or aryloxy group, or R₁ and R₂ or R₁ and R₃ may be combined with each other to form a ring. n represents an integer of 1 to 10. X represents a dicyclopentadienyl residue).

Specific examples of the ester residue include -CH₂CH=CH₂ (described in JP-B-7-21633) -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amide residue include -CH₂CH=CH₂, -CH₂CH₂O-Y (wherein Y represents a cyclohexene residue) and -CH₂CH₂-OCO-CH=CH₂.

As the monomer having a crosslinkable group for the polymer resin for the undercoat layer, an ester or amide of acrylic acid or methacrylic acid having the above-described crosslinkable group is preferable.

A content of the crosslinking group in the polymer resin for undercoat layer (content of the radical polymerizable unsaturated double bond determined by iodine titration) is preferably from 0.1 to 10.0 mmol; more preferably from 1.0 to 7.0 mmol, and most preferably from 2.0 to 5.5 mmol, based on 1 g of the polymer resin. In the above-described range, preferable compatibility between the sensitivity and stain resistance and good preservation stability can be achieved.

A weight average molecular weight of the polymer resin for undercoat layer is preferably 5,000 or more, more preferably from 10,000 to 300,000. A number average molecular weight of the polymer resin for undercoat layer is preferably 1,000 or more, more preferably from 2,000 to 250,000. The polydispersity (weight average molecular weight/number average molecular weight) thereof is preferably from 1.1 to 10.

The polymer resin for undercoat layer may be any of a random polymer, a block polymer and a graft polymer, and it is preferably a random polymer.

As the polymer resin for undercoat layer, known resins having a hydrophilic group can also be used. Specific examples of the resin include gum arabic, casein, gelatin, a starch derivative, carboxy methyl cellulose and a sodium salt thereof, cellulose acetate, sodium alginate, vinyl acetate-maleic acid copolymer, styrene-maleic acid copolymer, polyacrylic acid and a salt thereof, polymethacrylic acid and a salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, a polyethylene glycol, a hydroxypropylene polymer, a polyvinyl alcohol, a hydrolyzed polyvinyl acetate having a hydrolysis degree of 60% by mole or more, preferably 80% by mole or more, a polyvinyl formal, a polyvinyl butyral, a polyvinyl pyrrolidone, a homopolymer or copolymer of acrylamide, a homopolymer or polymer of methacrylamide, a homopolymer or copolymer of N-methylolacrylamide, a polyvinyl pyrrolidone, an alcohol-soluble nylon, a polyether of 2,2-bis-(4-hydroxyphenyl)propane and epichlorohydrin.

The polymer resins for undercoat layer may be used individually or as a mixture of two or more thereof.

A coating amount (solid content) of the undercoat layer is preferably from 0.1 to 100 mg/m², and more preferably from 1 to 30 mg/m².

### (Backcoat layer)

After applying the surface treatment to the support or forming the undercoat layer on the support, a backcoat layer can be provided on the back surface of the support, if desired.

The backcoat layer preferably includes, for example, a coating layer comprising an organic polymer compound described in JP-A-5-45885, and a coating layer comprising a metal oxide obtained by hydrolysis and polycondensation of an organic metal compound or an inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting material is inexpensive and easily available.

### <Plate-making method>

Now, the plate-making method (plate-making method according to the invention) of the lithographic printing plate precursor described above is described below.

According to the plate-making method of the lithographic printing plate precursor, a lithographic printing plate is obtained by exposing the lithographic printing plate precursor described above using an exposure apparatus equipped with a light source having an oscillation wavelength in a range of 360 to 450 nm and rubbing a surface of the exposed lithographic printing plate precursor with a rubbing member in the presence of a developer having pH of 2 to 10 in an automatic processor equipped with the rubbing member to remove the photosensitive layer in the unexposed area.

The exposure apparatus for use in the invention includes an exposure apparatus equipped with a light source having an emission maximum in a range of 360 to 450 nm, and particularly, a laser of 405 nm commercially available, for example, from Nichia Corp. is preferably employed.

The exposure apparatus for use in the invention may be any of an internal drum system, an external drum system and a flat bed system. Also, highly accurate images can be recorded at high speed by simultaneously recording the images using a multi-beam exposure system.

Further, at the exposure of the lithographic printing plate precursor according to the invention, the image recording can be performed using an FM screen.

According to the invention, the entire surface of the exposed lithographic printing plate precursor may be heated, if desired, between the exposure and the development. By the heating, the image-forming reaction in the photosensitive layer is accelerated and thus advantages, for example, improvement in the sensitivity and printing durability and stabilization of the sensitivity are achieved. When the protective layer is provided on the photosensitive layer, it is also preferred to conduct a water washing treatment before the development processing.

### [Development]

After the imagewise exposure of the lithographic printing plate precursor according to the invention, the surface of the exposed lithographic printing plate precursor is rubbed with a rubbing member in the presence of a developer having pH of 2 to 10 to remove the photosensitive layer thereof in the unexposed area (also a protective layer, when the protective layer is provided) so that the image can be formed on the surface of aluminum plate support.

The developer for use in the invention is an aqueous solution having pH of 2 to 10. For instance, the developer is preferably water alone or an aqueous solution containing water as a main component (containing 60% by weight or more of water). Particularly, an aqueous solution having the same composition as conventionally known dampening water, an aqueous solution containing a surfactant (for example, an anionic, nonionic or cationic surfactant) and an aqueous solution containing a water-soluble polymer compound are preferable. An aqueous solution containing both a surfactant and a water-soluble polymer compound is especially preferable. The pH of the developer is preferably from 3 to 8, and more preferably from 4 to 7.

The concentration of the surfactant in the developer is preferably 1% by weight or more, more preferably 2% by weight or more, and still more preferably from 5 to 20% by weight or more.

The anionic surfactant for use in the developer according to the invention includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, dialkylsulfosuccinic acid salts, alkyl sulfate ester salts and alkylnaphthalenesulfonic acid salts are particularly preferably used.

The cationic surfactant for use in the developer according to the invention is not particularly limited and conventionally known cationic surfactants can be used. Examples of the cationic surfactant include alkylamine salts, quaternary ammonium salts, polyoxyethylene alkyl amine salts and polyethylene polyamine derivatives.

The nonionic surfactant for use in the developer according to the invention includes, for example, polyethylene glycol type higher alcohol ethylene oxide addacts, alkylphenol ethylene oxide addacts, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines.

The nonionic surfactants may be used individually or as a mixture of two or more thereof. In the invention, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferable.

Further, from the standpoint of stable solubility in water or opacity, with respect to the nonionic surfactant used in the developer according to the invention, the HLB (hydrophile-lipophile balance) value thereof is preferably 6 or more, and more preferably 8 or more. Moreover, an amount of the nonionic surfactant contained in the developer is preferably from 0.01 to 10% by weight, and more preferably from 0.01 to 5% by weight.

Furthermore, an oxyethylene adduct of acetylene glycol type or acetylene alcohol type or a surfactant, for example, a fluorine-based surfactant or a silicon-based surfactant can also be used.

Of the surfactants used in the developer according to the invention, the nonionic surfactant is particularly preferred in view of foam depressing property.

Of the surfactants for use in the developer according to the invention, as the anionic surfactants, compounds represented by any one of formulae (1-III) to (1-VI) shown below are particularly preferable and as the nonionic or cationic surfactants containing a nitrogen atom, compounds represented by any one of formulae (1-VII) to (1-IX) shown below are particularly preferable.

The surfactants represented by any one of formulae (I-III) to (1-XI) shown below can be synthesized according to known methods. The molecular weight of the surfactant is ordinarily 2,000 or less, preferably from 100 to 1,500.

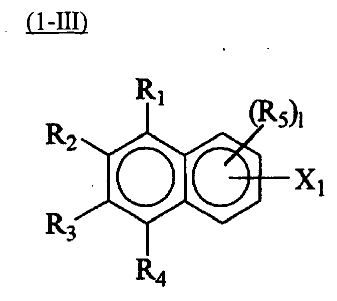

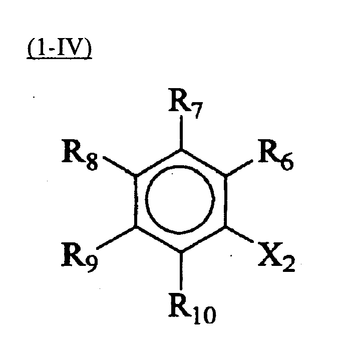

In formulae, R₁ to R₁₀ each represents a hydrogen atom or an alkyl group; 1 represents an integer of 1 to 3; X₁ and X₂ each represents a sulfonate, a sulfuric monoester salt, a carboxylate or a phosphate; and provided that a total number of carbon atoms included in R₁ to R₅ or R₆ to R₁₀ is 3 or more.

In the compound represented by formula (I-III), when the total number of carbon atoms included in R₁ to R₅ is 3 or more, the effect can be recognized. However, as the total number of carbon atoms included in R₁ to R₅ increases, the hydrophobic portion becomes large and dissolution of the compound in an aqueous developer becomes difficult. In such a case, the surfactant can not be dissolved in a proper mixing range even when a dissolution auxiliary agent for assisting the dissolution, for example, an organic solvent is mixed with water. Ordinarily, the total number of carbon atoms included in R₁ to R₅ is 24 or less. The total number of carbon atoms included in R₁ to R₅ is preferably from 3 to 20. When R₁ to R₅ represent one or more alkyl groups, each of the alkyl groups may be a straight-chain or branched structure.

The total number of carbon atoms included in R₁ to R₅ of the compound (surfactant) is influenced by a material, especially, a binder, used in the photosensitive layer. When a binder having high hydrophilicity is used, the total number of carbon atoms included in R₁ to R₅ may be relatively small. On the other hand, when a binder having low hydrophilicity is used, it is necessary that the total number of carbon atoms included in R₁ to R₅ is large.

In the above-described compound, X₁ represents a sulfonate, a sulfuric monoester salt, a carboxylate or a phosphate. Among them, the sulfonate and carboxylate have the large effect. In the salts, an alkali metal salt is preferable, since it has excellent solubility in an aqueous solvent. Among them, a sodium salt or a potassium salt is particularly preferable.

The compound will be described more specifically below.

Specific examples of the compound wherein the alkyl groups represented by R₁ to R₅ do not contain an oxygen atom are set forth below.

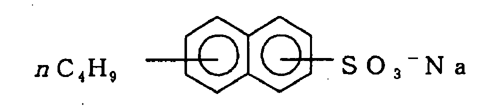

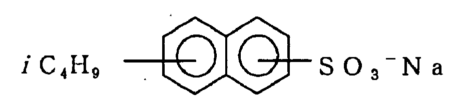

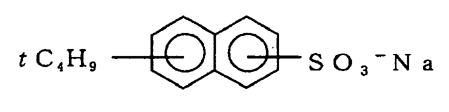

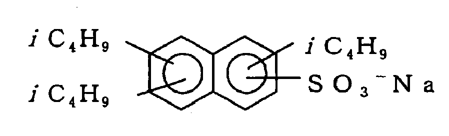

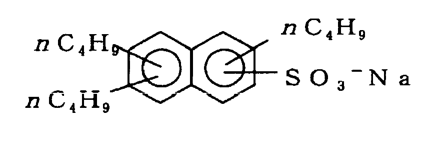

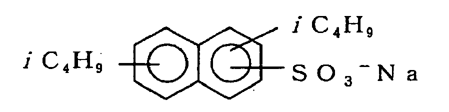

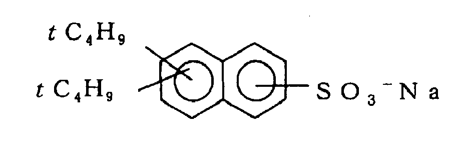

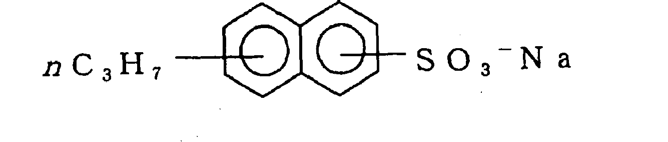

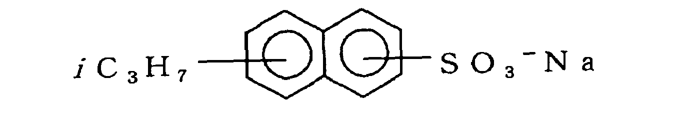

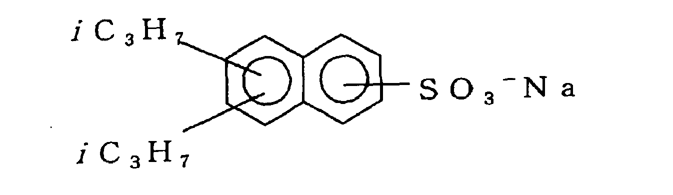

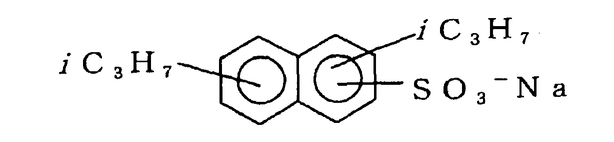

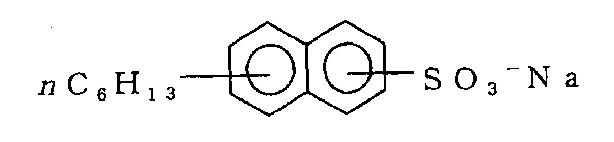

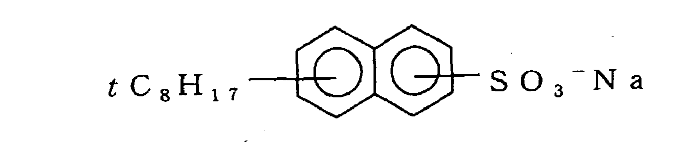

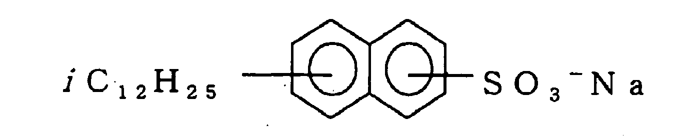

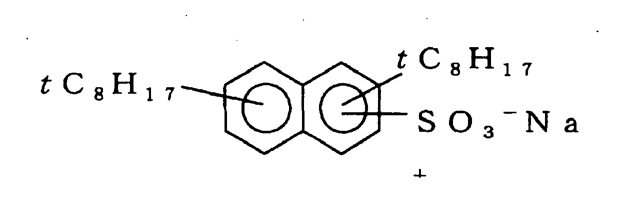

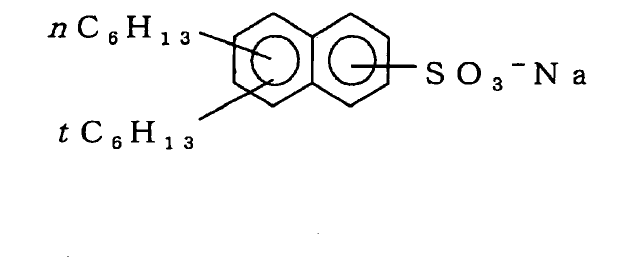

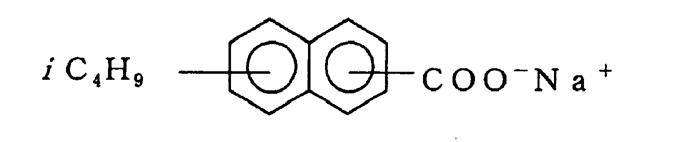

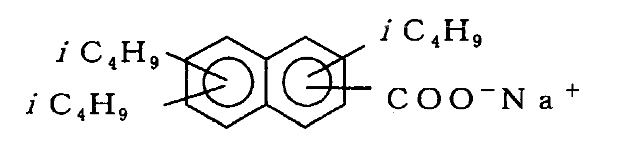

Specific examples of the compound represented by formula (1-III) wherein at least one of R₁ to R₅ represents an alkyl group containing an oxygen atom, that is, -CₘH₂ₘOCₙ₋ₘH₂₍ₙ₋ₘ₎₊₁ (n ≥ 2, n ≥ m ≥ 0) are set forth below.

The substituents other than the -CₘH₂ₘOCₙ₋ₘH₂₍ₙ₋ₘ₎₊₁ are hydrogen atoms or alkyl groups, and the total number of carbon atoms included in R₁ to R₅ is 3 to 24. These compounds are easily soluble in the aqueous solvent by the introduction of oxygen atom and they are preferably used in the developer in many cases.

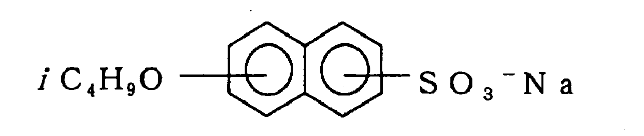

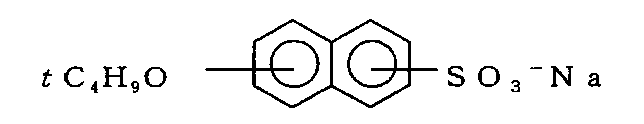

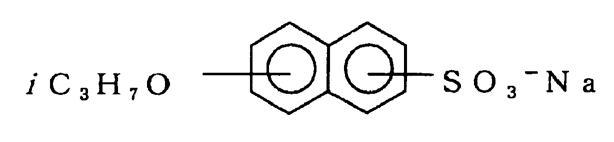

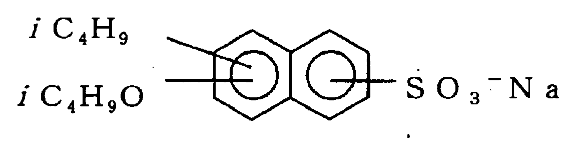

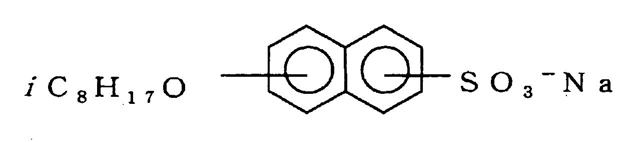

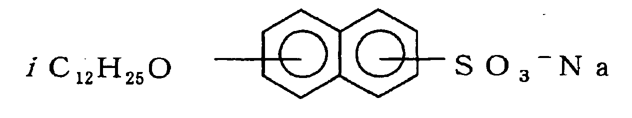

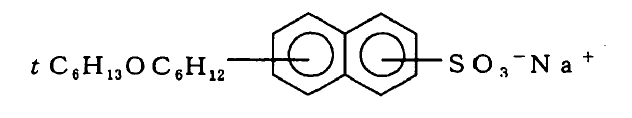

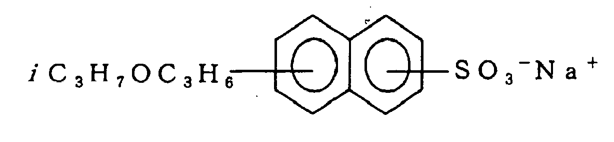

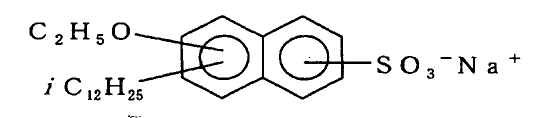

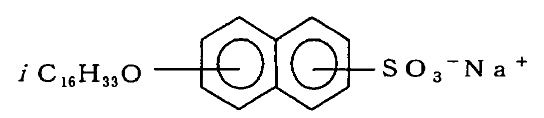

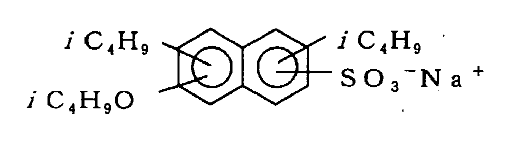

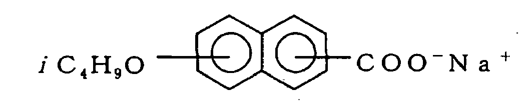

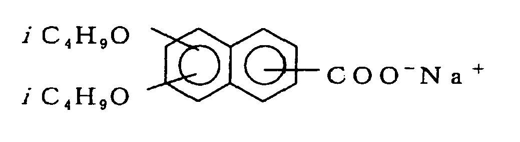

In the compound represented by formula (1-IV), when the total number of carbon atoms included in R₆ to R₁₀ is 3 or more, the effect can be recognized. However, as the total number of carbon atoms included in R₆ to R₁₀ increases, the hydrophobic portion becomes large and dissolution of the compound in an aqueous developer becomes difficult. In such a case, the surfactant can not be dissolved in a proper mixing range even when a dissolution auxiliary agent for assisting the dissolution, for example, an organic solvent is mixed with water. Ordinarily, the total number of carbon atoms included in R₆ to R₁₀ is 24 or less. The total number of carbon atoms included in R₆ to R₁₀ is preferably from 3 to 20. When R₆ to R₁₀ represents one or more alkyl groups, each of the alkyl groups may be a straight-chain or branched structure.

The total number of carbon atoms included in R₆ to R₁₀ of the compound (surfactant) is influenced by a material, especially, a binder, used in the photosensitive layer. When a binder having high hydrophilicity is used, the total number of carbon atoms included in R₆ to R₁₀ may be relatively small. On the other hand, when a binder having low hydrophilicity is used, it is necessary that the total number of carbon atoms included in R₆ to R₁₀ is large.

In the above-described compound, X₂ represents a sulfonate, a sulfuric monoester salt, a carboxylate or a phosphate. Among them, the sulfonate and carboxylate have the large effect. In the salts, an alkali metal salt is preferable, since it has excellent solubility in an aqueous solvent. Among them, a sodium salt or a potassium salt is particularly preferable.

The compound will be described more specifically below.

Specific examples of the compound wherein the alkyl groups represented by R₆ to R₁₀ do not contain an oxygen atom are set forth below.

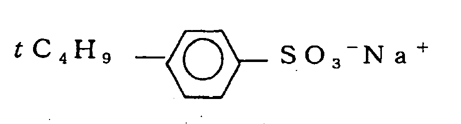

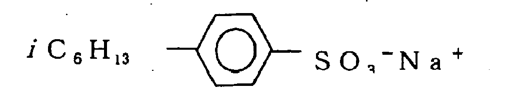

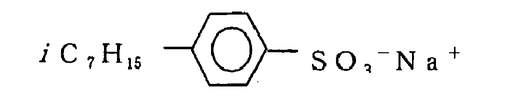

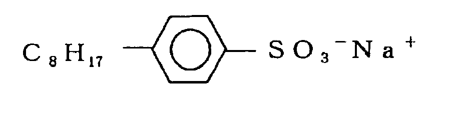

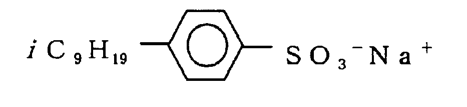

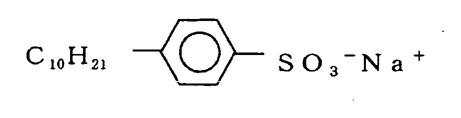

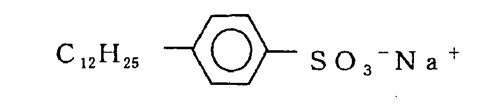

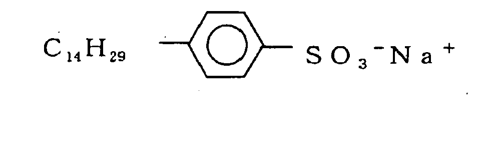

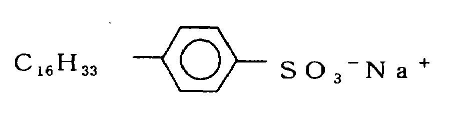

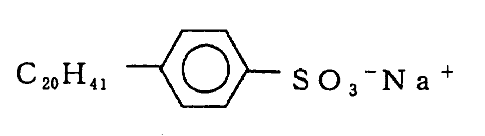

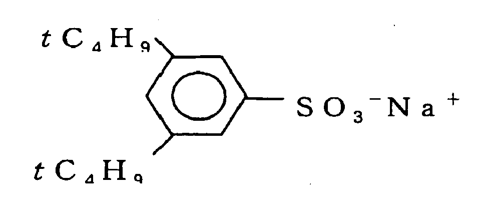

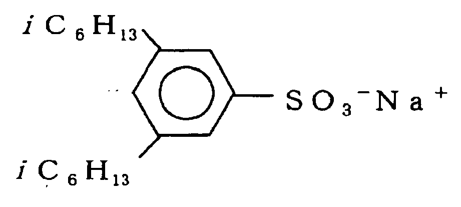

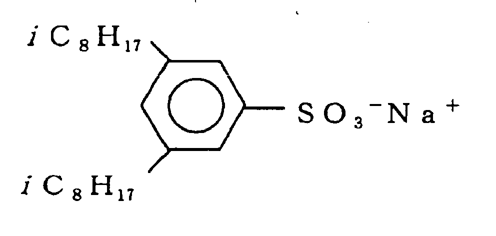

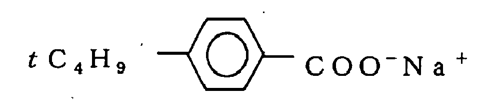

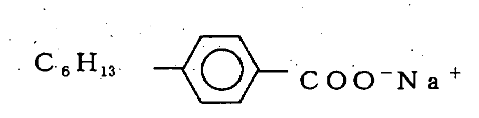

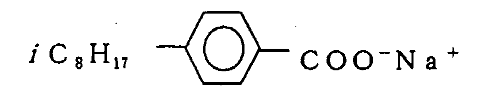

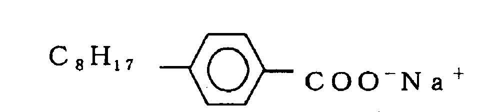

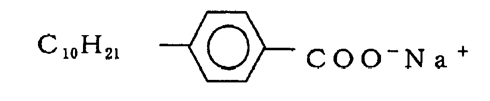

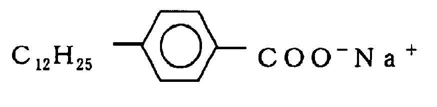

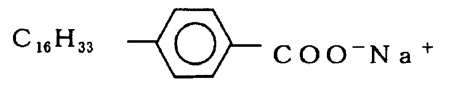

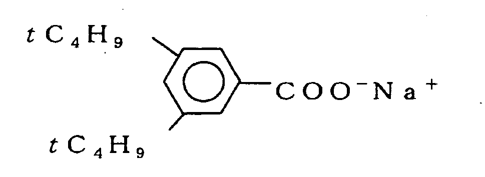

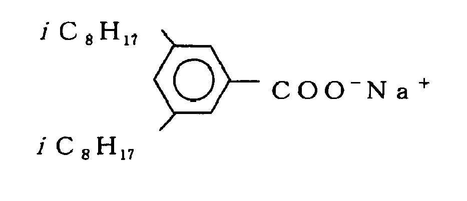

Specific examples of the compound wherein at least one of R₆ to R₁₀ represents an alkyl group containing an oxygen atom, that is, -CₘH₂ₘOCₙ₋ₘH₂₍ₙ₋ₘ₎+1 (n ≥ 2, n ≥ m ≥ 0) are set forth below.

The substituents other than the -CₘH₂ₘOCₙ₋ₘH₂(ₙ₋ₘ)₊₁ are hydrogen atoms or alkyl groups, and the total number of carbon atoms included in R₆ to R₁₀ is 3 to 24. These compounds are easily soluble in the aqueous solvent by the introduction of oxygen atom and they are preferably used in the developer in many cases.

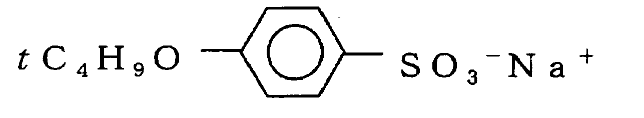

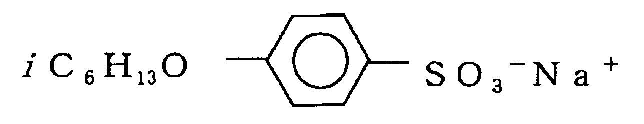

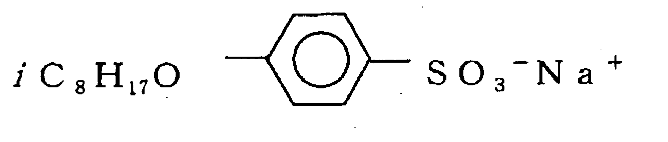

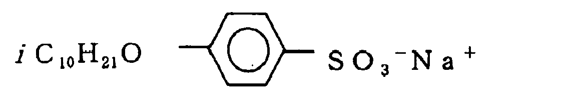

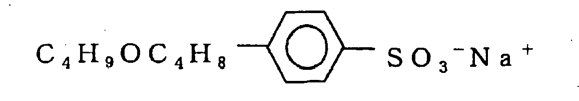

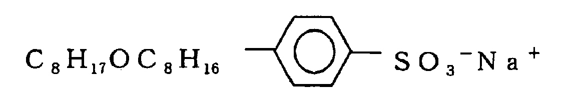

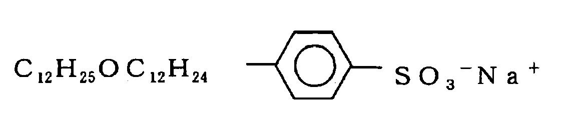

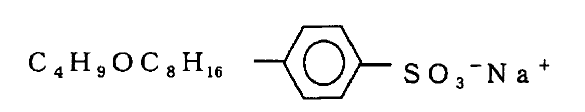

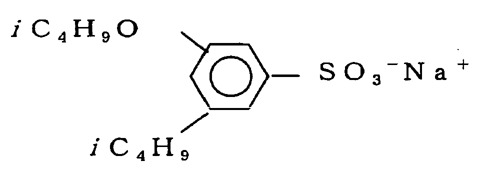

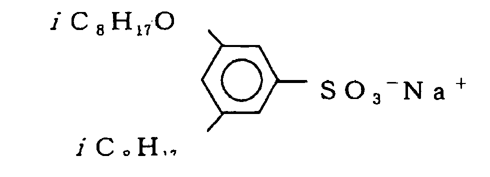

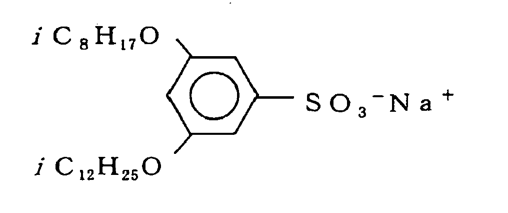

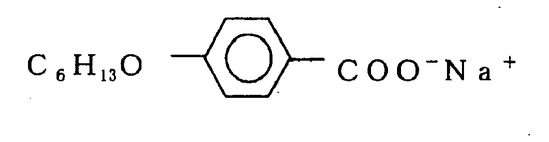

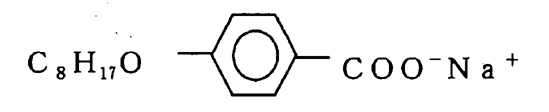

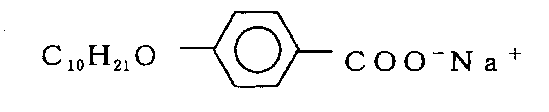

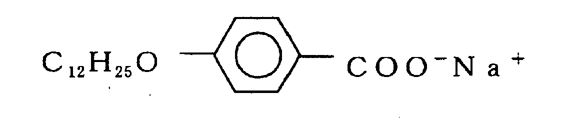

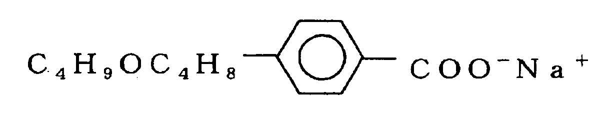

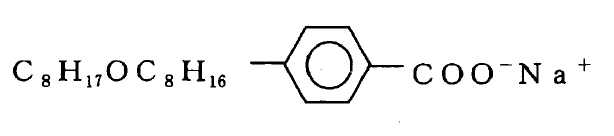

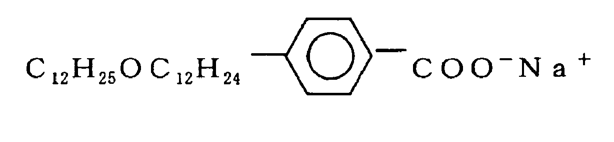

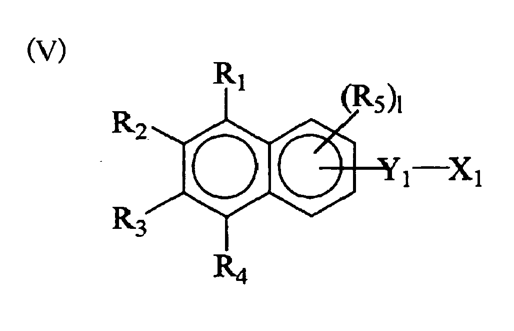

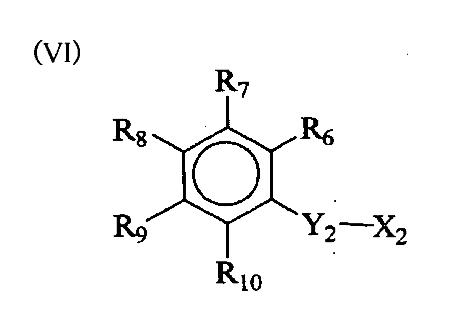

In the formulae, R₁ to R₁₀ each represents a hydrogen atom or an alkyl group; 1 represents an integer of 1 to 3; X₁ and X₂ each represents a sulfonate, a sulfuric monoester salt, a carboxylate or a phosphate; Y₁ and Y₂ each represents -CₙH₂ₙ-, -Cₙ₋ₘH₂₍ₙ₋ₘ₎OCₘH₂ₘ-, -O-(CH₂CH₂O)ₙ-, -O-(CH₂CH₂CH₂O)ₙ- or -CO-NH- wherein n ≥ 1 and n ≥ m ≥ 0; and provided that a total number of carbon atoms included in R₁ to R₅ and Y₁ or R₆ to R₁₀ and Y₂ is 3 or more.

In the compound represented by formula (1-V), when the total number of carbon atoms included in R₁ to R₅ and Y₁ is 3 or more, the effect can be recognized. However, as the total number of carbon atoms increases, the hydrophobic portion becomes large and dissolution of the compound in an aqueous developer becomes difficult. In such a case, the surfactant can not be dissolved in a proper mixing range even when a dissolution auxiliary agent for assisting the dissolution, for example, an organic solvent is mixed with water. Ordinarily, the total number of carbon atoms is 25 or less. The total number of carbon atoms is preferably from 4 to 20. The alkyl group described above may be a straight-chain or branched structure.

The total number of carbon atoms included in R₁ to R₅ and Y₁ of the compound (surfactant) is influenced by a material, especially, a binder, used in the photosensitive layer. When a binder having high hydrophilicity is used, the total number of carbon atoms included in R₁ to R₅ and Y₁ may be relatively small. On the other hand, when a binder having low hydrophilicity is used, it is necessary that the total number of carbon atoms is large.

In the above-described compound, X₁ represents a sulfonate, a sulfuric monoester salt, a carboxylate or a phosphate. Among them, the sulfonate and carboxylate have the large effect. In the salts, an alkali metal salt is preferable, since it has excellent solubility in an aqueous solvent. Among them, a sodium salt or a potassium salt is particularly preferable.

The compound will be described more specifically below.

Specific examples of the compound wherein Y₁ represents a group not containing an oxygen atom are set forth below.

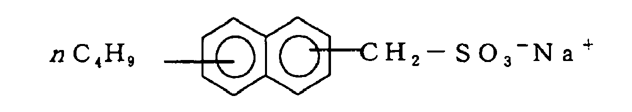

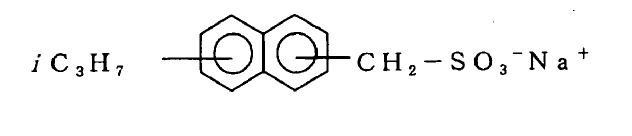

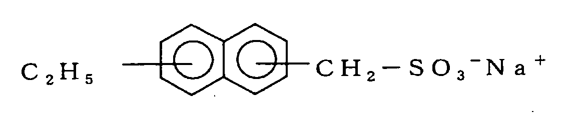

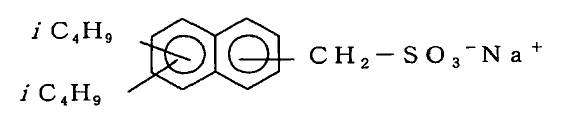

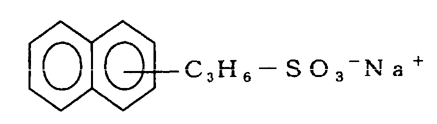

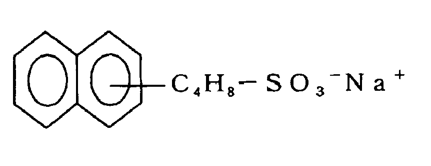

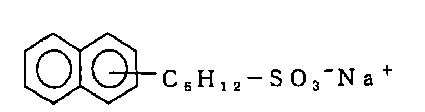

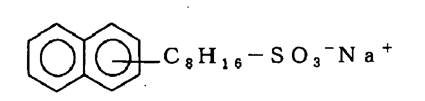

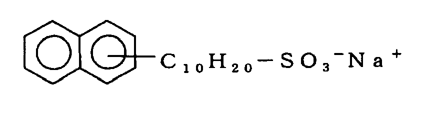

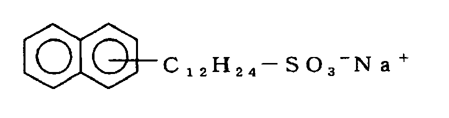

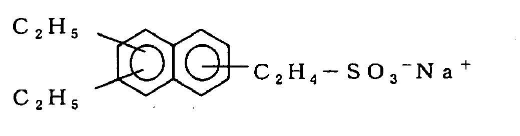

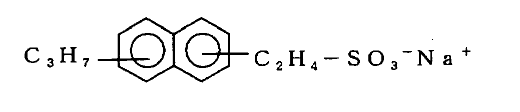

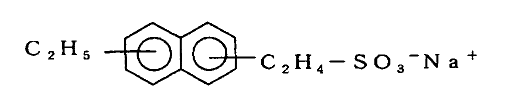

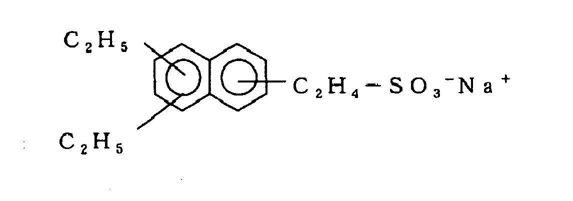

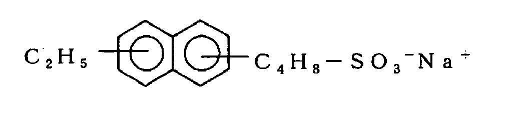

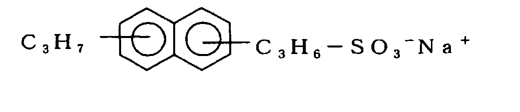

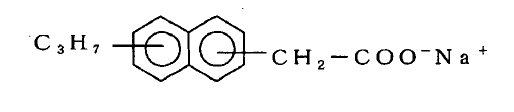

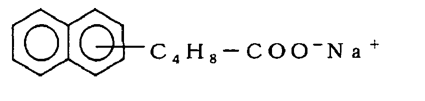

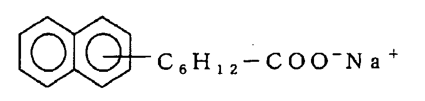

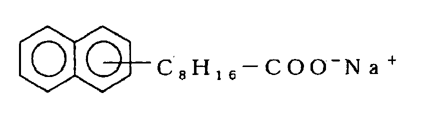

Specific examples of the compound wherein Y₁ represents a group containing an oxygen atom, that is, -Cₙ₋ₘH₂₍ₙ₋ₘ₎OCₘH₂ₘ- (n ≥ 1, n ≥ m ≥ 0) are set forth below.

The substituents (R₁ to R₅) other than the -Cₙ₋ₘH₂₍ₙ₋ₘ₎OCₘH₂ₘ- are hydrogen atoms or alkyl groups, and the total number of carbon atoms is 3 to 25. These compounds are easily soluble in the aqueous solvent by the introduction of oxygen atom and they are preferably used in the developer in many cases.

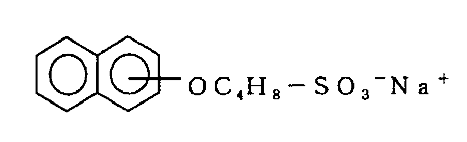

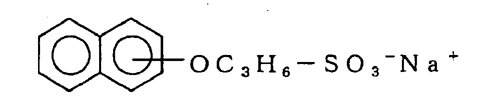

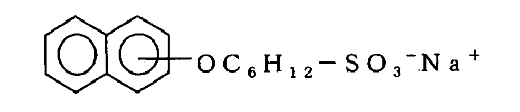

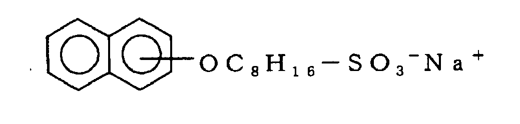

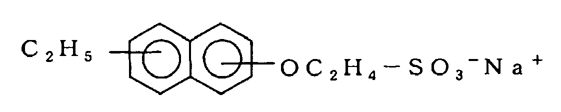

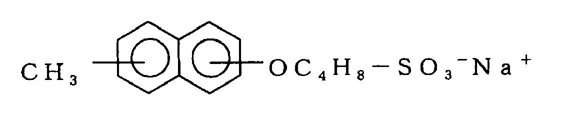

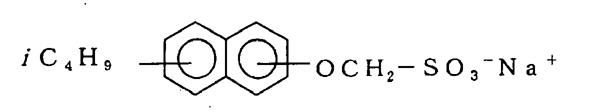

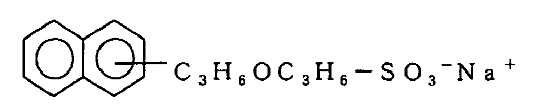

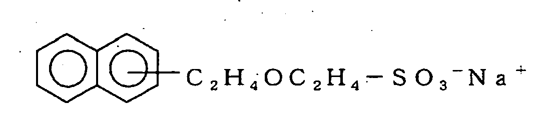

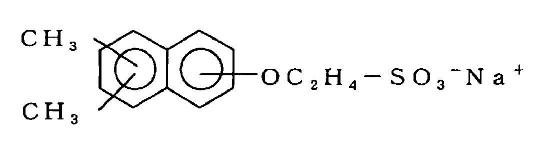

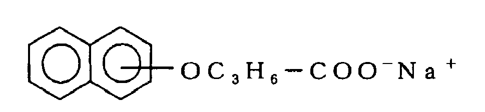

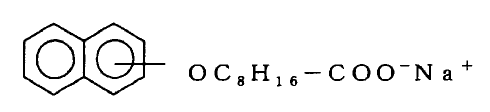

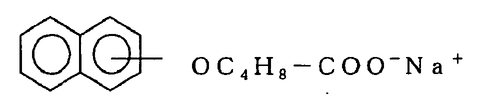

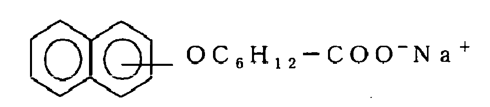

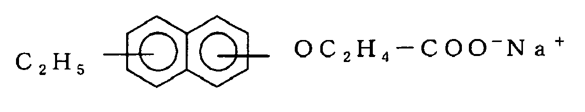

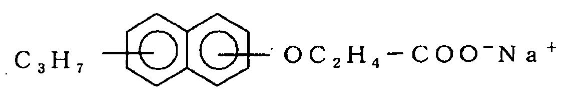

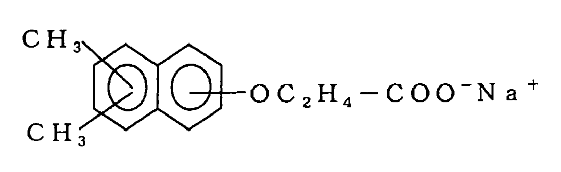

In the compound represented by formula (1-VI), when the total number of carbon atoms included in R₆ to R₁₀ and Y₂ is 3 or more, the effect can be recognized. However, as the total number of carbon atoms increases, the hydrophobic portion becomes large and dissolution of the compound in an aqueous developer becomes difficult. In such a case, the surfactant can not be dissolved in a proper mixing range even when a dissolution auxiliary agent for assisting the dissolution, for example, an organic solvent is mixed with water. Ordinarily, the total number of carbon atoms is 25 or less. The total number of carbon atoms is preferably from 3 to 20. The alkyl group described above may be a straight-chain or branched structure.

The total number of carbon atoms included in R₆ to R₁₀ and Y₂ of the compound (surfactant) is influenced by a material, especially, a binder, used in the photosensitive layer. When a binder having high hydrophilicity is used, the total number of carbon atoms included in R₆ to R₁₀ and Y₂ may be relatively small. On the other hand, when a binder having low hydrophilicity is used, it is necessary that the total number of carbon atoms is large.

In the above-described compound, X₂ represents a sulfonate, a sulfuric monoester salt, a carboxylate or a phosphate. Among them, the sulfonate and carboxylate have the large effect. In the salts, an alkali metal salt is preferable, since it has excellent solubility in an aqueous solvent. Among them, a sodium salt or a potassium salt is particularly preferable.

The compound will be described more specifically below.

Specific examples of the compound wherein Y₂ represents a group not containing an oxygen atom are set forth below.

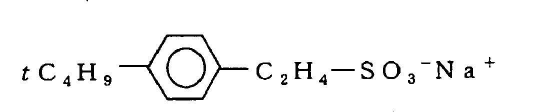

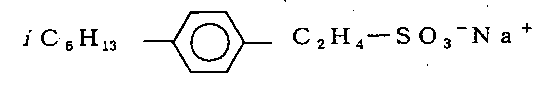

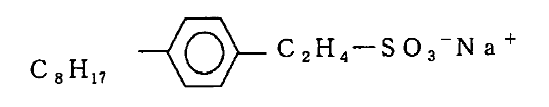

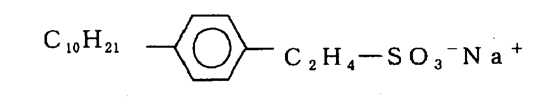

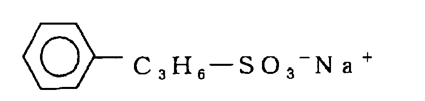

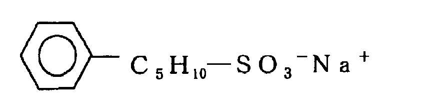

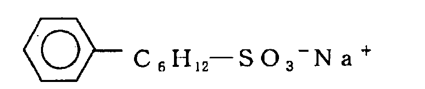

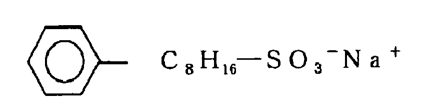

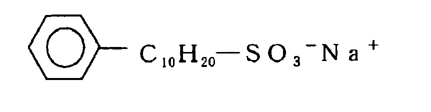

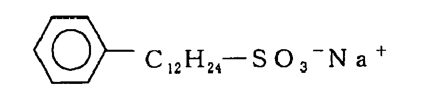

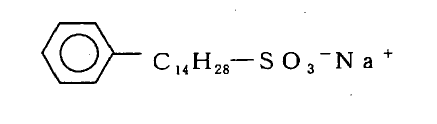

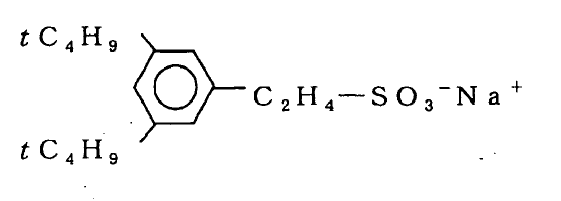

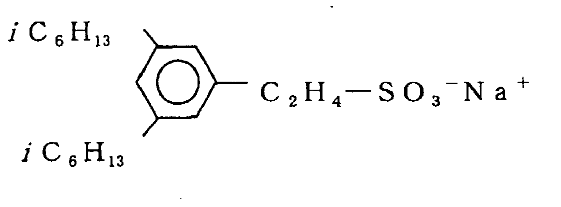

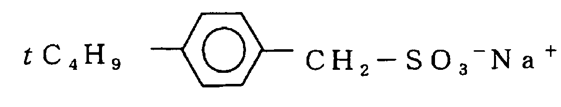

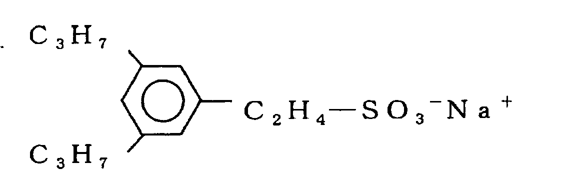

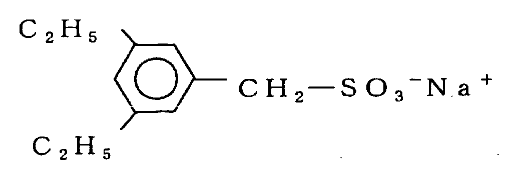

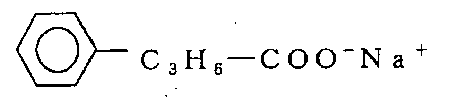

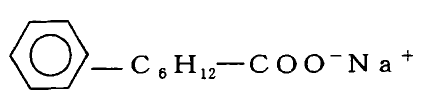

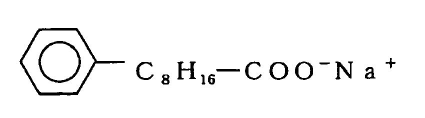

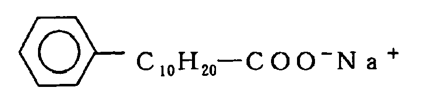

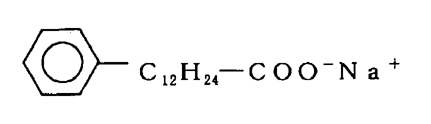

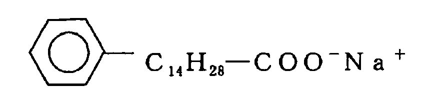

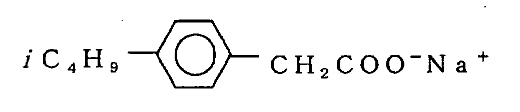

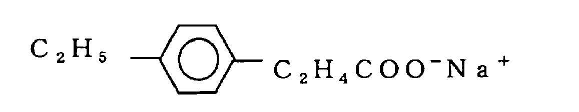

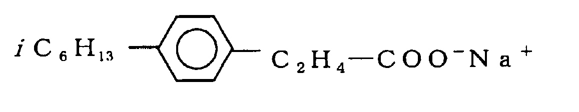

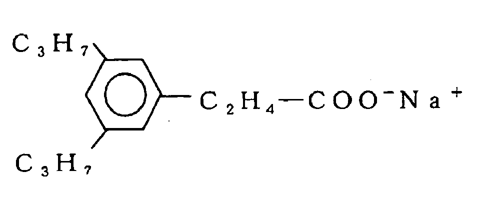

Specific examples of the compound wherein Y₂ represents a group containing an oxygen atom, that is, -Cₙ₋ₘH₂₍ₙ₋ₘ₎OCₘH₂ₘ- (n ≥ 1, n ≥ m ≥ 0) are set forth below.

The substituents (R₆ to R₁₀) other than the -Cₙ₋ₘH₂₍ₙ₋ₘ₎OCₘH₂ₘ- are hydrogen atoms or alkyl groups, and the total number of carbon atoms is 3 to 25. These compounds are easily soluble in the aqueous solvent by the introduction of oxygen atom and they are preferably used in the developer in many cases.

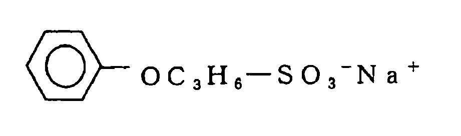

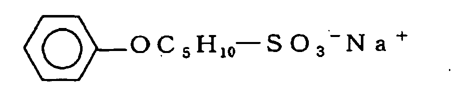

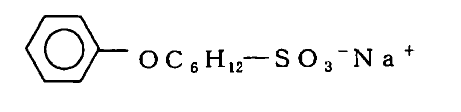

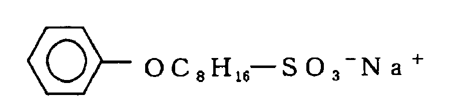

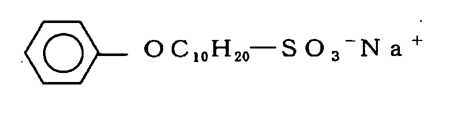

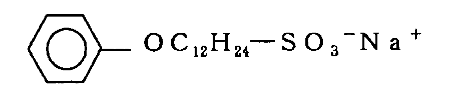

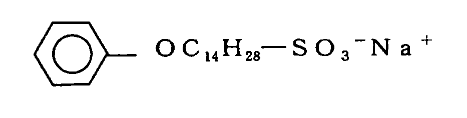

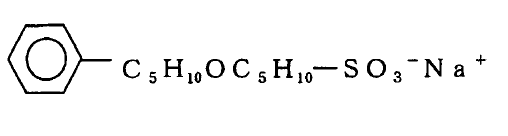

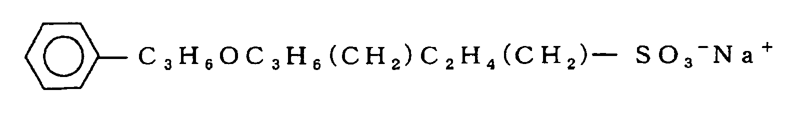

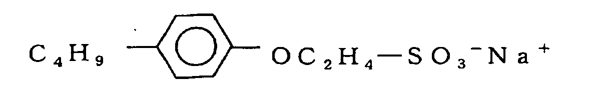

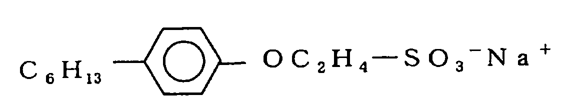

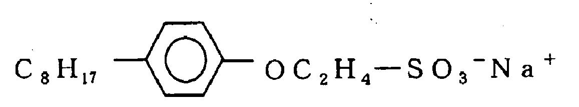

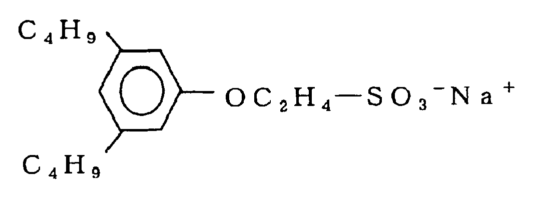

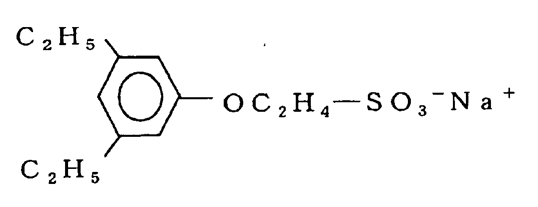

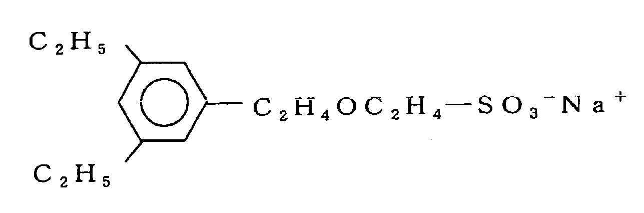

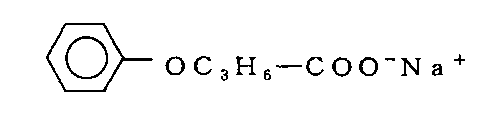

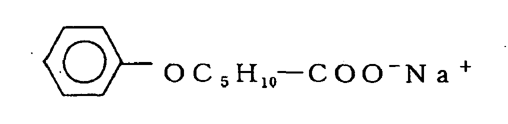

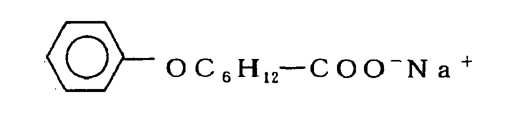

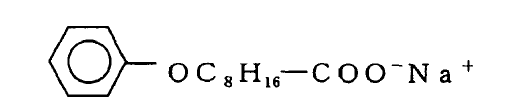

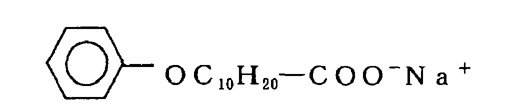

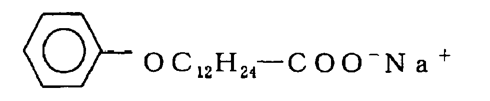

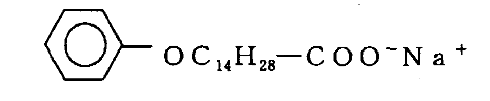

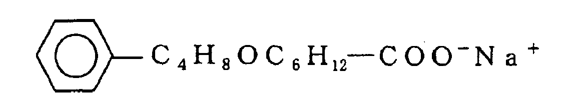

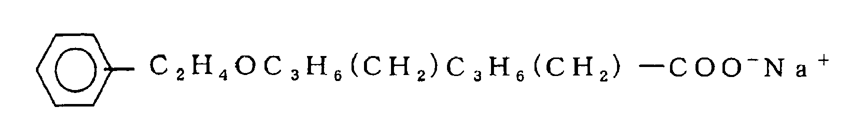

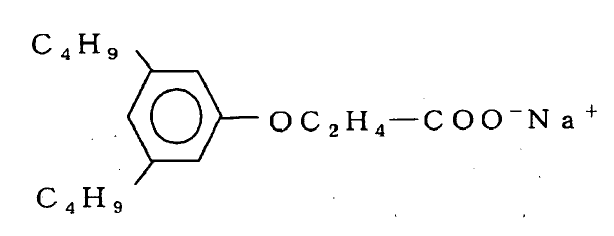

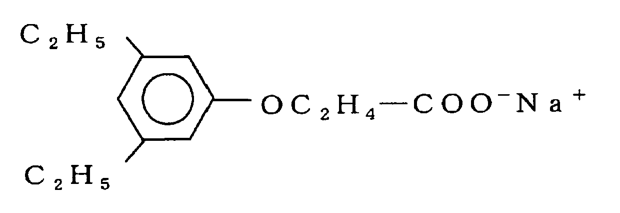

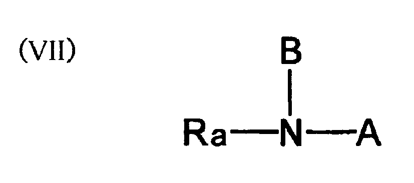

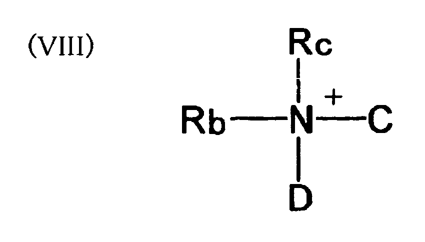

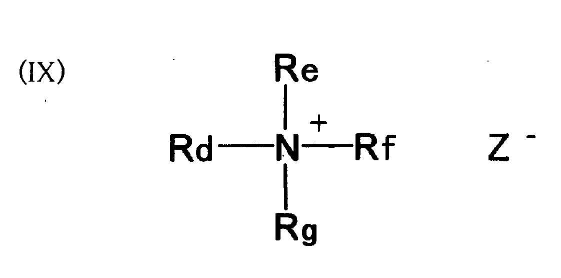

In formula (1-VII), Rₐ represents a hydrogen atom or an alkyl group; and A and B each represents a group containing an ethylene oxide group, a carboxylic acid group or a carboxylate.

In formula (1-VIII), R_{b} and R_{c} each represents a hydrogen atom or an alkyl group; C represents an alkyl group or a group containing an ethylene oxide group; and D represents a group containing a carboxylic acid anion.

In formula (1-IX), R_{d}, Rₑ, R_{f} and R_{g} each represents a hydrogen atom or an alkyl group; and Z⁻ represents a counter anion.

The alkyl group represented by any one of Rₐ and R_{g} may have a substituent.

The compounds (hereinafter, also referred to as surfactant) represented by formulae (1-VII), (1-VIII) and (1-IX) described above are not particularly restricted. Representative compounds are described below. 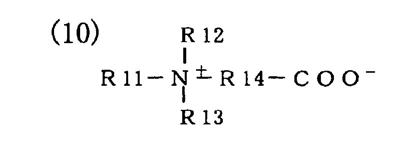 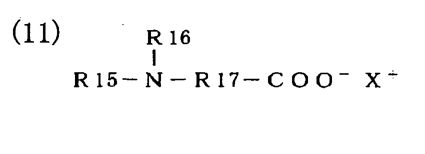 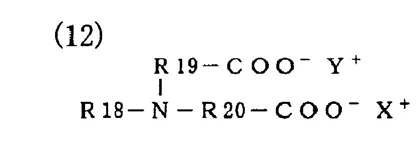 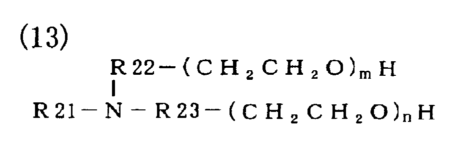 or

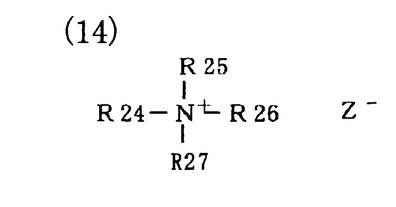

In the formula, R11 to R13, R15, R16, R18, R21 and R24 to R27 each represents a hydrogen atom or an alkyl group, and R14, R17, R19, R20, R22 and R23 each represents an alkylene group or a single bond.

In the compound represented by formula (10), R11 to R13 each represents a hydrogen atom or an alkyl group, and R14 represents an alkylene group. However, the N atom may be directly connected with the carboxyl group and in this case, R14 represents a single bond.

In the compound represented by formula (10), as the total number of carbon atoms increases, the hydrophobic portion becomes large and dissolution of the compound in an aqueous developer becomes difficult. In such a case, the dissolution is improved by mixing a dissolution auxiliary agent for assisting the dissolution, for example, an organic solvent or an alcohol. However, when the total number of carbon atoms excessively increases, the surfactant can not be dissolved in a proper mixing range. The total number of carbon atoms included in R11 to R14 is preferably from 10 to 40, more preferably from 12 to 30.

When R11 to R13 each represents an alkyl group, the alkyl group may be a straight-chain or branched structure.

The total number of carbon atoms included in R11 to R14 of the compound (surfactant) is influenced by a material, especially, a binder, used in the photosensitive layer. When a binder having high hydrophilicity is used, it tends to be preferable that the total number of carbon atoms included in R11 to R14 is relatively small. On the other hand, when a binder having low hydrophilicity is used, it is preferable that the total number of carbon atoms included in R11 to R14 is large.

Specific examples of the representative compound are set forth below.

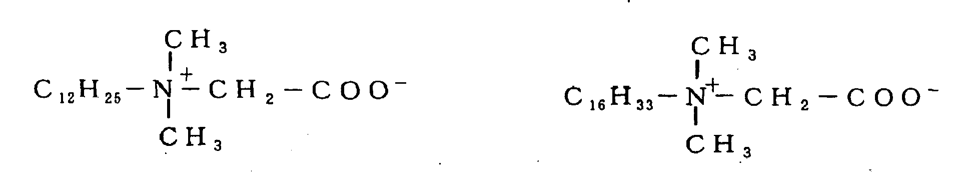

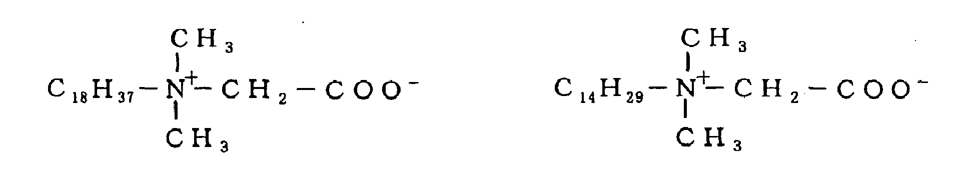

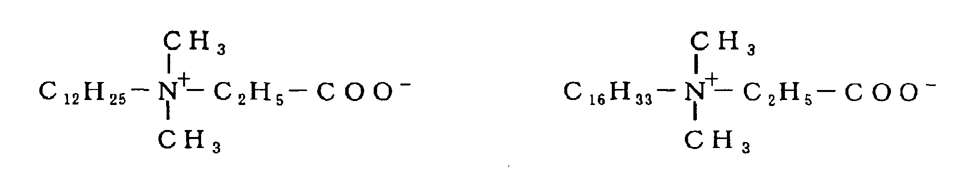

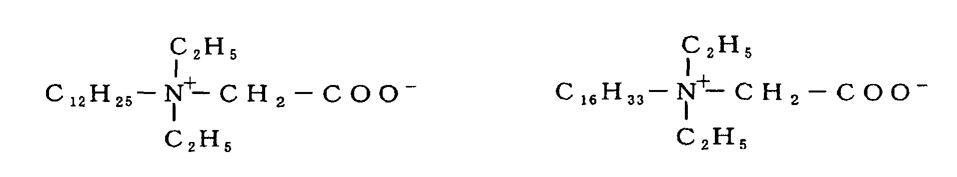

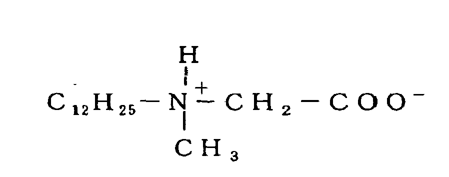

In the compound represented by formula (11), R15 to R16 each represents a hydrogen atom or an alkyl group, and R17 represents an alkylene group. However, the N atom may be directly connected with the carboxyl group and in this case, R17 represents a single bond.

Similar to the compound represented by formula (10), in the compound represented by formula (11), as the total number of carbon atoms increases, the hydrophobic portion becomes large and dissolution of the compound in an aqueous developer becomes difficult. In such a case, the dissolution is improved by mixing a dissolution auxiliary agent for assisting the dissolution, for example, an organic solvent or an alcohol. However, when the total number of carbon atoms excessively increases, the surfactant can not be dissolved in a proper mixing range. The total number of carbon atoms included in R15 to R17 is preferably from 10 to 30, more preferably from 12 to 25.

When R15 to R17 each represents an alkyl group, the alkyl group may be a straight-chain or branched structure.

The total number of carbon atoms included in R15 to R17 of the compound (surfactant) is influenced by a material, especially, a binder, used in the photosensitive layer. When a binder having high hydrophilicity is used, it tends to be preferable that the total number of carbon atoms included in R15 to R17 is relatively small. On the other hand, when a binder having low hydrophilicity is used, it is preferable that the total number of carbon atoms included in R15 to R17 is large.

In the compound described above, as X⁺, a divalent metal ion, for example, a calcium ion or a magnesium ion, an ammonium ion or a hydrogen ion is used in addition to a monovalent metal ion, for example, a potassium ion or a sodium ion. Among them, a sodium ion or a potassium ion is preferably used.

Specific examples of the representative compound are set forth below.

C₁₂H₂₅-NH-CH₂-COO⁻ Na⁺

C₁₄H₂₉-NH-CH₂-COO- Na⁺

C₁₂H₂₅-NH-C₂H₄-COO⁻ Na⁺

C₁₄H₂₉-NH-C₂H₄-COO⁻ Na⁺

C₁₆H₃₃-NH-CH₂-COO⁻ Na⁺

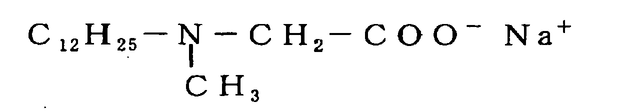

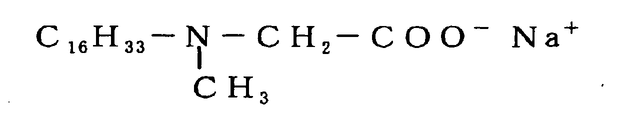

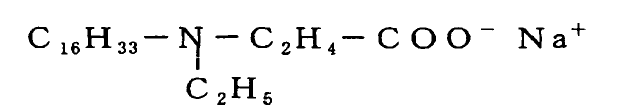

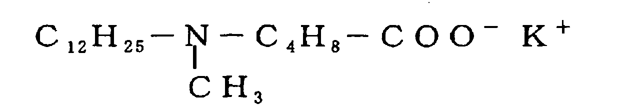

In the compound represented by formula (12), R18 represents a hydrogen atom or an alkyl group, and R19 and R20 each represents an alkylene group. However, the N atom may be directly connected with the carboxyl groups and in this case, R19 and R20 each represents a single bond.

Similar to the compound represented by formula (10) or (11), in the compound represented by formula (12), as the total number of carbon atoms increases, the hydrophobic portion becomes large and dissolution of the compound in an aqueous developer becomes difficult. In such a case, the dissolution is improved by mixing a dissolution auxiliary agent for assisting the dissolution, for example, an organic solvent or an alcohol. However, when the total number of carbon atoms excessively increases, the surfactant can not be dissolved in a proper mixing range. The total number of carbon atoms included in R18 to R20 is preferably from 10 to 30, more preferably from 12 to 28.

When R18 represents an alkyl group, the alkyl group may be a straight-chain or branched structure.

The total number of carbon atoms included in R18 to R20 of the compound (surfactant) is influenced by a material, especially, a binder, used in the photosensitive layer. When a binder having high hydrophilicity is used, it tends to be preferable that the total number of carbon atoms included in R18 to R20 is relatively small. On the other hand, when a binder having low hydrophilicity is used, it is preferable that the total number of carbon atoms included in R18 to R20 is large.

In the compound described above, as X⁺ or Y⁺, a divalent metal ion, for example, a calcium ion or a magnesium ion, an ammonium ion or a hydrogen ion is used in addition to a monovalent metal ion, for example, a potassium ion or a sodium ion. Among them, a sodium ion or a potassium ion is preferably used.

Specific examples of the representative compound are set forth below.

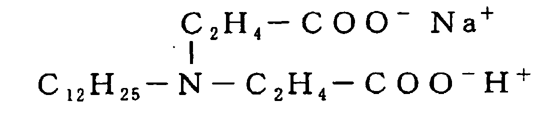

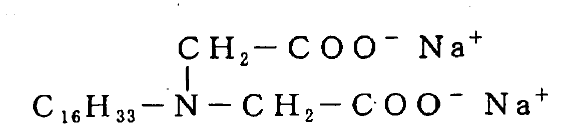

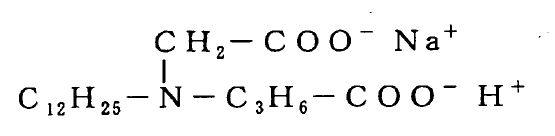

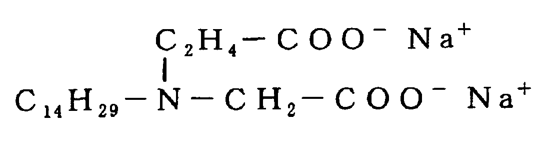

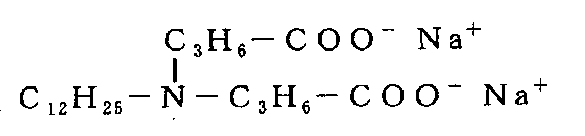

In the compound represented by formula (13), R21 represents a hydrogen atom or an alkyl group, and R22 and R23 each represents an alkylene group. However, the N atom may be directly connected with the ethylene oxide groups and in this case, R22 and R23 each represents a single bond.

In the compound represented by formula (13) also, as the total number of carbon atoms increases, the hydrophobic portion becomes large and dissolution of the compound in an aqueous developer becomes difficult. In such a case, the dissolution is improved by mixing a dissolution auxiliary agent for assisting the dissolution, for example, an organic solvent or an alcohol. However, when the total number of carbon atoms excessively increases, the surfactant can not be dissolved in a proper mixing range. The total number of carbon atoms included in R21 to R23 is preferably from 8 to 50, more preferably from 12 to 40.

When R21 represents an alkyl group, the alkyl group may be a straight-chain or branched structure.

The total number of carbon atoms included in R21 to R23 of the compound (surfactant) is influenced by a material, especially, a binder, used in the photosensitive layer. When a binder having high hydrophilicity is used, it tends to be preferable that the total number of carbon atoms included in R21 to R23 is relatively small. On the other hand, when a binder having low hydrophilicity is used, it is preferable that the total number of carbon atoms included in R21 to R23 is large.

With respect to m and n each representing a number of the ethylene oxide, as the number increases, the hydrophilicity increases and the stability thereof in water is improved. m and n may be the same or different. m is ordinarily from 1 to 20 and n is ordinarily from 1 to 20.

Specific examples of the representative compound are set forth below.

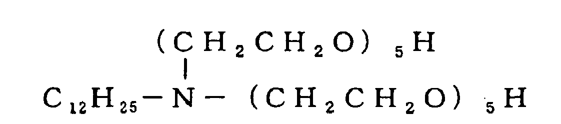

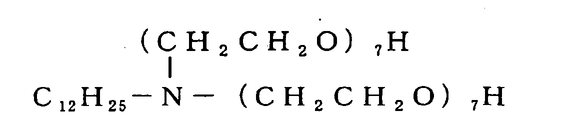

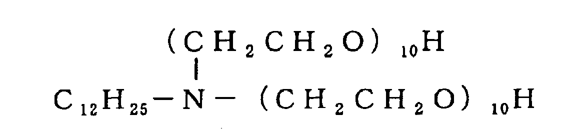

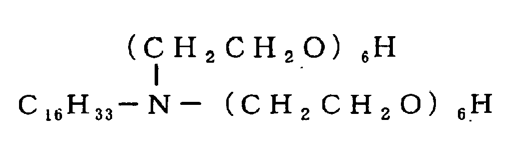

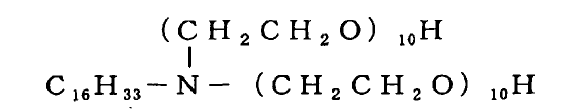

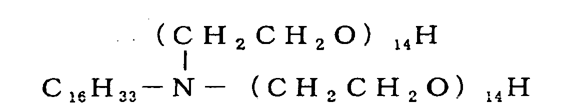

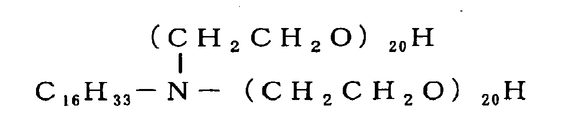

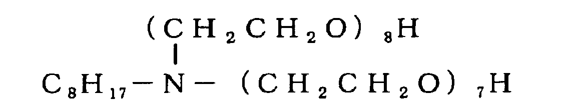

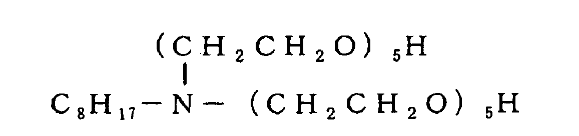

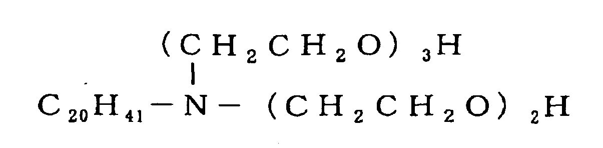

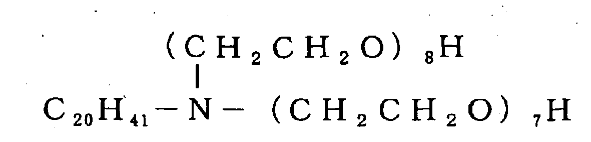

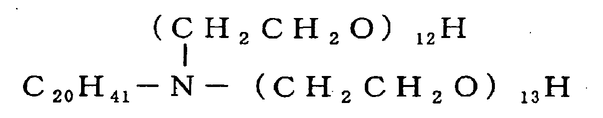

In the compound represented by formula (14), R24 to R27 each represents a hydrogen atom or an alkyl group.

In the compound represented by formula (14) also, as the total number of carbon atoms increases, the hydrophobic portion becomes large and dissolution of the compound in an aqueous developer becomes difficult. In such a case, the dissolution is improved by mixing a dissolution auxiliary agent for assisting the dissolution, for example, an organic solvent or an alcohol. However, when the total number of carbon atoms excessively increases, the surfactant can not be dissolved in a proper mixing range. The total number of carbon atoms included in R24 to R27 is preferably from 10 to 30, more preferably from 12 to 28.

When R24 to R27 each represents an alkyl group, the alkyl group may be a straight-chain or branched structure.

The total number of carbon atoms included in R24 to R27 of the compound (surfactant) is influenced by a material, especially, a binder, used in the photosensitive layer. When a binder having high hydrophilicity is used, it tends to be preferable that the total number of carbon atoms included in R24 to R27 is relatively small. On the other hand, when a binder having low hydrophilicity is used, it is preferable that the total number of carbon atoms included in R24 to R27 is large.

Z⁻ represents a counter anion. The counter anion is not restricted but, for example, Cl⁻, Br⁻ or I⁻ is used in many cases.

Specific examples of the representative compound are set forth below.

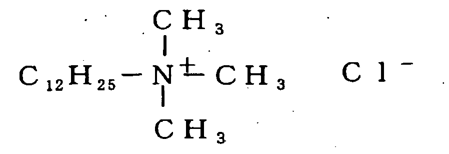

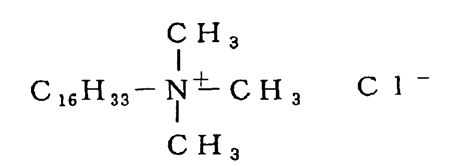

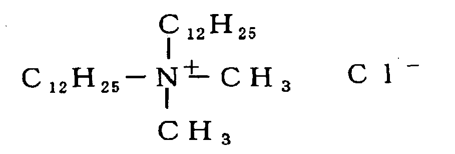

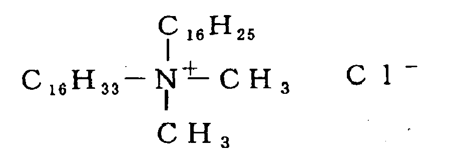

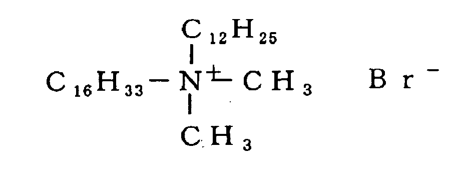

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, those known can be used. For example, as a commercial product, Soyafive (trade name, produced by Fuji Oil Co., Ltd.) is available and various grade products can be used. The soybean polysaccharide preferably used has viscosity in a range from 10 to 100 mPa/sec in a 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound is preferably from 0.1 to 20% by weight, and more preferably from 0.5 to 10% by weight, in the developer.

The developer for use in the invention may contain an organic solvent. The organic solvent that can be contained in the developer include, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or nomochlorobenzene) and a polar solvent.

Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, dipropylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

Further, when the organic solvent is insoluble in water, it may be employed by being solubilized in water using a surfactant or the like. In the case where the developer contains the organic solvent, the concentration of the organic solvent is desirably less than 40% by weight in view of safety and inflammability.

Into the developer for use in the invention, an antiseptic agent, a chelating agent, a defoaming agent, an organic acid, an inorganic acid, an inorganic salt or the like can be incorporated in addition to the above components.

As the antiseptic agent, for example, phenol or a derivative thereof, formalin, an imidazole derivative, sodium dehydroacetate, a 4-isothiazolin-3-one derivative, benzisotiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative and a nitro bromo alcohol, e.g., 2-bromo-2-nitropropane-1,3-diol, 1,1-dibromo-1-nitro-2-ethanol or 1,1-dibromo-1-nitro-2-propanol are preferably used.

As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; organic phosphonic acids, for example, 1-hydroxyethane-1,1-diphosphonic acid, potassium salt thereof, sodium salt thereof; aminotri(methylenephosphonic acid), potassium salt thereof, sodium salt thereof; and phophonoalkanetricarboxylic acids are illustrated. A salt of an organic amine is also effectively used in place of the sodium salt or potassium salt in the chelating agents.

As the defoaming agent, for example, a conventional silicone-based self-emulsifying type or emulsifying type defoaming agent, and a nonionic surfactant having HLB of 5 or less are used. The silicone defoaming agent is preferably used. Any of emulsifying dispersing type and solubilizing type can be used.

As the organic acid, for example, citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid and an organic phosphonic acid are illustrated. The organic acid can also be used in the form of an alkali metal salt or an ammonium salt.

As the inorganic acid and inorganic salt, for example, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate and nickel sulfate are illustrated.

The developer described above can be used as a developer and a development replenisher for an exposed negative-working lithographic printing plate precursor, and it is preferably applied to an automatic processor described hereinafter. In the case of conducting the development processing using an automatic processor, the developer becomes fatigued in accordance with the processing amount, and hence the processing ability may be restored using a replenisher or a fresh developer. Such a replenishment system can be preferably applied to the plate-making method of the lithographic printing plate precursor according to the invention.

The development processing using the aqueous solution having pH of 2 to 10 according to the invention is preferably performed by an automatic processor equipped with a supplying means for a developer and a rubbing member. As the automatic processor, there are illustrated an automatic processor in which a lithographic printing plate precursor after image-recording is subjected to a rubbing treatment while it is transporting described in JP-A-2-220061 and -JP-A-60-59351, and an automatic processor in which a lithographic printing plate precursor after image-recording placed on a cylinder is subjected to a rubbing treatment while rotating the cylinder described in U.S. Patents 5,148,746 and 5,568,768 and British Patent 2,297,719. Among them, the automatic processor using a rotating brush roll as the rubbing member is particularly preferred.

The rotating brush roller which can be preferably used in the invention can be appropriately selected by taking account, for example, of scratch resistance of the image area and nerve strength of the support of the lithographic printing plate precursor. As for the rotating brush roller, a known rotating brush roller produced by implanting a brush material in a plastic or metal roller can be used. For example, a rotating brush roller described in JP-A-58-159533 and JP-A-3-100554, or a brush roller described in JP-U-B-62-167253 (the term "JP-UM-B" as used herein means an "examined Japanese utility model publication"), in which a metal or plastic groove-type member having implanted therein in rows a brush material is closely radially wound around a plastic or metal roller acting as a core, can be used.

As the brush material, a plastic fiber (for example, a polyester-based synthetic fiber, e.g., polyethylene terephthalate or polybutylene terephthalate; a polyamide-based synthetic fiber, e.g., nylon 6.6 or nylon 6.10; a polyacrylic synthetic fiber, e.g., polyacrylonitrile or polyalkyl (meth)acrylate; and a polyolefin-based synthetic fiber, e.g., polypropylene or polystyrene) can be used. For instance, a brush material having a fiber bristle diameter of 20 to 400 µm and a bristle length of 5 to 30 mm can be preferably used.

The outer diameter of the rotating brush roller is preferably from 30 to 200 mm, and the peripheral velocity at the tip of the brush rubbing the plate surface is preferably from 0.1 to 5 m/sec.

Further, it is preferred to use a plurality, that is, two or more of the rotating brush rollers.

The rotary direction of the rotating brush roller for use in the invention may be the same direction or the opposite direction with respect to the transporting direction of the lithographic printing plate precursor of the invention, but when two or more rotating brush rollers are used in an automatic processor as shown in Fig. 1, it is preferred that at least one rotating brush roller rotates in the same direction and at least one rotating brush roller rotates in the opposite direction with respect to the transporting direction. By such arrangement, the photosensitive layer in the non-image area can be more steadily removed. Further, a technique of rocking the rotating brush roller in the rotation axis direction of the brush roller is also effective.

The developer can be used at an appropriate temperature, and the developer temperature is preferably from 10 to 50°C.

In the invention, the lithographic printing plate after the rubbing treatment may be subsequently subjected to water washing, a drying treatment and an oil-desensitization treatment, if desired. In the oil-desensitization treatment, a known oil-desensitizing solution can be used.

Further, in a plate-making process of the lithographic printing plate precursor to prepare a lithographic printing plate according to the invention, the entire surface of the lithographic printing plate precursor may be heated, if desired, before or during the exposure or between the exposure and the development. By the heating, the image-forming reaction in the photosensitive layer is accelerated and advantages, for example, improvement in the sensitivity and printing durability and stabilization of the sensitivity are achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise in that undesirable fog occurs in the non-image area. On the other hand, the heating after the development can be performed using a very strong condition. Ordinarily, the heat treatment is carried out in a temperature range of 200 to 500°C. When the temperature is too low, a sufficient effect of strengthening the image may not be obtained, whereas when it is excessively high, problems of deterioration of the support and thermal decomposition of the image area may occur.

The plate-making process is described in more detail below. In the invention, although the development processing can be carried out just after the exposure step, the heat treatment step may intervene between the exposure step and the development step as described above. The heat treatment is effective for increasing the printing durability and improving uniformity of the image hardness degree in the entire surface of printing plate precursor. The conditions of the heat treatment can be appropriately determined in a range for providing such effects. Examples of the heating means include a conventional convection oven, an IR irradiation apparatus, an IR laser, a microwave apparatus or a Wisconsin oven. For instance, the heat treatment can be conducted by maintaining the printing plate precursor at a plate surface temperature ranging from 70 to 150°C for a period of one second to 5 minutes, preferably at 80 to 140°C for 5 seconds to one minute, more preferably at 90 to 130°C for 10 to 30 seconds. In the above-described range, the effects described above are efficiently achieved and an adverse affect, for example, change in shape of the printing plate precursor due to the heat can be preferably avoided.

According to the invention, the development processing step is conducted after the exposure step, preferably after the exposure step and the heat treatment step to prepare a lithographic printing plate. It is preferable that a plate setter used in the exposure step, a heat treatment means used in the heat treatment step and a development apparatus used in the development processing step are connected with each other and the lithographic printing plate precursor is subjected to automatically continuous processing. Specifically, a plate-making line wherein the plate setter and the development apparatus are connected with each other by transport means, for example, a conveyer is illustrated. Also, the heat treatment means may be placed between the plate setter and the development apparatus or the heat treatment means and the development apparatus may constitute a unit apparatus.

In case where the lithographic printing plate precursor used is apt to be influenced by surrounding light under a working environment, it is preferable that the plate-making line is blinded by a filter, a cover or the like.

After the image formation as described above, the entire surface of lithographic printing plate may be exposed to active ray, for example, ultraviolet light to accelerate hardening of the image area. As a light source for the entire surface exposure, for example, a carbon arc lamp, a mercury lamp, a gallium lamp, a metal halide lamp, a xenon lamp, a tungsten lamp or various laser beams are exemplified. In order to obtain sufficient printing durability, the amount of the entire surface exposure is preferably 10 mJ/cm² or more, more preferably 100 mJ/cm² or more.

Heating may be performed at the same time with the entire surface exposure. By performing the heating, further improvement in the printing durability is recognized. Examples of the heating means include a conventional convection oven, an IR irradiation apparatus, an IR laser, a microwave apparatus or a Wisconsin oven. The plate surface temperature at the heating is preferably from 30 to 150°C, more preferably from 35 to 130°C, and still more preferably from 40 to 120°C.

The lithographic printing plate thus obtained through the treatments is mounted on an offset printing machine to perform printing of a large number of prints.

As a plate cleaner which can be used for removing stain on the printing plate at the printing, conventionally known plate cleaners for PS plate may be used. Examples thereof include CL-1, CL-2, CP, CN-4, CN, CG-1, PC-1, SR and IC (produced by Fuji Photo Film Co., Ltd.).

### EXAMPLES

### (Preparation of Support 1)

An aluminum plate (material: 1050) having a thickness of 0.3 mm was subjected to a degrease treatment with an aqueous 10% by weight sodium aluminate solution at 50°C for 30 seconds in order to remove rolling oil on the surface thereof. Thereafter, the aluminum plate surface was grained using three nylon brushes implanted with bundled bristles having a diameter of 0.3 mm and an aqueous suspension (specific gravity: 1.1 g/cm³) of pumice having a median diameter of 25 µm, and then thoroughly washed with water. The plate was etched by dipping it in an aqueous 25% by weight sodium hydroxide solution at 45°C for 9 seconds and after washing with water, dipped in an aqueous 20% by weight nitric acid solution at 60°C for 20 seconds, followed by washing with water. The etching amount of the grained surface was about 3 g/m².

Subsequently, the aluminum plate was subjected to a continuous electrochemical surface roughening treatment using alternate current voltage of 60 Hz. The electrolytic solution used was an aqueous 1% by weight nitric acid solution (containing 0.5% by weight of aluminum ion) at a liquid temperature of 50°C. The electrochemical surface roughening treatment was performed using a rectangular wave alternate current having a trapezoidal waveform such that the time TP necessary for the current value to reach the peak from zero was 0.8 msec and the duty ratio was 1:1, and disposing a carbon electrode as the counter electrode. The auxiliary anode used was ferrite. The current density was 30 A/dm² in terms of the peak value of current, and 5% of the current flowing from the power source was divided to the auxiliary anode. The quantity of electricity at the nitric acid electrolysis was 175 C/dm² when the aluminum plate was serving as the anode. Then, the aluminum plate was washed with water by spraying.

Then, the aluminum plate was subjected to an electrochemical surface roughening treatment in the same manner as in the nitric acid electrolysis above using, as the electrolytic solution, an aqueous 0.5% by weight hydrochloric acid solution (containing 0.5% by weight of aluminum ion) at a liquid temperature of 50°C under the conditions that the quantity of electricity was 50 C/dm² when the aluminum plate was serving as the anode, and then washed with water by spraying. The plate was then treated in an aqueous 15% by weight sulfuric acid solution (containing 0.5% by weight of aluminum ion) as the electrolytic solution at a current density of 15 A/dm² to provide a direct current anodic oxide film of 2.5 g/m², thereafter washed with water and dried.

The center line average roughness Ra (JIS B0601) of the surface of the thus-treated aluminum plate was measured using a stylus having a diameter of 2 µm and found to be 0.51 µm.

Further, Undercoat Solution (1) shown below was coated using a bar to have a dry coating amount of 10 mg/m² and dried in an oven at 80°C for 10 seconds to prepare Support (1) having an undercoat layer to be used in the experiments described below.

### <Undercoat Solution (1)>

| | |
|---|---|
| Undercoat Compound (1) shown below | 0.017 g |
| Methanol | 9.00 g |
| Water | 1.00 g |

### Undercoat Compound (1):

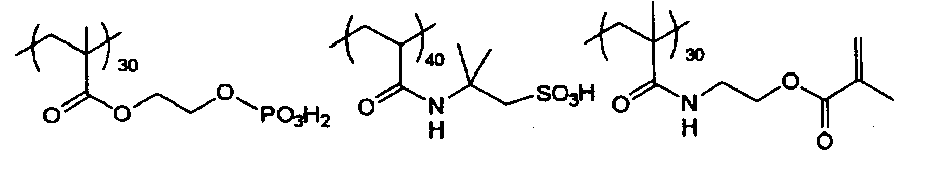

### [Preparation of Lithographic Printing Plate Precursor (1)]

On Support (1) having the undercoat layer described above, Coating Solution (1) for Photosensitive Layer having the composition shown below was coated using a bar and dried in an oven at 70°C for 60 seconds to form a photosensitive layer having a dry coating amount of 1.1 g/m². On the photosensitive layer, Coating Solution (1) for Protective Layer having the composition shown below was coated using a bar to have a dry coating amount of 0.75 g/m² and dried at 125°C for 70 seconds to prepare Lithographic Printing Plate Precursor (1).

### <Coating Solution (1) for Photosensitive Layer>

| | |
|---|---|
| Binder Polymer (1) shown below (Tg: 35°C) | 0.48 g |
| Polymerizable Compound (M-1) | 0.54 g |
| Sensitizing Dye (1) shown below | 0.07 g |
| Polymerization Initiator (1) shown below | 0.19 g |
| Chain Transfer Agent (1) shown below | 0.07 g |
| Dispersion of ε-phthalocyanine pigment: | 0.40 g |
| (pigment: 15 parts by weight; dispersing agent (Binder Polymer (1)): 10 parts by weight; solvent (cyclohexanone/methoxypropyl acetate/1-methoxy-2-propanol = 15 parts by weight/20 parts by weight/40 parts by weight)) | |
| Thermal polymerization inhibitor N-nitrosophenylhydroxylamine aluminum salt | 0.01 g |
| Fluorine-Based Surfactant (1) shown below | 0.001 g |
| 1-Methoxy-2-propanol | 3.50 g |
| Methyl ethyl ketone | 8.00 g |

### Binder Polymer (1):

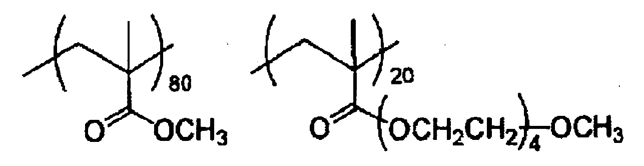

### Chain Transfer Agent (1):

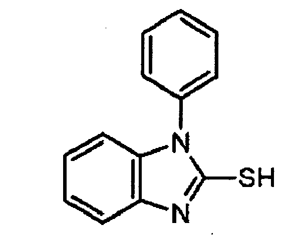

### Sensitizing Dye (1):

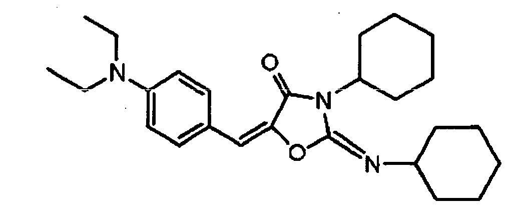

### Polymerization Initiator (1):

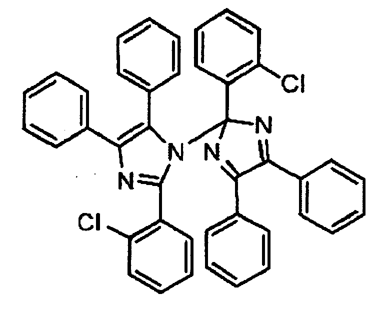

### Fluorine-Based Surfactant (1):

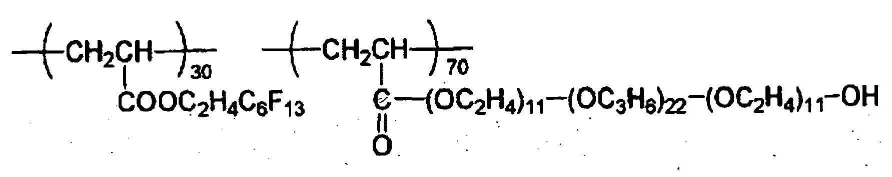

### <Coating Solution (1) for Protective Layer>

| | |
|---|---|
| Polyvinyl alcohol (saponification degree: 98% by mole; polymerization degree: 500) | 40 g |
| Polyvinyl pyrrolidone (molecular weight: 50,000) | 5 g |
| Vinyl pyrrolidone/vinyl acetate (1/1) copolymer (molecular weight: 70,000) | 0.5 g |
| Surfactant (Emalex 710, produced by Nihon-Emulsion Co., Ltd.) | 0.5 g |
| Water | 950 g |

The oxygen transmission rate of the protective layer was measured in the manner described below and it was found to be 3.8 ml/(m²·day·atom).

### (Measurement of Oxygen Transmission Rate)

On a surface of photographic printing paper having a thickness of about 200 µm both surfaces of which had been coated with polyethylene having a thickness of about 20 µm was coated the protective layer in the same manner as described in the coating of protective layer on the photosensitive layer, followed by drying to prepare a sample for measurement. The oxygen transmission rate of the photographic printing paper previously measured was about 700 ml/(m²·day·atom) under the measurement conditions described below and it was a sufficiently negligible value for the measurement of the oxygen transmission rate of the protective layer.

Using the sample thus-prepared, the oxygen transmission rate [ml/(m²·day·atom)] was measured by OX-TRAN2/20 produced by Mocon Inc. according to the vapor permeation rate testing method described in JIS K7126B and ASTM D3985 under the conditions of 25°C and 60% RH.

### [Preparation of Lithographic Printing Plate Precursors (2) to (13)]

Lithographic Printing Plate Precursors (2) to (13) were prepared in the same manner as in the preparation of Lithographic Printing Plate Precursor (1) except for changing Polymerizable Compound (M-1) in Coating Solution (1) for Photosensitive Layer to the polymerizable compounds shown in Table 1 below, respectively. The photosensitive layers of Lithographic Printing Plate Precursors (2) to (13) obtained had the dry coating amounts shown in Table 1 below, respectively. The polymerizable compounds used for the preparation of Lithographic Printing Plate Precursors (2) to (13) are shown below.

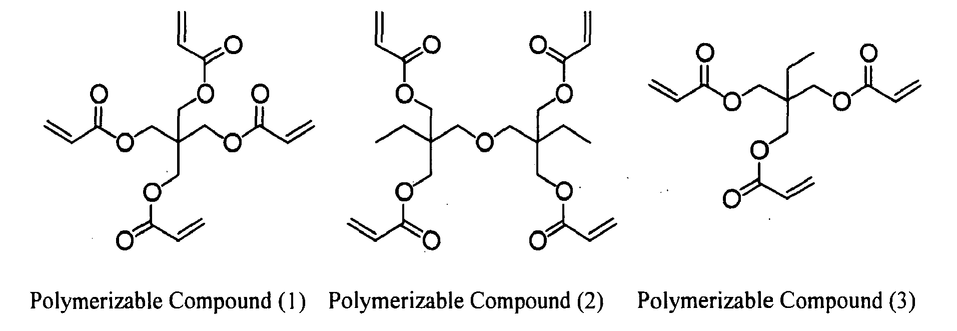

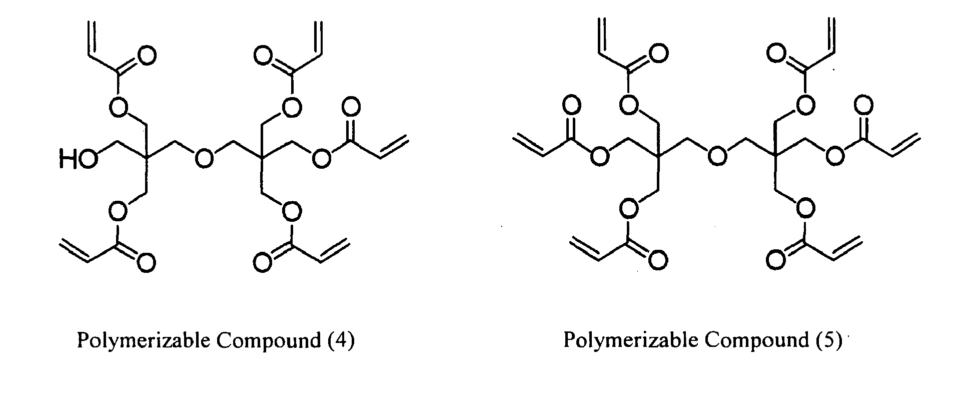

### [Preparation of Lithographic Printing Plate Precursor (14)]

Lithographic Printing Plate Precursor (14) was prepared in the same manner as in the preparation of Lithographic Printing Plate Precursor (1) except for changing Coating Solution (1) for Photosensitive Layer to Coating Solution (14) for Photosensitive Layer having the composition shown below. The photosensitive layer of Lithographic Printing Plate Precursor (14) obtained had the dry coating amount of 1.1 g/m².

### <Coating Solution (14) for Photosensitive Layer>

| | |
|---|---|
| Polymerization Initiator (1) shown above | 0.20 g |
| Sensitizing Dye (1) shown above | 0.10 g |
| Binder Polymer (1) shown above | 3.00 g |
| Polymerizable Compound (M-1) | 6.20 g |
| Leuco Crystal Violet | 0.20 g |
| Fluorine-based Surfactant (1) shown above | 0.10 g |
| Dispersion of Microcapsule (1) shown below | 25.00 g |
| Methyl ethyl ketone | 35.00 g |
| 1-Methoxy-2-propanol | 35.00 g |

### (Preparation of Dispersion of Microcapsule (1))

As an oil phase component, 10 g of adduct of trimethylolpropane and xylene diisocyanate (Takenate D-110N, produced by Mitsui Takeda Chemicals, Inc.), 4.15 g of isocyanuric acid EO-modified diacrylate (Aronics M-215, produced by Toa Gosei Co., Ltd.) and 0.1 g of Pionin A-41C (produced by Takemoto Oil & Fat Co., Ltd.) were dissolved in 17 g of ethyl acetate. As an aqueous phase component, 40 g of an aqueous 4% by weight PVA-205 solution was prepared. The oil phase component and the aqueous phase component were mixed and emulsified using a homogenizer at 12,000 rpm for 10 minutes. The resulting emulsion was added to 25 g of distilled water and the mixture was stirred at room temperature for 30 minutes and then stirred at 40°C for 3 hours. The thus-obtained microcapsule solution was diluted with distilled water to have a solid content concentration of 20% by weight to prepare Dispersion of Microcapsule (1). The average particle diameter of the microcapsule was 0.25 µm.

### [Preparation of Lithographic Printing Plate Precursors (15) to (17)]

Lithographic Printing Plate Precursors (15) to (17) were prepared in the same manner as in the preparation of Lithographic Printing Plate Precursor (14) except for changing Polymerizable Compound (M-1) in Coating Solution (14) for Photosensitive Layer to the radical polymerizable compounds shown in Table 1 below, respectively. The photosensitive layers of Lithographic Printing Plate Precursors (15) to (17) obtained had the dry coating amounts shown in Table 1 below, respectively.

### [Preparation of Lithographic Printing Plate Precursor (18)]

Lithographic Printing Plate Precursor (18) was prepared in the same manner as in the preparation of Lithographic Printing Plate Precursor (14) except that Coating Solution (14) for Photosensitive Layer was changed to Coating Solution (18) for Photosensitive Layer having the composition shown below and that Coating Solution (1) for Protective Layer was changed to Coating Solution (2) for Protective Layer having the composition shown below and coated by a bar so as to have a dry coating amount of 0.2 g/m². The photosensitive layer of Lithographic Printing Plate Precursor (18) obtained had the dry coating amount of 1.1 g/m².

### <Coating Solution (18) for Photosensitive Layer>

| | |
|---|---|
| Binder Polymer (1) shown above | 0.54 g |
| Polymerizable Compound (M-2) | 0.45 g |
| Sensitizing Dye (1) shown above | 0.06 g |
| Polymerization Initiator (1) shown above | 0.18 g |
| Chain Transfer Agent (1) shown above | 0.07 g |
| Dispersion of ε-phthalocyanine pigment: | 0.40 g |
| (pigment: 15 parts by weight; dispersing agent (Binder Polymer (1)): 10 parts by weight; solvent (cyclohexanone/methoxypropyl acetate/1-methoxy-2-propanol = 15 parts by weight/20 parts by weight/40 parts by weight)) | |
| Thermal polymerization inhibitor N-nitrosophenylhydroxylamine aluminum salt | 0.01 g |
| Fluorine-Based Surfactant (1) shown above | 0.001 g |
| 1-Methoxy-2-propanol | 3.5 g |
| Methyl ethyl ketone | 8.0 g |

### <Coating Solution (2) for Protective Layer>

| | |
|---|---|
| Dispersion of Mica (1) shown below | 13.00 g |
| Polyvinyl alcohol (saponification degree: 98% by mole; polymerization degree: 500) | 1.30 g |
| Sodium 2-ethylhexylsulfosuccinate | 0.20 g |
| Vinyl pyrrolidone/vinyl acetate (1/1) copolymer (molecular weight: 70,000) | 0.05 g |
| Surfactant (Emalex 710, produced by Nihon-Emulsion Co., Ltd.) | 0.05 g |
| Water | 133.00 g |

### (Preparation of Dispersion of Mica (1))

In 368 g of water was added 32 g of synthetic mica (SOMASIF ME-100, produced by CO-OP Chemical Co., Ltd.; aspect ratio: 1,000 or more) and dispersed using a homogenizer until the average particle diameter (measured by a laser scattering method) became 0.5 µm to obtain Dispersion of Mica (1).

### [Preparation of Lithographic Printing Plate Precursors (19) to (21)]

Lithographic Printing Plate Precursors (19) to (21) were prepared in the same manner as in the preparation of Lithographic Printing Plate Precursor (18) except for changing Polymerizable Compound (M-2) in Coating Solution (18) for Photosensitive Layer to the polymerizable compounds shown in Table 1 below, respectively. The photosensitive layers of Lithographic Printing Plate Precursors (19) to (21) obtained had the dry coating amounts shown in Table 1 below, respectively.

### [Preparation of Lithographic Printing Plate Precursor (22)]

On Support (2) described below, Coating Solution (22) for Photosensitive Layer having the composition shown below was coated using a bar and dried in an oven at 70°C for 60 seconds to form a photosensitive layer having a dry coating amount of 1.1 g/m². On the photosensitive layer, Coating Solution (2) for Protective Layer having the composition shown above was coated using a bar to have a dry coating amount of 0.75 g/m² and dried at 125°C for 70 seconds to prepare Lithographic Printing Plate Precursor (22).

### <Coating Solution (22) for Photosensitive Layer>

| | |
|---|---|
| Binder Polymer (1) shown above | 0.54 g |
| Polymerizable Compound (M-4) | 0.48 g |
| Sensitizing Dye (1) shown above | 0.06 g |
| Polymerization Initiator (1) shown above | 0.18 g |
| Chain Transfer Agent (1) shown above | 0.07 g |
| Dispersion of ε-phthalocyanine pigment: | 0.40 g |
| (pigment: 15 parts by weight; dispersing agent (Binder | |
| Polymer (1)): 10 parts by weight; solvent (cyclohexanone/methoxypropyl acetate/1-methoxy-2-propanol = 15 parts by weight/20 parts by weight/40 parts by weight)) | |
| Thermal polymerization inhibitor N-nitrosophenylhydroxylamine aluminum salt | 0.01 g |
| Fluorine-Based Surfactant (1) shown above | 0.001 g |
| 1-Methoxy-2-propanol | 3.5 g |
| Methyl ethyl ketone | 8.0 g |

### (Preparation of Support 2)

An aluminum plate having a thickness of 0.3 mm was dipped in an aqueous 10% by weight sodium hydroxide solution at 60°C for 25 seconds to effect etching, washed with running water, neutralized and cleaned with an aqueous 20% by weight nitric acid solution and then washed with water. The aluminum plate was subjected to an electrolytic surface roughening treatment in an aqueous 1 % by weight nitric acid solution using an alternating current with a sinusoidal waveform at an anode time electricity of 300 coulomb/dm². Subsequently, the aluminum plate was dipped in an aqueous 1% by weight sodium hydroxide solution at 40°C for 5 seconds, dipped in an aqueous 30% by weight sulfuric acid solution at 60°C for 40 seconds to effect a desmut treatment, and then subjected to an anodizing treatment in an aqueous 20% by weight sulfuric acid solution for 2 minutes at a current density of 2 A/dm² to form an anodic oxide film having a thickness of 2.7 g/m². The center line average roughness (Ra) of the surface of the thus-treated aluminum plate was measured and found to be 0.3 µm.

On the aluminum plate thus-treated, Undercoat Solution (2) shown below was coated using a bar to have a dry coating amount of 10 mg/m² and dried in an oven at 80°C for 20 seconds to prepare Support 2.

### <Undercoat Solution (2)>

| | |
|---|---|
| Sol solution shown below | 100 g |
| Methanol | 900 g |

### Sol Solution

| | |
|---|---|
| Phosmer PE (produced by Uni-Chemical Co., Ltd) | 5 g |
| Methanol | 45 g |
| Water | 10 g |
| Phosphoric acid (85% by weight) | 5 g |
| Tetraethoxysilane | 20 g |
| 3-Methacryloxypropyltrimethoxysilane | 15 g |

### [Preparation of Lithographic Printing Plate Precursors (23) to (25)]

Lithographic Printing Plate Precursors (23) to (25) were prepared in the same manner as in the preparation of Lithographic Printing Plate Precursor (22) except for changing Polymerizable Compound (M-4) in Coating Solution (22) for Photosensitive Layer to the polymerizable compounds shown in Table 1 below, respectively. The photosensitive layers of Lithographic Printing Plate Precursors (23) to (25) obtained had the dry coating amounts shown in Table 1 below, respectively.

### [Preparation of Lithographic Printing Plate Precursor (26)]

Lithographic Printing Plate Precursor (26) was prepared in the same manner as in the preparation of Lithographic Printing Plate Precursor (1) except for changing Binder Polymer (1) in Coating Solution (1) for Photosensitive Layer to Binder Polymer (2) shown below. The photosensitive layer of Lithographic Printing Plate Precursor (26) obtained had the dry coating amount of 1.1 g/m².

### [Preparation of Lithographic Printing Plate Precursor (27)]

Lithographic Printing Plate Precursor (27) was prepared in the same manner as in the preparation of Lithographic Printing Plate Precursor (1) except for changing Binder Polymer (1) in Coating Solution (1) for Photosensitive Layer to Binder Polymer (3) shown below. The photosensitive layer of Lithographic Printing Plate Precursor (27) obtained had the dry coating amount of 1.1 g/m².

### [Preparation of Lithographic Printing Plate Precursor (28)]

Lithographic Printing Plate Precursor (28) was prepared in the same manner as in the preparation of Lithographic Printing Plate Precursor (1) except for changing Binder Polymer (1) in Coating Solution (1) for Photosensitive Layer to Binder Polymer (4) shown below. The photosensitive layer of Lithographic Printing Plate Precursor (28) obtained had the dry coating amount of 1.1 g/m².

### [Preparation of Lithographic Printing Plate Precursor (29)]

Lithographic Printing Plate Precursor (29) was prepared in the same manner as in the preparation of Lithographic Printing Plate Precursor (1) except for changing Binder Polymer (1) in Coating Solution (1) for Photosensitive Layer to Binder Polymer (5) shown below. The photosensitive layer of Lithographic Printing Plate Precursor (29) obtained had the dry coating amount of 1.1 g/m².

### [Preparation of Lithographic Printing Plate Precursor (30)]

Lithographic Printing Plate Precursor (30) was prepared in the same manner as in the preparation of Lithographic Printing Plate Precursor (1) except for changing Binder Polymer (1) in Coating Solution (1) for Photosensitive Layer to Binder Polymer (6) shown below. The photosensitive layer of Lithographic Printing Plate Precursor (30) obtained had the dry coating amount of 1.1 g/m².

### [Preparation of Lithographic Printing Plate Precursor (31)].

Lithographic Printing Plate Precursor (31) was prepared in the same manner as in the preparation of Lithographic Printing Plate Precursor (1) except for changing Binder Polymer (1) in Coating Solution (1) for Photosensitive Layer to Binder Polymer (7) shown below. The photosensitive layer of Lithographic Printing Plate Precursor (31) obtained had the dry coating amount of 1.1 g/m².

### [Preparation of Lithographic Printing Plate Precursor (32)]

Lithographic Printing Plate Precursor (32) was prepared in the same manner as in the preparation of Lithographic Printing Plate Precursor (1) except for changing Binder Polymer (1) in Coating Solution (1) for Photosensitive Layer to Binder Polymer (8) shown below. The photosensitive layer of Lithographic Printing Plate Precursor (32) obtained had the dry coating amount of 1.1 g/m².

### [Preparation of Lithographic Printing Plate Precursor (33)]

Lithographic Printing Plate Precursor (33) was prepared in the same manner as in the preparation of Lithographic Printing Plate Precursor (1) except for changing Binder Polymer (1) in Coating Solution (1) for Photosensitive Layer to Binder Polymer (9) shown below. The photosensitive layer of Lithographic Printing Plate Precursor (33) obtained had the dry coating amount of 1.1 g/m².

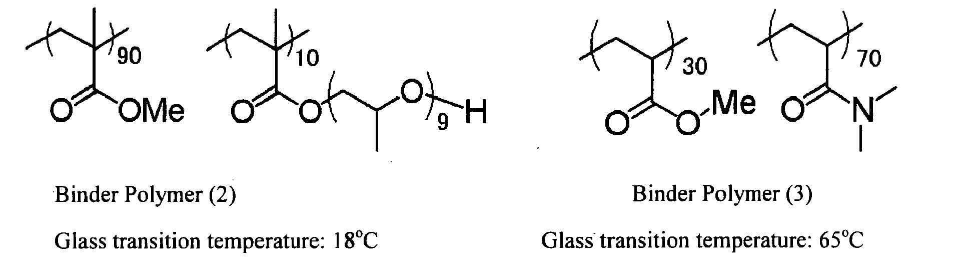

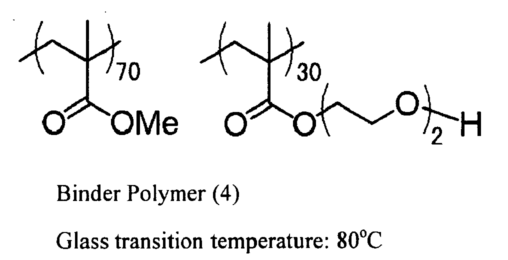

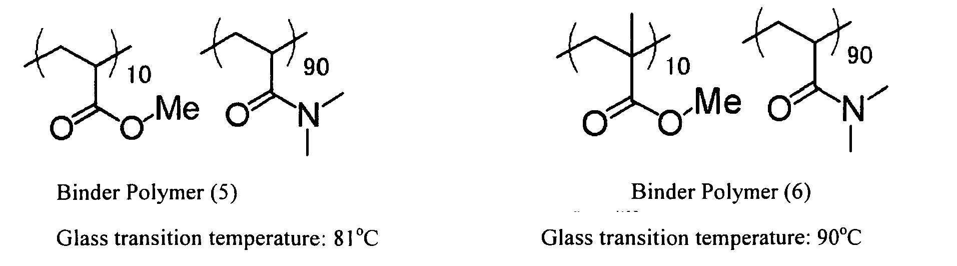

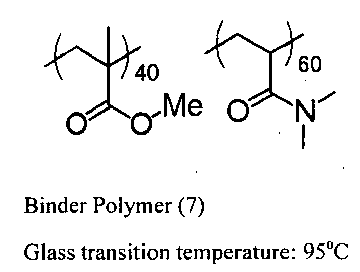

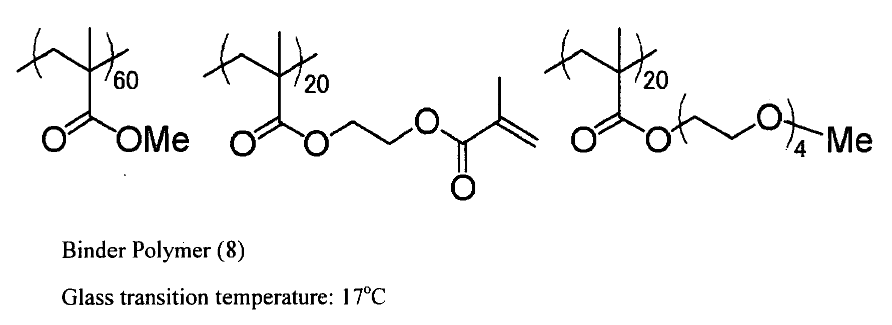

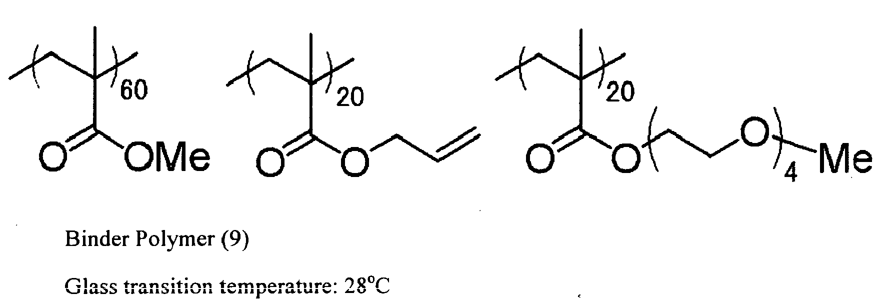

### EXAMPLES 1 TO 22 AND COMPARATIVE EXAMPLES 1 TO 11

### (1) Exposure, Development and Printing

Each of Lithographic Printing Plate Precursors (1) to (33) was subjected to imagewise exposure using a semiconductor laser of 405 nm having an output of 100 mW while changing energy density.

Then, development processing was performed in an automatic development processor having a structure shown in Fig. 1 using Developer (1) having the composition shown below. The pH of the developer was 5. The automatic development processor was an automatic processor having two rotating brush rollers. As for the rotating brush rollers used, the first brush roller was a brush roller having an outer diameter of 90 mm and being implanted with fiber of polybutylene terephthalate (bristle diameter: 200 µm, bristle length: 17 mm), and the brush roller was rotated at 200 rpm in the same direction as the transporting direction (peripheral velocity at the tip of brush: 0.94 m/sec). The second brush roller was a brush roller having an outer diameter of 60 mm and being implanted with fiber of polybutylene terephthalate (bristle diameter: 200µm, bristle length: 17 mm), and the brush roller was rotated at 200 rpm in the opposite direction to the transporting direction (peripheral velocity at the tip of brush: 0.63 m/sec).

The developer was supplied on the surface of the lithographic printing plate precursor by showering from a spray pipe using a circulation pump. The tank volume for the developer was 10 liters. Developer (1)

| | |
|---|---|
| Water | 100.00 g |
| Benzyl alcohol | 1.00 g |
| Polyoxyethylene naphthyl ether (average number of oxyethylene: n = 13) | 1.00 g |
| Sodium salt of dioctylsulfosuccinic acid ester | 0.50 g |
| Gum arabic | 1.00 g |
| Ethylene glycol | 0.50 g |
| Ammonium primary phosphate | 0.05 g |
| Citric acid | 0.05 g |
| Tetrasodium salt of ethylenediaminetetraacetate | 0.05 g |

The lithographic printing plate after development was mounted on a printing machine, SOR-M, produced by Heidelberg, and printing was performed at a printing speed of 6,000 sheets per hour using dampening water (EU-3 (etching solution, produced by Fuji Photo Film Co., Ltd.))/water/isopropyl alcohol = 1/89/10 (by volume ratio)) and TRANS-G(N) black ink (produced by Dai-Nippon Ink & Chemicals, Inc.).

### (2) Evaluation

Using the lithographic printing plate precursors prepared above, the developing property, sensitivity and printing durability were evaluated in the following manner. The results obtained are shown in Table 1.

### <Developing Property>

The development was performed under the above-described conditions and the transporting speed necessary for completely removing the non-image area of the lithographic printing plate precursor was determined to evaluate the developing property. As the transporting speed is higher, the developing property is better.

### <Sensitivity>

After performing printing of 100 sheets as described above and confirming that a printed material free from ink stain in the non-image area was obtained, 500 sheets were continuously printed. Thus, 600 sheets in total were printed. The exposure amount for causing no unevenness in the ink density of the image area on the 600th printed material was determined and defined as the sensitivity.

### <Printing Durability>

As increase in the number of printing sheets under the above-described printing conditions, the photosensitive layer was gradually abraded to cause decrease in the ink receptivity, resulting in decrease of ink density on printing paper. A number of printed materials obtained until the ink density (reflection density) decreased by 0.1 from that at the initiation of printing was determined to evaluate the printing durability.

**TABLE 1**

| | Lithographic Printing Plate Precursor | Polymerizable Compound | Coating Amount (g/m²) | Developing Property (cm/min) | Sensitivity (mJ/cm²) | Printing Durability (x 10⁵ sheets) |
|---|---|---|---|---|---|---|
| Example 1 | (1) | M-1 | 1.1 | 130 | 0.08 | 11 |
| Example 2 | (2) | M-2 | 1.2 | 140 | 0.09 | 10 |
| Example 3 | (3) | M-7 | 1.1 | 130 | 0.07 | 10 |
| Example 4 | (4) | M-8 | 1.0 | 130 | 0.08 | 12 |
| Example 5 | (5) | M-10 | 1.1 | 130 | 0.09 | 13 |
| Example 6 | (6) | M-11 | 1.2 | 140 | 0.08 | 12 |
| Example 7 | (7) | M-1/M-9(1/1) | 1.3 | 140 | 0.07 | 11 |
| Example 8 | (8) | M-1/(1)(4/1) | 1.2 | 150 | 0.07 | 10 |
| Comparative Example 1 | (9) | (1) | 1.1 | 100 | 0.12 | 6 |
| Comparative Example 2 | (10) | (2) | 1.2 | 90 | 0.11 | 5 |
| Comparative Example 3 | (11) | (3) | 1.1 | 90 | 0.12 | 8 |
| Comparative Example 4 | (12) | (4) | 1.0 | 100 | 0.10 | 8 |
| Comparative Example 5 | (13) | (5) | 1.3 | 100 | 0.11 | 7 |
| Example 9 | (14) | M-1 | 1.1 | 140 | 0.10 | 10 |
| Example 10 | (15) | M-5 | 1.1 | 140 | 0.11 | 12 |
| Comparative Example 6 | (16) | (1) | 1.1 | 100 | 0.13 | 9 |
| Comparative Example 7 | (17) | (4) | 1.1 | 90 | 0.14 | 7 |
| Example 11 | (18) | M-2 | 1.1 | 140 | 0.08 | 10 |
| Example 12 | (19) | M-6 | 1.2 | 150 | 0.09 | 12 |
| Comparative Example 8 | (20) | (2) | 1.2 | 100 | 0.14 | 6 |
| Comparative Example 9 | (21) | (5) | 1.1 | 110 | 0.15 | 7 |
| Example 13 | (22) | M-4 | 1.1 | 120 | 0.10 | 12 |
| Example 14 | (23) | M-9 | 1.2 | 130 | 0.11 | 14 |
| Comparative Example 10 | (24) | (1) | 1.1 | 90 | 0.16 | 8 |
| Comparative Example 11 | (25) | (5) | 1.2 | 90 | 0.15 | 7 |
| Example 15 | (26) | M-10 | 1.1 | 140 | 0.08 | 11 |
| Example 16 | (27) | M-10 | 1.1 | 120 | 0.08 | 10 |
| Example 17 | (28) | M-10 | 1.1 | 120 | 0.09 | 10 |
| Example 18 | (29) | M-10 | 1.1 | 120 | 0.09 | 10 |
| Example 19 | (30) | M-10 | 1.1 | 110 | 0.10 | 9 |
| Example 20 | (31) | M-10 | 1.1 | 110 | 0.10 | 9 |
| Example 21 | (32) | M-10 | 1.1 | 130 | 0.07 | 14 |
| Example 22 | (33) | M-10 | 1.1 | 130 | 0.07 | 13 |

| | | | | | | |
|---|---|---|---|---|---|---|
| *1: M-1/M-9(1/1) means that Polymerizable Compounds M-1 and M-9 were mixed in a weight ratio of 1:1. *2: M-1/(1)(4/1) means that Polymerizable Compounds M-1 and (1) were mixed in a weight ratio of 4:1. | | | | | | |

As is apparent from the results shown in Table 1, the lithographic printing plate precursors using the radical polymerizable compound having an isocyanuric acid group according to the invention are improved in the developing property, sensitivity and printing durability in comparison with the lithographic printing plate precursors which does not contain the radical polymerizable compound having an isocyanuric acid group.

### EXAMPLE 23

The exposure, development, printing and evaluation were conducted in the same manner as in Example 1 except that within 30 seconds after the image exposure, the exposed lithographic printing plate precursor was put in an oven and heated the whole surface of the lithographic printing plate precursor by blowing hot air to maintain at 110°C for 15 seconds and after that the development processing was performed within 30 seconds in the same manner as in Example 1. By conducting the heat treatment, the developing property did not change as 130 cm/min, the sensitivity was changed to 0.05 mJ/cm² and the printing durability was changed to 12 x 10⁵ sheets.

### EXAMPLE 24

Lithographic Printing Plate Precursor (1) was subjected to image exposure by a violet semiconductor laser plate setter Vx9600 (equipped with InGaN semiconductor laser: emission: 405 nm ± 10 nm/output: 30 mW, produced by FUJIFILM Electronic Imaging, Ltd.). As for the image, halftone dots of 35% were drawn using an FM screen (TAFFETA 20, produced by Fuji Photo Film Co., Ltd.) in a plate surface exposure amount of 0.05 mJ/cm² and at resolution of 2,438 dpi. The exposed lithographic printing plate precursor was subjected to development processing within 30 seconds after the image exposure using an automatic processor (LP1250PLX, produced by Fuji Photo Film Co., Ltd.). The automatic processor was composed of a heating unit, a water-washing unit, a developing unit, a rinsing unit and a finishing unit in this order. The heating condition in the heating unit was 100°C for 10 seconds. In all bathes of the water-washing unit, developing unit, rinsing unit and finishing unit, Developer (1) described above was charged. The temperature of the developer was 28°C and the transportation of the lithographic printing plate precursor was performed at a transporting speed of 130 cm/min.

After the development processing, the non-image area and image area of the resulting lithographic printing plate were visually observed. As a result, it was found that the residue of the photosensitive layer was not present in the non-image area and the uniform halftone dot image free from unevenness was formed. Further, the printing was conducted using the lithographic printing plate under the same conditions as described above. As a result, 12 x 10⁵ sheets of good printed materials of uniform halftone dot image free from unevenness and without stain in the non-image area were obtained.

This application is based on Japanese Patent application JP 2006-99780, filed March 31, 2006, and Japanese Patent application JP 2006-123825, filed April 27, 2006, the entire content of which is hereby incorporated by reference, the same as if set forth at length.

## Claims

1. A method for producing a lithographic printing plate comprising:
imagewise exposing a lithographic printing plate precursor comprising: a hydrophilic support; a photosensitive layer containing a radical polymerizable compound having an isocyanuric acid group, a binder polymer having an acid value of 0.3 meq/g or less, a sensitizing dye having an absorption maximum in a wavelength range of from 360 to 450 nm and a polymerization initiator; and a protective layer in this order with a laser beam of from 360 to 450 nm; and
rubbing a surface of the exposed lithographic printing plate precursor with a rubbing member in a presence of a developer having pH of from 2 to 10 in an automatic processor equipped with the rubbing member to remove the protective layer and an unexposed area of the photosensitive layer.

2. The method as claimed in claim 1, wherein the radical polymerizable compound having an isocyanuric acid group has a molecular weight of 450 or more.

3. The method as claimed in claim 1 or 2, wherein the radical polymerizable compound having an isocyanuric acid group has a radical polymerizable group value of 4 mmol/g or more.

4. The method as claimed in any one of claims 1 to 3, wherein the binder polymer having an acid value of 0.3 meq/g or less is a polymer having a weight average molecular weight of 10,000 or more and a glass transition point of 80°C or less.

5. The method as claimed in claim 4, wherein the binder polymer having an acid value of 0.3 meq/g or less further has a radical polymerizable group.

6. The method as claimed in any one of claims 1 to 5, wherein the exposed lithographic printing plate precursor is subjected to a heat treatment between the exposing and the rubbing.

7. The method as claimed in any one of claims 1 to 6, wherein the developer contains a surfactant represented by the following formula (1-III) or (1-IV): 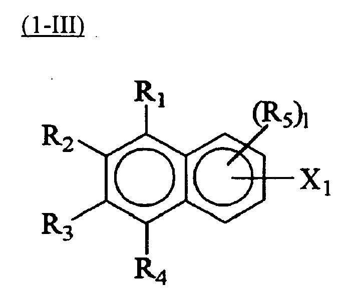 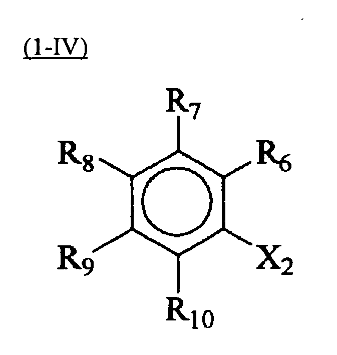 wherein R₁ to R₁₀ each independently represents a hydrogen atom or an alkyl group; 1 represents an integer of from 1 to 3; X₁ and X₂ each independently represents a sulfonate, a sulfuric monoester salt, a carboxylate or a phosphate; and provided that a total number of carbon atoms included in R₁ to R₅ or R₆ to R₁₀ is 3 or more.

8. The method as claimed in any one of claims 1 to 6, wherein the developer contains a surfactant represented by the following formula (1-V) or (1-VI): 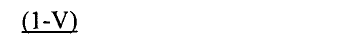 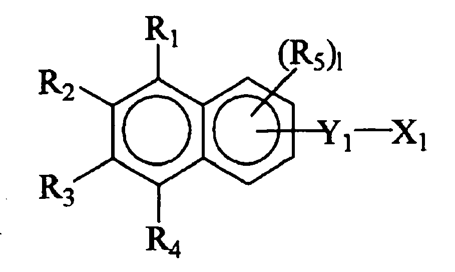 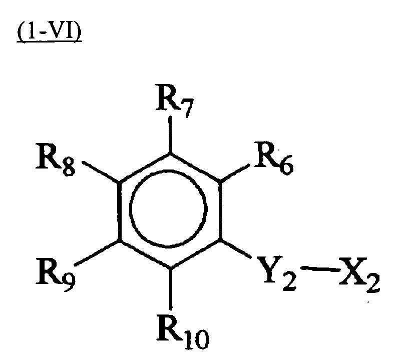 wherein R₁ to R₁₀ each independently represents a hydrogen atom or an alkyl group; 1 represents an integer of from 1 to 3; X₁ and X₂ each independently represents a sulfonate, a sulfuric monoester salt, a carboxylate or a phosphate; Y₁ and Y₂ each independently represents -CₙH₂ₙ-, -Cₙ₋ₘH₂₍ₙ₋ₘ₎OCₘH₂ₘ-,-O-(CH₂CH₂O)ₙ-, -O-(CH₂CH₂CH₂O)ₙ- or -CO-NH- in which n ≥ 1 and n ≥ m ≥ 0; and provided that a total number of carbon atoms included in R₁ to R₅ and Y₁ or R₆ to R₁₀ and Y₂ is 3 or more.

9. The method as claimed in any one of claims 1 to 6, wherein the developer contains a surfactant represented by any one of the following formulae (1-VII) to (1-IX): 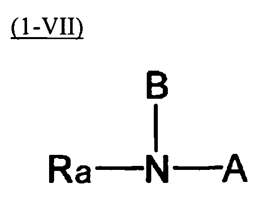 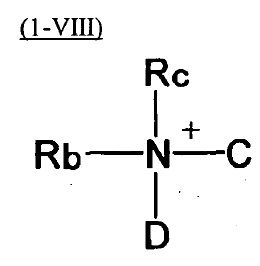 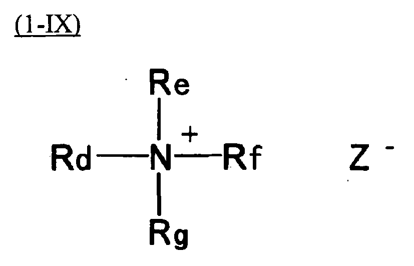 wherein,
in the formula (1-VII), Rₐ represents a hydrogen atom or an alkyl group; and A and B each independently represents a group containing an ethylene oxide group, a carboxylic acid group or a carboxylate;
in the formula (1-VIII), R_{b} and R_{c} each independently represents a hydrogen atom or an alkyl group; C represents an alkyl group or a group containing an ethylene oxide group; and D represents a group containing a carboxylic acid anion; and
in the formula (1-IX), R_{d}, Rₑ, R_{f} and R_{g} each independently represents a hydrogen atom or an alkyl group; and Z⁻ represents a counter anion.

10. A lithographic printing plate precursor comprising:
a hydrophilic support;
a photosensitive layer containing a radical polymerizable compound having an isocyanuric acid group, a binder polymer having an acid value of 0.3 meq/g or less, a sensitizing dye having an absorption maximum in a wavelength range of from 360 to 450 nm and a polymerization initiator; and
a protective layer, in this order,
wherein the protective layer and an unexposed area of the photosensitive layer is capable of being removed by imagewise exposing the lithographic printing plate precursor with a laser beam of from 360 to 450 nm and rubbing a surface of the exposed lithographic printing plate precursor with a rubbing member in a presence of a developer having pH of 2 to 10 in an automatic processor equipped with the rubbing member.
